# EUROPEAN PATENT APPLICATION

(11) **EP 4 679 461 A2**
(43) Date of publication of application: **14.01.2026**
(21) Application number: 25183014.7
(22) Date of filing: 16.06.2025
(51) Int. Cl.: H01F 1/26, H01F 1/37, H01F 17/00, H05K 1/03

(54) **RESIN COMPOSITION AND PRODUCTION METHOD OF THE SAME**

(30) Priority: 17.06.2024 JP 2024097466
(71) Applicant: AJINOMOTO CO., INC., Chuo-ku Tokyo 104-8315 (JP)
(72) Inventor: SAITO, Mizuki, Kanagawa, 210-0801 (JP); OOYAMA, Hideki, Kanagawa, 210-0801 (JP)
(74) Representative: Mewburn Ellis LLP

(57) **Abstract**

Provided is a resin composition containing a thermosetting resin and an iron alloy type magnetic powder, a content of (a) an iron alloy type magnetic powder having a particle size of more than 20 µm and 50 µm or less being 26% by volume or more and 45% by volume or less, a content of (b) an iron alloy type magnetic powder having a particle size of more than 2 µm and 20 µm or less being 28% by volume or more and 68% by volume or less, and a content of (c) an iron alloy type magnetic powder having a particle size of 2 µm or less being 1% by volume or more and 41% by volume or less when a nonvolatile component of the resin composition is 100% by volume.

## Description

### Technical Field

The present invention relates to a resin composition and a production method of the same, a cured product, a magnetic paste, a resin sheet, a circuit board, and an inductor substrate containing the resin composition.

### Background Art

With a trend toward smaller and lighter electronic devices and the spread of portable devices in recent years, switching power supply circuits are being made smaller and more powerful. The switching power supply circuit usually includes an inductor (Patent Literature 1-4).

### Citation List

### Patent Literature

Patent Literature 1: Japanese Patent Application Laid-open No. 2017-69523
Patent Literature 2: International Publication No. 2006/54749
Patent Literature 3: Japanese Patent Application Laid-open No. 2019-192920
Patent Literature 4: International Publication No. 2023/176284

### Summary of the Invention

### Technical Problem

In recent years, magnetic materials that can achieve a high specific magnetic permeability in the low-frequency band of about 10 MHz have been sought in order to simultaneously achieve high functionality and miniaturization of inductors.

Magnetic materials may be applied as a resin composition containing magnetic powder during their use. For example, when a resin sheet with a magnetic material layer is produced, a resin composition containing magnetic powder may be applied to a support. When holes formed in a substrate are filled with a magnetic material, a resin composition containing magnetic powder may be applied to the substrate to fill the holes. Furthermore, when a circuit board including a magnetic material layer is produced, a resin composition containing magnetic powder may be applied to a substrate including a wiring pattern on its surface to embed the wiring pattern. In applying the resin composition containing magnetic powder, the resin composition is required to have fluidity in order to ensure its applicability.

However, study by the inventor of the present invention has found that when the magnetic powder is blended into the resin composition to the extent that a high specific magnetic permeability is achieved, even if the resin composition has fluidity, streaks occur during application, resulting in a poor appearance. It has been found that a resin composition with a poor appearance during application induces defects such as the generation of voids and poor adhesion to the substrate in a step of filling the holes and a step of embedding the wiring pattern. Since the generation of voids and poor adhesion to the substrate can cause, for example, a decrease in the inductance value of inductor components, the resin composition containing magnetic powder is required to have an excellent appearance during application.

The present invention has been made in view of the above problem, and an object thereof is to provide a resin composition that can produce a cured product that can achieve a high specific magnetic permeability in the low-frequency band and has an excellent appearance during application and a production method of the same; a cured product of the resin composition; a magnetic paste and a resin sheet containing the resin composition; and a circuit board and an inductor substrate including the cured product of the resin composition.

### Solution to Problem

The inventor of the present invention has intensively studied in order to solve the above problem. Consequently, the inventor of the present invention has found that a resin composition containing an iron alloy type magnetic powder having a specific range of particle size, an iron alloy type magnetic powder having another specific range of particle size, an iron alloy type magnetic powder having a still another specific range of particle size, and a thermosetting resin can solve the above problem to complete the present invention.

That is, the present invention includes the following.
<1> A resin composition comprising a thermosetting resin and an iron alloy type magnetic powder,
   a content of (a) an iron alloy type magnetic powder having a particle size of more than 20 µm and 50 µm or less being 26% by volume or more and 45% by volume or less,
   a content of (b) an iron alloy type magnetic powder having a particle size of more than 2 µm and 20 µm or less being 28% by volume or more and 68% by volume or less, and
   a content of (c) an iron alloy type magnetic powder having a particle size of 2 µm or less being 1% by volume or more and 41% by volume or less,
   when a nonvolatile component of the resin composition is 100% by volume.
<2> The resin composition according to <1>, wherein (a) the iron alloy type magnetic powder having a particle size of more than 20 µm and 50 µm or less contains a nanocrystalline magnetic powder containing an iron alloy.
<3> The resin composition according to <1> or <2>, wherein (b) the iron alloy type magnetic powder having a particle size of more than 2 µm and 20 µm or less contains at least one iron alloy magnetic powder selected from a nanocrystalline magnetic powder containing an iron alloy, a Ni-containing iron alloy type magnetic powder, a polycrystalline magnetic powder containing an iron alloy, and an amorphous magnetic powder.
<4> The resin composition according to any one of <1> to <3>, wherein the volume ratio V(a)/V(c) is 25 or less,
   wherein the content (% by volume) of (a) the large-diameter magnetic powder is expressed as V(a) and the content (% by volume) of (c) the small-diameter magnetic powder is expressed as V(c) relative to 100% by volume of the nonvolatile component of the resin composition.
<5> The resin composition according to any one of <1> to <4>, wherein the volume ratio V(a)/V(c) is 15 or less,
   wherein the content (% by volume) of (a) the large-diameter magnetic powder is expressed as V(a) and the content (% by volume) of (c) the small-diameter magnetic powder is expressed as V(c) relative to 100% by volume of the nonvolatile component of the resin composition.
<6> The resin composition according to any one of <1> to <5>, wherein the thermosetting resin contains an epoxy resin.
<7> The resin composition according to any one of <1> to <6>, wherein the thermosetting resin contains a curing agent.
<8> The resin composition according to any one of <1> to <7>, further comprising a thermoplastic resin.
<9> The resin composition according to any one of <1> to <8>, further comprising a curing accelerator.
<10> The resin composition according to any one of <1> to <9>, further comprising a dispersant.
<11> The resin composition according to any one of <1> to <10>, wherein the resin composition is for hole filling.
<12> A production method of the resin composition according to any one of <1> to <11>, the production method comprising mixing together:
   (A) an iron alloy type magnetic powder having an average particle size of more than 20 µm and 50 µm or less,
   (B) an iron alloy type magnetic powder having an average particle size of more than 2 µm and 20 µm or less,
   (C) an iron alloy type magnetic powder having an average particle size of 2 µm or less, and
   (D) a thermosetting resin.
<13> A production method of a resin composition, the production method comprising mixing together:
   (A) an iron alloy type magnetic powder having an average particle size of more than 20 µm and 50 µm or less,
   (B) an iron alloy type magnetic powder having an average particle size of more than 2 µm and 20 µm or less,
   (C) an iron alloy type magnetic powder having an average particle size of 2 µm or less, and
   (D) a thermosetting resin.
<14> The production method of a resin composition according to <12> or <13>, wherein (A) the iron alloy type magnetic powder having an average particle size of more than 20 µm and 50 µm or less contains a nanocrystalline magnetic powder containing an iron alloy.
<15> The production method of a resin composition according to any one of <11> to <14>, wherein the component (B) is at least one iron alloy type magnetic powder selected from a nanocrystalline magnetic powder containing an iron alloy, a Ni-containing iron alloy type magnetic powder, a polycrystalline magnetic powder containing an iron alloy, and an amorphous magnetic powder.
<16> The production method of a resin composition according to any one of <12> to <15>, wherein a blended amount of the component (A) is 60% by volume or more and 75% by volume or less when the nonvolatile component of the resin composition to be produced is 100% by volume.
<17> A cured product of the resin composition according to any one of <1> to <11>.
<18> A magnetic paste comprising the resin composition according to any one of <1> to <11>.
<19> A resin sheet comprising:
   a support; and
   a resin composition layer provided on the support,
   the resin composition layer containing the resin composition according to any one of <1> to <11>.
<20> A circuit board comprising a cured product layer containing a cured product of the resin composition according to any one of <1> to <11>.
<21> The circuit board according to <20>, further comprising:
   a substrate having holes; and
   the cured product of the resin composition filled in the holes.
<22> An inductor substrate comprising the circuit board according to <20> or <21>.

### Advantageous Effects of Invention

The present invention can provide a resin composition that can produce a cured product that can achieve a high specific magnetic permeability in the low-frequency band and has an excellent appearance during application and a production method of the same; a cured product of the resin composition; a magnetic paste and a resin sheet containing the resin composition; and a circuit board and an inductor substrate including a cured product of the resin composition.

### Brief Description of Drawings

Fig. 1 is a cross sectional view schematically illustrating the core substrate prepared in a production method of a circuit board according to the first example of one embodiment of the present invention.
Fig. 2 is a cross sectional view schematically illustrating the core substrate formed with through holes in the production method of the circuit board according to the first example of one embodiment of the present invention.
Fig. 3 is a cross sectional view schematically illustrating the core substrate formed with a plated layer in the through hole in the production method of the circuit board according to the first example of one embodiment of the present invention.
Fig. 4 is a cross sectional view schematically illustrating the state of the through hole in the core substrate filled with a resin composition in the production method of the circuit board according to the first example of one embodiment of the present invention.
Fig. 5 is a schematic cross sectional view to explain the step (2) in the production method of the circuit board according to the first example of one embodiment of the present invention.
Fig. 6 is a schematic cross sectional view to explain the step (3) in the production method of the circuit board according to the first example of one embodiment of the present invention.
Fig. 7 is a schematic cross sectional view to explain the step (5) in the production method of the circuit board according to the first example of one embodiment of the present invention.
Fig. 8 is a schematic cross sectional view to explain the step (5) in the production method of the circuit board according to the first example of one embodiment of the present invention.
Fig. 9 is a schematic cross sectional view to explain the step (i) in the production method of the circuit board according to the second example of one embodiment of the present invention.
Fig. 10 is a schematic cross sectional view to explain the step (i) in the production method of the circuit board according to the second example of one embodiment of the present invention.
Fig. 11 is a schematic cross sectional view to explain the step (ii) in the production method of the circuit board according to the second example of one embodiment of the present invention.
Fig. 12 is a schematic cross sectional view to explain the step (iv) in the production method of the circuit board according to the second example of one embodiment of the present invention.
Fig. 13 is a schematic plan view of the circuit board possessed by the inductor substrate, observed from one side in the thickness direction thereof.
Fig. 14 is a schematic view illustrating the cut end face of a circuit board that is cut at the position indicated by the II-II single-dotted line in Fig. 13.
Fig. 15 is a schematic plan view to explain the composition of the first conductor layer of the circuit board included in the inductor substrate.

### Description of Embodiments

Hereinafter, the present invention will be described in detail by embodiments and examples. The present invention is not limited to the embodiments and examples described below, and the present invention may be carried out with any modification so far as such modification is not outside the claims or the equivalent thereof.

In the following description, the "nonvolatile component" of a resin composition represent a component except a solvent out of components contained in the resin composition. The "resin component" of a resin composition represents a component except inorganic particles such as magnetic powders out of the nonvolatile components contained in the resin composition.

In the following description, the "magnetic permeability" represents "specific magnetic permeability" unless otherwise specified.

In the following description, the term "E₁-E₂ type alloy" represents an alloy containing an element E₁ and an element E₂, and the term "E₁-E₂-E₃ type alloy" represents an alloy containing elements E₁, E₂, and E₃. The same applies to alloys containing four or more elements.

In the following description, the term "E₁ type ferrite" represents an Ferrite containing an element E₁, the term "E₁-E₂ type ferrite" represents an Ferrite containing the element E₁ and an element E₂, and the term "E₁-E₂-E₃ type ferrite" represents an Ferrite containing elements E₁, E₂, and E₃. The same applies to ferrites containing four or more elements. Note that in the ferrite, when Fe is contained in an element such as the element E₁ or the element E₂, Fe means divalent iron, not trivalent iron derived from iron oxide (Fe₂O₃).

### Outline of Resin Composition according to First Embodiment

The resin composition according to a first embodiment of the present invention (hereinafter also referred to as the "resin composition of the present invention") contains a thermosetting resin and an iron alloy type magnetic powder,
a content of (a) an iron alloy type magnetic powder having a particle size of more than 20 µm and 50 µm or less being 26% by volume or more and 45% by volume or less,
a content of (b) an iron alloy type magnetic powder having a particle size of more than 2 µm and 20 µm or less being 28% by volume or more and 68% by volume or less, and
a content of (c) an iron alloy type magnetic powder having a particle size of 2 µm or less being 1% by volume or more and 41% by volume or less,
when a nonvolatile component of the resin composition is 100% by volume.

In the following description, "(a) the iron alloy type magnetic powder having a particle size of more than 20 µm and 50 µm or less" may be referred to as "(a) the large-diameter magnetic powder." "(b) The iron alloy type magnetic powder having a particle size of more than 2 µm and 20 µm or less" may be referred to as "(b) the intermediate magnetic powder." "(c) The iron alloy type magnetic powder having a particle size of 2 µm or less" may be referred to as "(c) the small-diameter magnetic powder." The resin composition according to the first embodiment of the present invention contains (a) the large-diameter magnetic powder, (b) the intermediate magnetic powder, and (c) the small-diameter magnetic powder in specific range amounts, together with a thermosetting resin.

The resin composition of the present invention can be cured by the thermosetting of the thermosetting resin to provide a cured product. The thus obtained cured product can have a high specific magnetic permeability in the low-frequency band (e.g., 10 MHz). In addition, the resin composition of the present invention can have an excellent appearance during application.

As described above, the inventor of the present invention has found that when the magnetic powder is blended into the resin composition to the extent that a high specific magnetic permeability is achieved, even if the resin composition has fluidity, streaks occur during application, resulting in a poor appearance.

Furthermore, the inventor of the present invention has found that a resin composition with a poor appearance during application induces defects such as the generation of voids and poor adhesion to the substrate in a step of filling the holes and a step of embedding the wiring pattern. The generation of voids and poor adhesion to the substrate can cause, for example, a decrease in the inductance value of inductor components.

Against these, according to a resin composition containing a thermosetting resin and an iron alloy type magnetic powder, a content of (a) an iron alloy type magnetic powder having a particle size of more than 20 µm and 50 µm or less being 26% by volume or more and 45% by volume or less, a content of (b) an iron alloy type magnetic powder having a particle size of more than 2 µm and 20 µm or less being 28% by volume or more and 68% by volume or less, and a content of (c) an iron alloy type magnetic powder having a particle size of 2 µm or less being 1% by volume or more and 41% by volume or less when a nonvolatile component of the resin composition is 100% by volume, a cured product that can achieve a high specific magnetic permeability in the low-frequency band can be achieved. In addition, such a resin composition can inhibit the generation of streaks during the application of the resin composition and have an excellent appearance during application. Therefore, the resin composition of the present invention significantly contributes to the achievement of an inductor that simultaneously achieves high functionality and miniaturization.

### (a) Large-Diameter Magnetic Powder (Iron Alloy type Magnetic Powder having Particle Size of more than 20 µm and 50 µm or less) according to First Embodiment

The resin composition according to the first embodiment of the present invention contains (a) the large-diameter magnetic powder (the iron alloy type magnetic powder having a particle size of more than 20 µm and 50 µm or less).

From the viewpoint of being able to better enjoy the effect of the present invention, (a) the large-diameter magnetic powder preferably contains a nanocrystalline magnetic powder containing an iron alloy. In the present specification, the term "nanocrystalline magnetic powder" refers to a magnetic powder containing crystal grains with a grain size of 100 nm or less. There is no particular restriction on the lower limit of the grain size of crystal grains, but it is preferably 1 nm or more. Among other things, the nanocrystalline magnetic powder preferably has a maximum grain size of crystal grains of 100 nm or less. In general, a single particle of the nanocrystalline magnetic powder contains a plurality of crystal grains, and thus the particles of the nanocrystalline magnetic powder can be a polycrystal. The size of crystal grains can be observed, for example, with a transmission electron microscope (TEM). Since the nanocrystalline magnetic powder contains crystal grains, it can generally exhibit peaks indicating crystallinity in an X-ray diffraction pattern. For example, the bcc crystal structure (the body-centered cubic lattice structure) is a crystal structure that crystal grains have, but they may have other crystal structures.

(a) The large-diameter magnetic powder is contained in the resin composition, for example, in the form of particles. (a) The large-diameter magnetic powder may contain crystal grains in at least part of its particles, preferably contains crystal grains on the surface layer of the particles, more preferably contains crystal grains throughout the particles, and even more preferably consists only of crystal grains.

(a) The large-diameter magnetic powder refers to the iron alloy type magnetic powders contained in the resin composition the particle size of which is in the range of more than 20 µm and 50 µm or less. The presence and the content of (a) the large-diameter magnetic powder can be measured by laser diffraction and scattering based on Mie scattering theory. Specifically, it can be measured by creating the particle size distribution of the magnetic powder contained in the resin composition on a volume basis with a laser diffraction scattering type particle size distribution analyzer and from the particle size distribution. As to a sample to be measured, the magnetic powder ultrasonically dispersed in pure water can suitably be used. As the laser diffraction scattering type particle size distribution analyzer, "MT3000II" manufactured by MicrotracBEL Corporation, "LA-960" manufactured by Horiba, Ltd., "SALD-2200" manufactured by Shimadzu Corporation, or the like can be used.

The resin composition of the present invention contains (a) the large-diameter magnetic powder in a specific range of amount. Specifically, the content of (a) the large-diameter magnetic powder is 26% by volume or more, preferably 27% by volume or more, and more preferably 28% by volume when the nonvolatile component of the resin composition is 100% by volume. The upper limit of the content of (a) the large-diameter magnetic powder is 45% by volume or less, preferably 40% by volume or less, and more preferably 35% by volume or less, 34% by volume or less, or 32% by volume or less. When such an amount of (a) the large-diameter magnetic powder is used, the specific magnetic permeability can be improved in the low-frequency band.

Examples of the magnetic material contained in (a) the large-diameter magnetic powder include magnetic metals. Among these, the magnetic material contained in (a) the large-diameter magnetic powder preferably contains iron (Fe). Therefore, examples of the magnetic material contained in (a) the large-diameter magnetic powder include iron alloy magnetic materials having crystallinity. From the viewpoint of producing the effect of the present invention conspicuously, the magnetic material contained in (a) the large-diameter magnetic powder preferably has a composition further containing one or more elements selected from the group consisting of Nb, Hf, Zr, Ta, Mo, W, and V, in combination with Fe.

Preferred examples of the magnetic material contained in (a) the large-diameter magnetic powder include the magnetic materials described in Japanese Patent Application Laid-open No. 2021-158343, Japanese Patent Application Laid-open No. 2021-141267, International Publication No. 2019-31463, Japanese Patent Application Laid-open No. 2021-11602, and the like.

Among the above examples, (a) the large-diameter magnetic powder preferably contains a nanocrystalline magnetic powder containing an Fe-Si-Nb-B type alloy from the viewpoint of producing the desired effect of the present invention conspicuously.

As to (a) the large-diameter magnetic powder, one may be contained alone or two or more having different alloy compositions may be contained in combination.

(a) The large-diameter magnetic powder can be produced, for example, by atomization. Specific examples of the production method of (a) the large-diameter magnetic powder include methods described in Japanese Patent Application Laid-open No. 2021-141267 and Japanese Patent Application Laid-open No. 2021-158343. For (a) the large-diameter magnetic powder, commercially available products may be used. Examples of the commercially available magnetic powder containing (a) the large-diameter magnetic powder include "KUAMET NC1-53um," "KUAMET NC1-75um," "KUAMET NC1 053C03," "KUAMET NC1 075C03," and "KUAMET NC2-53um" manufactured by Epson Atmix Corporation. However, commercially available magnetic powders generally have a wide particle size distribution and can thus contain particles with a particle size of 20 µm or less or particles with a particle size of more than 50 µm. Therefore, when (a) the large-diameter magnetic powder is obtained from the market, a commercially available magnetic powder may be classified and used if necessary.

(a) The large-diameter magnetic powder is preferably spherical. The value obtained by dividing the length of the major axis of the particles of (a) the large-diameter magnetic powder by the length of the minor axis thereof (an aspect ratio) is preferably 2 or less, more preferably 1.5 or less, and even more preferably 1.2 or less, and is, for example, 1 or more, preferably more than 1, and more preferably 1.05 or more.

In the resin composition of the present invention, the content of (a) the large-diameter magnetic powder is preferably 28% by volume or more, more preferably 30% by volume or more, and even more preferably 32% by volume or more, and is preferably 60% by volume or less, more preferably 55% by volume or less, and even more preferably 50% by volume or less, 45% by volume or less, or 40% by volume or less when the entire magnetic powder contained in the resin composition is 100% by volume. When the content (% by volume) of (a) the large-diameter magnetic powder in the entire magnetic powder is within the above range, the specific magnetic permeability can be effectively improved in the low-frequency band.

In the resin composition of the present invention, the content of (a) the large-diameter magnetic powder is preferably 27% by mass or more, more preferably 30% by mass or more, and even more preferably 32% by mass or more, and is preferably 55% by mass or less, and more preferably 50% by mass or less, 45% by mass or less, 40% by mass or less, or 37% by mass or less when the nonvolatile component of the resin composition is 100% by mass. When the content (% by mass) of (a) the large-diameter magnetic powder in the resin composition is within the above range, the specific magnetic permeability can be effectively improved in the low-frequency band.

### (b) Intermediate Magnetic Powder (Iron Alloy type Magnetic Powder having Particle Size of more than 2 µm and 20 µm or less) according to First Embodiment

The resin composition according to the first embodiment of the present invention contains (b) the intermediate magnetic powder having a specific range of particle size. (b) The intermediate magnetic powder is contained in the resin composition, for example, in the form of particles. This (b) intermediate magnetic powder refers to the iron alloy type magnetic powders contained in the resin composition the particle size of which is in the range of more than 2 µm and 20 µm or less. The presence and the content of (b) the intermediate magnetic powder can be determined and measured in the same manner as for (a) the large-diameter magnetic powder. (b) The intermediate magnetic powder is an iron alloy type magnetic powder. As to (b) the intermediate magnetic powder, one may be used alone or two or more may be used in combination.

(b) The intermediate magnetic powder preferably contains at least one iron alloy type magnetic powder selected from a nanocrystalline magnetic powder containing an iron alloy, a Ni-containing iron alloy type magnetic powder, a polycrystalline magnetic powder containing an iron alloy, and an amorphous magnetic powder.

In a preferred embodiment, (b) the intermediate magnetic powder contains a nanocrystalline magnetic powder having a particle size of more than 2 µm and 20 µm or less and containing an iron alloy. The nanocrystalline magnetic powder containing an iron alloy is as described in the section of (a) large-diameter magnetic powder. As to the nanocrystalline magnetic powder as (b) the intermediate magnetic powder, one may be contained alone or two or more having different alloy compositions may be contained in combination.

In another preferred embodiment, (b) the intermediate magnetic powder contains an iron alloy type magnetic powder having a particle size of more than 2 µm and 20 µm or less and containing Ni. Examples of the Ni-containing iron alloy include Fe-Ni type alloys, Fe-Ni-Si type alloys, Fe-Ni-Cr type alloys, Fe-Ni-B type alloys, Fe-Si-Nb-B type alloys, Fe-Ni-Mo type alloys, Fe-Ni-Mo-Cu type alloys, Fe-Ni-Si-Cr type alloys, and Fe-Ni-Co type alloys. As to the Ni-containing iron alloy, one may be used alone or two or more having different alloy compositions may be used in combination. The Ni-containing iron alloy type magnetic powder as (b) the intermediate magnetic powder preferably contains a magnetic powder containing at least any iron alloy out of an Fe-Ni type alloy and an Fe-Ni-Si type alloy. Thus, in a preferred embodiment, the Ni-containing iron alloy type magnetic powder as (b) the intermediate magnetic powder contains one or more magnetic powders selected from the group consisting of an Fe-Ni type alloy magnetic powder and an Fe-Ni-Si type alloy magnetic powder.

In still another preferred embodiment, (b) the intermediate magnetic powder contains a polycrystalline magnetic powder having a particle size of more than 2 µm and 20 µm or less and containing an iron alloy. The polycrystalline magnetic powder containing an iron alloy has grain boundaries because one particle has a plurality of crystal structures. A single-crystalline structure and a polycrystalline structure can be discriminated by observation of crystal lattices using a transmission electron microscope (TEM), observation of grain boundaries using a scanning electron microscope (SEM), or the like. The composition of the iron alloy in the polycrystalline magnetic powder is not limited to a particular composition, and examples thereof include Fe-Si type alloys, Fe-Si-Al type alloys, Fe-Cr type alloys, Fe-Cr-Si type alloys, Fe-Ni-Cr type alloys, Fe-Cr-Al type alloys, Fe-Ni type alloys, Fe-Ni-B type alloys, Fe-Ni-Si type alloys, Fe-Ni-Si-Cr type alloys, Fe-Ni-Mo type alloys, Fe-Ni-Mo-Cu type alloys, Fe-Co type alloys, and Fe-Ni-Co type alloys. As to the polycrystalline magnetic powder containing an iron alloy as (b) the intermediate magnetic powder, one may be used alone or two or more having different alloy compositions may be used in combination.

In yet still another suitable embodiment, (b) the intermediate magnetic powder contains an amorphous magnetic powder having a particle size of more than 2 µm and 20 µm or less. Since amorphous magnetic materials are non-crystalline, they generally do not exhibit certain peaks indicating crystallinity in an X-ray diffraction pattern. Therefore, a broad pattern without peaks indicating crystallinity appears in the X-ray diffraction pattern of the amorphous magnetic powder. As to the amorphous magnetic powder as (b) the intermediate magnetic powder, one may be used alone or two or more having different alloy compositions may be used in combination.

The resin composition of the present invention contains (b) the intermediate magnetic powder in a specific range of amount. Specifically, the content of the component (b) is 28% by volume or more and 68% by volume or less when the nonvolatile component of the resin composition is 100% by volume. The upper limit of the content of the component (b) is preferably 60% by volume or less, more preferably 50% by volume or less, and even more preferably 40% by volume or less or 38% by volume or less. When such an amount of (b) the intermediate magnetic powder is contained, the specific magnetic permeability can be improved in the low-frequency band, and furthermore, the appearance of the resin composition during application can be made good.

For (b) the intermediate magnetic powder, commercially available products may be used. Examples of the commercially available magnetic powder containing (b) the intermediate magnetic powder include "KUAMET NC1-V1-38um," "ATFINE-NC1 PF3FA," "ATFINE-NC1 PF5FA," "ATFINE-NC1 PF10FA," "ATFINE-NC1 PF3FC124A," "ATFINE-NC1 PF5FC124A," and "ATFINE-NC1 PF10FC124A" manufactured by Epson Atmix Corporation (nanocrystalline magnetic powders containing iron alloys); "AKT-PB-3Si(3)" and "AKT-PB(5)" manufactured by Mitsubishi Steel Mfg. Co., Ltd. and "50%FE-50%NI PF-5F," "50%FE-50%NI PF-10F," and "50%FE-50%NI PF-20F" manufactured by Epson Atmix Corporation (Ni-containing iron alloy type magnetic powders); "EA-SMP-10 PF3K," "EA-SMP-10 PF5F," and "EA-SMP-10 PF10F" manufactured by Epson Atmix Corporation (polycrystalline magnetic powders containing iron alloys); and "AW02-08 PF3F," "AW02-08 PF5F," "AW02-08 PF8F," and "AW02-08 PF10F" manufactured by Epson Atmix Corporation (amorphous magnetic powders). However, commercially available magnetic powders generally have a wide particle size distribution and can thus contain particles with a particle size of 2 µm or less or particles with a particle size of more than 20 µm. Therefore, when (b) the intermediate magnetic powder is obtained from the market, a commercially available magnetic powder may be classified and used if necessary.

(b) The intermediate magnetic powder is preferably spherical. The range of the aspect ratio of the particles of (b) the intermediate magnetic powder may be the same as the range of the aspect ratio of (a) the large-diameter magnetic powder. The aspect ratio of (b) the intermediate magnetic powder and the aspect ratio of (a) the large-diameter magnetic powder may be the same or different.

In the resin composition of the present invention, the content of (b) the intermediate magnetic powder is preferably 30% by volume or more, more preferably 32% by volume or more, and even more preferably 34% by volume or more, and is preferably 55% by volume or less, more preferably 50% by volume or less, and even more preferably 45% by volume or less when the entire magnetic powder contained in the resin composition is 100% by volume. When the content (% by volume) of (b) the intermediate magnetic powder in the entire magnetic powder is within the above range, the specific magnetic permeability can be effectively improved in the low-frequency band, and furthermore, the appearance of the resin composition during application can be made good.

In the resin composition of the present invention, the content of (b) the intermediate magnetic powder is preferably 27% by mass or more, more preferably 30% by mass or more, and even more preferably 33% by mass or more, and is preferably 55% by mass or less, more preferably 48% by mass or less, and even more preferably 44% by mass or less when the nonvolatile component of the resin composition is 100% by mass. When the content (% by mass) of (b) the intermediate magnetic powder in the resin composition is within the above range, the specific magnetic permeability can be effectively improved in the low-frequency band, and furthermore, the appearance of the resin composition during application can be made good.

In the resin composition of the present invention, the content (% by volume) of (a) the large-diameter magnetic powder is expressed as "V(a)" and the content (% by volume) of (b) the intermediate magnetic powder is expressed as "V(b)" relative to 100% by volume of the nonvolatile component of the resin composition. In this case, the volume ratio between (a) the large-diameter magnetic powder and (b) the intermediate magnetic powder contained in the resin composition ((a) the large-diameter magnetic powder/(b) the intermediate magnetic powder) can be expressed as "V(a)/V(b)." This volume ratio V(a)/V(b) is preferably 0.4 or more, more preferably 0.6 or more, and even more preferably 0.7 or more, and is preferably 1.1 or less. When the volume ratio V(a)/V(b) is within the above range, the specific magnetic permeability can be effectively improved in the low-frequency band, and furthermore, the appearance of the resin composition during application can be made good.

In the resin composition of the present invention, the total amount (% by volume) of (a) the large-diameter magnetic powder and (b) the intermediate magnetic powder relative to 100% by volume of the nonvolatile components contained in the resin composition can be expressed as "V(a) + V(b)." This total amount (% by volume) V(a) + V(b) is preferably 55% by volume or more, and more preferably 56% by volume or more, and is preferably 90% by volume or less, more preferably 80% by volume or less, and even more preferably 70% by volume or less or 65% by volume or less. When the total amount (% by volume) V(a) + V(b) is within the above range, the specific magnetic permeability can be effectively improved in the low-frequency band, and furthermore, the appearance of the resin composition during application can be made good.

(c) Small-Diameter Magnetic Powder (Iron Alloy type Magnetic Powder having Particle Size of 2 µm or less) according to First Embodiment.

The resin composition according to the first embodiment of the present invention contains (c) the small-diameter magnetic powder having a specific range of particle size. (c) The small-diameter magnetic powder is contained in the resin composition, for example, in the form of particles. This (c) small-diameter magnetic powder refers to the iron alloy type magnetic powders contained in the resin composition the particle size of which is in the range of 2 µm or less. The particle size of (c) the small-diameter magnetic powder can be determined and measured in the same manner as for (a) the large-diameter magnetic powder. (c) The small-diameter magnetic powder is an iron alloy type magnetic powder. As to (c) the small-diameter magnetic powder, one may be used alone or two or more may be used in combination.

(c) The small-diameter magnetic powder may be a nanocrystalline magnetic powder containing crystal grains, a polycrystalline magnetic powder, an amorphous magnetic powder without crystal grains, a crystalline magnetic powder other than the nanocrystalline magnetic powder, or a combination thereof.

Examples of the iron alloy forming (c) the small-diameter magnetic powder include pure iron; and crystalline or non-crystalline alloys such as Fe-Si type alloys, Fe-Si-Cr type alloys, Fe-Si-Al type alloys, Fe-Si-Nb-B type alloys, Fe-Cr type alloys, Fe-Ni-Cr type alloys, Fe-Cr-Al type alloys, Fe-Ni type alloys, Fe-Ni-Si type alloys, Fe-Ni-B type alloys, Fe-Ni-Mo type alloys, Fe-Ni-Mo-Cu type alloys, Fe-Ni-Si-Cr type alloys, Fe-Co type alloys, Fe-Ni-Co type alloys, and Co-based amorphous alloys. Among these, (c) the small-diameter magnetic powder preferably contains a magnetic powder containing at least any iron alloy out of an Fe-Si-Cr type alloy, an Fe-Si-Nb-B type alloy, an Fe-Ni type alloy, and an Fe-Ni-Si type alloy. Thus, in a preferred embodiment, the iron alloy magnetic powder as (c) the small-diameter magnetic powder contains one or more magnetic powders selected from the group consisting of an Fe-Si-Cr type alloy magnetic powder, an Fe-Si-Nb-B type alloy magnetic powder, an Fe-Ni type alloy magnetic powder, and an Fe-Ni-Si type alloy magnetic powder.

The resin composition of the present invention contains (c) the small-diameter magnetic powder having a particle size in the above range in a specific range of amount. Specifically, the content of (c) the small-diameter magnetic powder is 1% by volume or more, preferably 2% by volume or more, more preferably 3% by volume or more, and even more preferably 4% by volume or more when the nonvolatile component of the resin composition is 100% by volume. The upper limit of the amount (% by volume) of (c) the small-diameter magnetic powder is 41% by volume or less, preferably 30% by volume or less, more preferably 20% by volume or less, and even more preferably 15% by volume or less or 14% by volume or less. When such an amount of (c) the small-diameter magnetic powder is contained, the specific magnetic permeability can be improved in the low-frequency band, and furthermore, the appearance of the resin composition during application can be made good.

For (c) the small-diameter magnetic powder, commercially available products may be used. Examples of the commercially available magnetic powder containing (c) the small-diameter magnetic powder include "G00129R" and "CVD iron powder (0.7 µm)" manufactured by JFE Mineral & Alloy Company, Ltd. However, commercially available magnetic powders generally have a wide particle size distribution and can thus contain particles with a particle size of more than 2 µm. Therefore, when (c) the small-diameter magnetic powder is obtained from the market, a commercially available magnetic powder may be classified and used if necessary.

(c) The small-diameter magnetic powder is preferably spherical. The range of the aspect ratio of the particles of (c) the small-diameter magnetic powder may be the same as the range of the aspect ratio of (a) the large-diameter magnetic powder. The aspect ratio of (c) the small-diameter magnetic powder and the aspect ratio of (a) the large-diameter magnetic powder may be the same or different.

In the resin composition of the present invention, the content of (c) the small-diameter magnetic powder is preferably 1% by volume or more, more preferably 3% by volume or more, and even more preferably 5% by volume or more, and is preferably 23% by volume or less, more preferably 20% by volume or less, and even more preferably 17% by volume or less when the entire magnetic powder contained in the resin composition is 100% by volume. When the content (% by volume) of (c) the small-diameter magnetic powder in the entire magnetic powder is within the above range, the specific magnetic permeability can be effectively improved in the low-frequency band, and furthermore, the appearance of the resin composition during application can be made good.

In the resin composition of the present invention, the content of (c) the small-diameter magnetic powder is preferably 1% by mass or more, more preferably 3% by mass or more, and even more preferably 5% by mass or more, and is preferably 30% by mass or less, more preferably 20% by mass or less, and even more preferably 16% by mass or less when the nonvolatile component of the resin composition is 100% by mass. When the content (% by mass) of (c) the small-diameter magnetic powder in the resin composition is within the above range, the specific magnetic permeability can be effectively improved in the low-frequency band, and furthermore, the appearance of the resin composition during application can be made good.

In the resin composition of the present invention, the content (% by volume) of (c) the small-diameter magnetic powder is expressed as "V(c)" relative to 100% by volume of the nonvolatile component of the resin composition. In this case, the volume ratio between (a) the large-diameter magnetic powder and (c) the small-diameter magnetic powder contained in the resin composition ((a) the large-diameter magnetic powder/(c) the small-diameter magnetic powder) can be expressed as "V(a)/V(c)." This volume ratio V(a)/V(c) is preferably 1 or more, more preferably 1.5 or more, and even more preferably 2 or more, and is preferably 30 or less, more preferably 25 or less, even more preferably 15 or less, still even more preferably 15 or less, and yet still even more preferably 10 or less or 7 or less. When the volume ratio V(a)/V(c) is within the above range, the specific magnetic permeability can be effectively improved in the low-frequency band, and furthermore, the appearance of the resin composition during application can be made good.

In the resin composition of the present invention, the total amount (% by volume) of (a) the large-diameter magnetic powder and (c) the small-diameter magnetic powder relative to 100% by volume of the nonvolatile components contained in the resin composition can be expressed as "V(a) + V(c)." This total amount (% by volume) V(a) + V(c) is preferably 28% by volume or more, more preferably 30% by volume or more, and even more preferably 32% by volume or more, and is preferably 60% by volume or less, more preferably 50% by volume or less, and even more preferably 45% by volume or less. When the total amount (% by volume) V(a) + V(c) is within the above range, the specific magnetic permeability can be effectively improved in the low-frequency band, and furthermore, the appearance of the resin composition during application can be made good.

### (D) Thermosetting Resin according to First Embodiment

The resin composition according to the first embodiment of the present invention contains a thermosetting resin (also referred to as "(D) the thermosetting resin" or the "component (D)"). (D) The thermosetting resin may bind a magnetic powder containing (a) the large-diameter magnetic powder, (b) the intermediate magnetic powder, and (c) the small-diameter magnetic powder. In addition, (D) the thermosetting resin may react by heat to form bonds to be cured. Thus, by curing the resin composition containing (a) the large-diameter magnetic powder, (b) the intermediate magnetic powder, (c) the small-diameter magnetic powder, and (D) the thermosetting resin in combination, a cured product can be obtained.

Examples of (D) the thermosetting resin include epoxy resins, phenolic resins, active ester type resins, amine type resins, acid anhydride type resins, benzoxazine type resins, cyanate ester type resins, and carbodiimide type resins. As to (D) the thermosetting resin, one may be used alone or two or more may be used in combination.

(D) The thermosetting resin preferably contains an epoxy resin (also referred to as "(D-1) the epoxy resin" or the "(D-1) component"). (D-1) The epoxy resin represents a resin having one or more epoxy groups in the molecule. When (D) the thermosetting resin contains (D-1) the epoxy resin, the dispersibility of the magnetic powders such as the components (a) to (c) can be improved and the specific magnetic permeability of the cured product of the resin composition can effectively be made good.

Examples of (D-1) the epoxy resin include bixylenol type epoxy resins, bisphenol A type epoxy resins; bisphenol F type epoxy resins; bisphenol S type epoxy resins; bisphenol AF type epoxy resins; dicyclopentadiene type epoxy resins; trisphenol type epoxy resins; phenol novolac type epoxy resins; glycidylamine type epoxy resins; glycidyl ester type epoxy resins; cresol novolac type epoxy resins; biphenyl type epoxy resins; linear aliphatic epoxy resins; epoxy resins having a butadiene structure; alicyclic epoxy resins; alicyclic epoxy resins having an ester skeleton; heterocyclic epoxy resins; spirocycle-containing epoxy resins; cyclohexane type epoxy resins; cyclohexane dimethanol type epoxy resins; trimethylol type epoxy resins; tetraphenylethane type epoxy resins; epoxy resins containing a condensed ring skeleton such as naphthylene ether type epoxy resins, tert-butyl-catechol type epoxy resins, naphthalene type epoxy resins, naphthol type epoxy resins, anthracene type epoxy resins, and naphthol novolac type epoxy resins; isocyanurate type epoxy resins; alkyleneoxy skeleton- and butadiene skeleton-containing epoxy resins; and fluorene structure-containing epoxy resins. As to (D-1) the epoxy resin, one may be used alone or two or more may be used in combination.

(D-1) The epoxy resin preferably contains an epoxy resin having two or more epoxy groups in one molecule. The ratio of the epoxy resin having two or more epoxy groups in one molecule is preferably 50% by mass or more, more preferably 60% by mass or more, and even more preferably 70% by mass or more, and is usually 100% or less relative to 100% by mass of the entire amount of (D-1) the epoxy resin.

(D-1) The epoxy resin includes an epoxy resin liquid at a temperature of 20°C (hereinafter may be referred to as the "liquid epoxy resin") and an epoxy resin solid at a temperature of 20°C (hereinafter may be referred to as the "solid epoxy resin"). (D-1) The epoxy resin may be only the liquid epoxy resin, only the solid epoxy resin, or a combination of the liquid epoxy resin and the solid epoxy resin. When the liquid epoxy resin and the solid resin are used in combination as (D-1) the epoxy resin, the amount ratio between them (the liquid epoxy resin:the solid epoxy resin) is preferably 1:0.01 to 1:50, more preferably 1:0.05 to 1:20, and even more preferably 1:0.1 to 1:10 in terms of mass ratio.

The liquid epoxy resin is preferably a liquid epoxy resin having two or more epoxy groups in one molecule. Preferred examples of the liquid epoxy resin include bisphenol A type epoxy resins, bisphenol F type epoxy resins, bisphenol AF type epoxy resins, naphthalene type epoxy resins, glycidyl ester type epoxy resins, glycidyl amine type epoxy resins, phenol novolac type epoxy resins, alicyclic epoxy resins having an ester skeleton, cyclohexane type epoxy resins, cyclohexanedimethanol type epoxy resins, epoxy resins having a butadiene structure, alkyleneoxy skeleton- and butadiene skeleton-containing epoxy resins, fluorene structure-containing epoxy resins, and dicyclopentadiene type epoxy resins. Among them, bisphenol A type epoxy resins and bisphenol F type epoxy resins are more preferred.

Specific examples of the liquid epoxy resin include "YX7400" manufactured by Mitsubishi Chemical Corporation; "HP4032," "HP4032D," and "HP4032SS" manufactured by DIC Corporation (naphthalene type epoxy resins); "828US," "828EL," "825," and "Epikote 828EL" manufactured by Mitsubishi Chemical Corporation (bisphenol A type epoxy resins); "807" and "1750" manufactured by Mitsubishi Chemical Corporation (bisphenol F type epoxy resins); "152" manufactured by Mitsubishi Chemical Corporation (a phenol novolac type epoxy resin); "630," "630LSD," and "604" manufactured by Mitsubishi Chemical Corporation (glycidyl amine type epoxy resins); "ED-523T" manufactured by ADEKA Corporation (a glycirol type epoxy resin); "EP-3950L" and "EP-3980S" manufactured by ADEKA Corporation (glycidyl amine type epoxy resins); "EP-4088S" manufactured by ADEKA Corporation (a dicyclopentadiene type epoxy resin); "ZX-1059" manufactured by NIPPON STEEL Chemical & Material Co., Ltd. (a mixed product of a bisphenol A type epoxy resin and a bisphenol F type epoxy resin); "EX-721" manufactured by Nagase ChemteX Corporation (a glycidyl ester type epoxy resin); "EX-991L" manufactured by Nagase ChemteX Corporation (an alkyleneoxy skeleton-containing epoxy resin); "Celloxide 2021P" and "Celloxide 2081" manufactured by Daicel Corporation (alicyclic epoxy resins having an ester skeleton); "PB-3600" manufactured by Daicel Corporation and "JP-100" and "JP-200" manufactured by Nippon Soda Co., Ltd. (epoxy resins having a butadiene structure); "ZX-1658" and "ZX-1658GS" manufactured by NIPPON STEEL Chemical & Material Co., Ltd. (liquid 1,4-glycidyl cyclohexane type epoxy resins); and "EG-280" manufactured by Osaka Gas Chemicals Co., Ltd. (a fluorene structure-containing epoxy resin). As to the liquid epoxy resin, one may be used alone or two or more may be used in combination.

The solid epoxy resin is preferably a solid epoxy resin having three or more epoxy groups in one molecule and more preferably an aromatic solid epoxy resin having three or more epoxy groups in one molecule. Preferred examples of the solid epoxy resin include bixylenol type epoxy resins, naphthalene type epoxy resins, naphthalene type tetrafunctional epoxy resins, cresol novolac type epoxy resins, dicyclopentadiene type epoxy resins, trisphenol type epoxy resins, naphthol type epoxy resins, biphenyl type epoxy resins, naphthylene ether type epoxy resins, anthracene type epoxy resins, bisphenol A type epoxy resins, bisphenol AF type epoxy resins, and tetraphenylethane type epoxy resins, and dicyclopentadiene type epoxy resins are more preferred.

Specific examples of the solid epoxy resin include "HP4032H" manufactured by DIC Corporation (a naphthalene type epoxy resin); "HP-4700" and "HP-4710" manufactured by DIC Corporation (naphthalene type tetrafunctional epoxy resins); "N-690" manufactured by DIC Corporation (a cresol novolac type epoxy resin); "N-695" manufactured by DIC Corporation (a cresol novolac type epoxy resin); "HP-7200," "HP-7200HH," and "HP-7200H" manufactured by DIC Corporation (dicyclopentadiene type epoxy resins); "EXA-7311," "EXA-7311-G3," "EXA-7311-G4," "EXA-7311-G4S," and "HP6000" manufactured by DIC Corporation (naphthylene ether type epoxy resins); "EPPN-502H" manufactured by Nippon Kayaku Co., Ltd. (a trisphenol type epoxy resin); "NC-7000L" manufactured by Nippon Kayaku Co., Ltd. (a naphthol novolac type epoxy resin); "NC-3000H," "NC-3000," "NC-3000-L," and "NC-3100" manufactured by Nippon Kayaku Co., Ltd. (biphenyl type epoxy resins); "ESN-475V" manufactured by NIPPON STEEL Chemical & Material Co., Ltd. (a naphthol type epoxy resin); "ESN-485" manufactured by NIPPON STEEL Chemical & Material Co., Ltd. (a naphthol novolac type epoxy resin); "YL6121" manufactured by Mitsubishi Chemical Corporation (a biphenyl type epoxy resin); "YX4000H," "YX4000," and "YX4000HK" manufactured by Mitsubishi Chemical Corporation (bixylenol type epoxy resins); "YX8800" manufactured by Mitsubishi Chemical Corporation (an anthracene type epoxy resin); "YX7700" manufactured by Mitsubishi Chemical Corporation (a xylene structure-containing novolac type epoxy resin); "PG-100" and "CG-500" manufactured by Osaka Gas Chemicals Co., Ltd.; "YL7760" manufactured by Mitsubishi Chemical Corporation (a bisphenol AF type epoxy resin); "YL7800" manufactured by Mitsubishi Chemical Corporation (a fluorene type epoxy resin); "1010" manufactured by Mitsubishi Chemical Corporation (a solid biphenol A type epoxy resin); and "1031S" manufactured by Mitsubishi Chemical Corporation (a tetraphenylethane type epoxy resin). As to the solid epoxy resin, one may be used alone or two or more may be used in combination.

The epoxy equivalent of (D-1) the epoxy resin is preferably 50 g/eq. to 5,000 g/eq., more preferably 50 g/eq. to 3,000 g/eq., even more preferably 80 g/eq. to 2,000 g/eq., and still even more preferably 110 g/eq. to 1,000 g/eq. The epoxy equivalent is the mass of an epoxy resin containing 1 equivalent of epoxy groups. This epoxy equivalent can be measured in accordance with JIS K7236.

The weight average molecular weight (Mw) of (D-1) the epoxy resin is preferably 100 to 5,000, more preferably 250 to 3,000, and even more preferably 400 to 1,500. The weight average molecular weight of the resin can be measured as a value in terms of polystyrene by gel permeation chromatography (GPC).

In the resin composition of the present invention, the content of the component (D-1) is preferably 0.5% by mass or more, more preferably 1% by mass or more, and even more preferably 1.3% by mass or more, and is preferably 3% by mass or less, more preferably 2% by mass or less, and even more preferably 1.6% by mass or less when the nonvolatile component of the resin composition is 100% by mass. When the content (% by mass) of (D-1) the epoxy resin is within the above range, the specific magnetic permeability of the cured product of the resin composition can effectively be made good.

In the resin composition of the present invention, the content of the component (D-1) is preferably 30% by mass or more, more preferably 35% by mass or more, and even more preferably 40% by mass or more, and is preferably 60% by mass or less, more preferably 50% by mass or less, and even more preferably 45% by mass or less when the resin component of the resin composition is 100% by mass. When the content (% by mass) of (D-1) the epoxy resin is within the above range, the specific magnetic permeability of the cured product of the resin composition can effectively be made good.

When (D) the thermosetting resin contains (D-1) the epoxy resin, (D) the thermosetting resin may contain a resin that may react with and bond to (D-1) the epoxy resin. The resin that may react with and bond to (D-1) the epoxy resin may hereinafter be referred to as "(D-2) a curing agent." Examples of (D-2) the curing agent include phenolic resins, active ester type resins, amine type resins, carbodiimide type resins, acid anhydride type resins, benzoxazine type resins, cyanate ester type resins, and thiol type resins. As to (D-2) the curing agent, one may be used alone or two or more may be used in combination. Among them, phenolic resins are preferred.

As the phenolic resins, resins having one or more, preferably two or more hydroxy groups bonding to an aromatic ring such as a benzene ring or a naphthalene ring in one molecule may be used. From the viewpoint of heat resistance and waterproofing, phenolic resins having a novolac structure are preferred. From the viewpoint of adhesion, nitrogen-containing phenolic resins are preferred, and triazine skeleton-containing phenolic resins are more preferred. Among them, from the viewpoint of satisfying heat resistance, waterproofing, and adhesion to a high degree, triazine skeleton-containing phenol novolac resins are preferred.

Specific examples of the phenolic resins include "MEH-7700," "MEH-7810," "MEH-7851," and "MEH-8000H" manufactured by Meiwa Plastic Industries, Ltd.; "NHN," "CBN," and "GPH" manufactured by Nippon Kayaku Co., Ltd.; "SN-170," "SN-180," "SN-190," "SN-475," "SN-485," "SN-495," "SN-495V," "SN-375," and "SN-395" manufactured by NIPPON STEEL Chemical & Material Co., Ltd.; "TD-2090," "TD-2090-60M," "LA-7052," "LA-7054," "LA-1356," "LA-3018," "LA-3018-50P," "EXB-9500," "HPC-9500," "KA-1160," "KA-1163," and "KA-1165 "manufactured by DIC Corporation; and "GDP-6115L," "GDP-6115H," and "ELPC75" manufactured by Gun Ei Chemical Industry Co., Ltd.

As the active ester type resins, compounds having one or more, preferably two or more active ester groups in one molecule may be used. Among them, as the active ester type resins, preferred are compounds having two or more ester groups having high reaction activity in one molecule, such as phenol esters, thiophenol esters, N-hydroxyamine esters, and esters of heterocyclic hydroxy compounds. The active ester type resins are preferably obtained by a condensation reaction of a carboxylic acid compound and/or a thiocarboxylic acid compound and a hydroxy compound and/or a thiol compound. In particular, from the viewpoint of improving heat resistance, active ester type resins obtained from a carboxylic acid compound and a hydroxy compound are preferred, and active ester type resins obtained from a carboxylic acid compound and a phenol compound and/or a naphthol compound are more preferred. Examples of the carboxylic acid compound include benzoic acid, acetic acid, succinic acid, maleic acid, itaconic acid, phthalic acid, isophthalic acid, terephthalic acid, and pyromellitic acid. Examples of the phenol compound or the naphthol compound include hydroquinone, resorcinol, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, dicyclopentadiene type diphenol compounds, and phenol novolac. The "dicyclopentadiene type diphenol compound" refers to a diphenol compound obtained by the condensation of two molecules of phenol to one molecule of dicyclopentadiene.

Preferred specific examples of the active ester type resins include active ester type resins containing a dicyclopentadiene type diphenol structure, active ester type resins containing a naphthalene structure, active ester type resins containing an acetylated product of phenol novolac, and active ester type resins containing a benzoylated product of phenol novolac. Among them, one or more active ester type resins selected from the group consisting of active ester type resins containing a naphthalene structure and active ester type resins containing a dicyclopentadiene type diphenol structure are more preferred. The "dicyclopentadiene type diphenol structure" represents a divalent structural unit containing phenylene-dicyclopentylene-phenylene.

Commercially available products of the active ester type resins include "EXB9451," "EXB9460," "EXB9460S," "HPC-8000-65T," and "EXB-8000L-65TM" (manufactured by DIC Corporation) as active ester type resins containing a dicyclopentadiene type diphenol structure; "EXB-9416-70BK," "EXB-8100L-65T," and "EXB-8150L-65T" (manufactured by DIC Corporation) as active ester type resins containing a naphthalene structure; "DC808" (manufactured by Mitsubishi Chemical Corporation) as an active ester type resin containing an acetylated product of phenol novolac; "YLH1026" (manufactured by Mitsubishi Chemical Corporation) as an active ester type resin containing a benzoylated product of phenol novolac; "DC808" (manufactured by Mitsubishi Chemical Corporation) as an active ester type resin as an acetylated product of phenol novolac; "YLH1026", "YLH1030", and "YLH1048" (manufactured by Mitsubishi Chemical Corporation) as active ester type resins as a benzoylated product of phenol novolac.

As the amine type resins, resins having one or more, preferably two or more amino groups in one molecule may be used. Examples of the amine type resins include aliphatic amines, polyether amines, alicyclic amines, and aromatic amines. Among them, aromatic amines are preferred. The amine type resins are preferably primary amines or secondary amines, and primary amines are more preferred. Specific examples of the amine type resins include 4,4'-methylenebis(2,6-dimethylaniline), diphenyldiaminosulfone, 4,4'-diaminodiphenylmethane, 4,4'-diaminodiphenylsulfone, 3,3'-diaminodiphenylsulfone, m-phenylenediamine, m-xylylenediamine, diethyltoluene diamine, 4,4'-diaminodiphenyl ether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethanediamine, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl)sulfone, and bis(4-(3-aminophenoxy)phenyl)sulfone. As to the amine type resins, commercially available products may be used, and examples thereof include "KAYABOND C-200S," "KAYABOND C-100," "KAYAHARD A-A," "KAYAHARD A-B," and "KAYAHARD A-S" manufactured by Nippon Kayaku Co., Ltd. and "Epikure W" manufactured by Mitsubishi Chemical Corporation.

As the carbodiimide type resins, resins having one or more, preferably two or more carbodiimide structures in one molecule may be used. Specific examples of the carbodiimide type resins include aliphatic biscarbodiimides such as tetramethylene-bis(t-butylcarbodiimide) and cyclohexane-bis(methylene-t-butylcarbodiimide); biscarbodiimides such as aromatic biscarbodiimides such as phenylene-bis(xylylcarbodiimide); aliphatic polycarbodiimides such as polyhexamethylenecarbodiimide, polytrimethylhexamethylenecarbodiimide, polycyclohexylenecarbodiimide, poly(methylenebiscyclohexylenecarbodiimide), and poly(isophoronecarbodiimide); and polycarbodiimides such as aromatic polycarbodiimides such as poly(phenylenecarbodiimide), poly(naphthylenecarbodiimide), poly(tolylenecarbodiimide), poly(methyldiisopropylphenylenecarbodiimide), poly(triethylphenylenecarbodiimide), poly(diethylphenylenecarbodiimide), poly(triisopropylphenylenecarbodiimide), poly(diisopropylphenylenecarbodiimide), poly(xylylenecarbodiimide), Poly(tetramethylxylylenecarbodiimide), poly(methylenediphenylenecarbodiimide), and poly[methylenebis(methylphenylene)carbodiimide]. Commercially available products of the carbodiimide type resins include "Carbodilite V-02B," "Carbodilite V-03," "Carbodilite V-04K," "Carbodilite V-07," and "Carbodilite V-09" manufactured by Nisshinbo Chemical Inc.; and "Stabaxol P," "Stabaxol P400," and "Hycasyl 510" manufactured by Lanxess.

As the acid anhydride type resins, resins having one or more acid anhydride groups in one molecule can be used, and resins having two or more acid anhydride groups in one molecule are preferred. Specific examples of the acid anhydride type resins include phthalic anhydride, tetrahydrophthalic anhydride, hexahydrophthalic anhydride, methyltetrahydrophthalic anhydride, methylhexahydrophthalic anhydride, methylnadic anhydride, hydrogenated methylnadic anhydride, trialkyl tetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphtho[1,2-C]furan-1,3-dione, ethylene glycol bis(anhydrotrimellitate), and polymer type acid anhydrides such as styrene-maleic acid resins in which styrene and maleic acid are copolymerized. Commercially available products of the acid anhydride type resins include "HNA-100," "MH-700," "MTA-15," "DDSA," and "OSA" manufactured by New Japan Chemical Co., Ltd.; "YH-306" and "YH-307" manufactured by Mitsubishi Chemical Corporation; "HN-2200" and "HN-5500" manufactured by Resonac Corporation; and "EF-30," "EF-40," "EF-60," and "EF-80" manufactured by Cray Valley.

Specific examples of the benzoxazine type resins include "JBZ-OD100," "JBZ-OP100D," and "ODA-BOZ" manufactured by JFE Chemical Corporation; "P-d" and "F-a" manufactured by Shikoku Chemicals Corporation; and "HFB2006M" manufactured by Showa Highpolymer Co., Ltd.

Examples of the cyanate ester type resins include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidenediphenyldicyanate, hexafluorobisphenol A dicyanate, 2,2-bis(4-cyanate)phenylpropane, 1,1-bis(4-cyanatophenyl)methane, bis(4-cyanate-3,5-dimethylphenyl)methane, 1,3-bis(4-cyanatophenyl-1-(methylethylidene))benzene, bis(4-cyanatophenyl)thioether, and bis(4-cyanatophenyl)ether; polyfunctional cyanate resins derived from phenol novolac, cresol novolac, and the like; and prepolymers in which these cyanate resins partially become triazine. Specific examples of the cyanate ester type resins include "PT30" and "PT60" (phenol novolac type polyfunctional cyanate ester resins), "ULL-950S" (a polyfunctional cyanate ester resin), and "BA230" and "BA230S75" (prepolymers in which part or all of bisphenol A dicyanate becomes triazine to become trimers) manufactured by Arxada.

Examples of the thiol type resins include trimethylolpropane tris(3-mercaptopropionate), pentaerythritol tetrakis(3-mercaptobutyrate), and tris(3-mercaptopropyl)isocyanurate.

The active group equivalent of (D-2) the curing agent is preferably 50 g/eq. to 3,000 g/eq., more preferably 100 g/eq. to 1,000 g/eq., even more preferably 100 g/eq. to 500 g/eq., and still even more preferably 100 g/eq. to 300 g/eq. The active group equivalent represents the mass of (D-2) the curing agent per equivalent of an active group.

When the number of epoxy groups of (D-1) the epoxy resin is 1, the number of active groups of (D-2) the curing agent is preferably 0.01 or more, more preferably 0.1 or more, and even more preferably 0.5 or more, and is preferably 10 or less, more preferably 5 or less, and even more preferably 3 or less. The active group of (D-2) the curing agent is an active hydroxy group or the like, which varies by the type of the curing agent. The number of epoxy groups of (D-1) the epoxy resin is a value obtained by totaling a value obtained by dividing the mass of each epoxy resin by the epoxy equivalent for all the epoxy resins. The number of active groups of (D-2) the curing agent is a value obtained by totaling a value obtained by dividing the mass of each curing agent by the active group equivalent for all the curing agents.

In the resin composition of the present invention, the content of the component (D-2) is preferably 0.5% by mass or more, more preferably 1% by mass or more, and even more preferably 1.3% by mass or more, and is preferably 3% by mass or less, more preferably 2% by mass or less, and even more preferably 1.5% by mass or less when the nonvolatile component of the resin composition is 100% by mass. When the amount (% by mass) of (D-2) the curing agent is within the above range, the specific magnetic permeability of the cured product of the resin composition can effectively be made good.

In the resin composition of the present invention, the content of the component (D-2) is preferably 30% by mass or more, more preferably 35% by mass or more, and even more preferably 40% by mass or more, and is preferably 60% by mass or less, more preferably 50% by mass or less, and even more preferably 45% by mass or less when the resin component of the resin composition is 100% by mass. When the content (% by mass) of (D-2) the curing agent is within the above range, the specific magnetic permeability of the cured product of the resin composition can effectively be made good.

The range of the weight average molecular weight (Mw) of (D) the thermosetting resin may normally be the same as the range of the weight average molecular weight of (D-1) the epoxy resin described above.

In the resin composition of the present invention, the content of the component (D) is preferably 2% by mass or more, more preferably 2.5% by mass or more, and even more preferably 2.8% by mass or more, and is preferably 5% by mass or less, more preferably 4% by mass or less, and even more preferably 3% by mass or less when the nonvolatile component of the resin composition is 100% by mass. When the content (% by mass) of (D) the thermosetting resin is within the above range, the specific magnetic permeability of the cured product of the resin composition can effectively be made good.

In the resin composition of the present invention, the content of the component (D) is preferably 60% by mass or more, more preferably 70% by mass or more, and even more preferably 80% by mass or more, and is preferably 90% by mass or less, more preferably 88% by mass or less, and even more preferably 87% by mass or less when the resin component of the resin composition is 100% by mass. When the content (% by mass) of (D) the thermosetting resin is within the above range, the specific magnetic permeability of the cured product of the resin composition can effectively be made good.

### (e) The Other Magnetic Powder according to First Embodiment

The resin composition according to the first embodiment of the present invention may further contain a magnetic powder other than the magnetic powders consisting of the components (a) to (c) (also referred to as "(e) the other magnetic powders" or the "component (e)") as an optional component in combination with the magnetic powders consisting of the components (a) to (c) and in combination with the component (D) described above.

As (e) the other magnetic powder, particles of a material having a specific magnetic permeability of greater than 1 may be used. The material of (e) the other magnetic powder is, for example, an inorganic material. In addition, the material of (e) the other magnetic powder may be a soft magnetic material or a hard magnetic material. As to the material of (e) the other magnetic powder, one may be used alone or two or more may be used in combination. Thus, (e) the other magnetic powder may be a soft magnetic powder, a hard magnetic powder, or a combination of the soft magnetic powder and the hard magnetic powder. In particular, (e) the other magnetic powder preferably contains the soft magnetic powder and more preferably contains only the soft magnetic powder.

Examples of (e) the other magnetic powder include magnetic metal oxide powders and magnetic metallic powders.

Examples of the magnetic metal oxide powders include ferrite type magnetic powders; and iron oxide powders such as iron oxide powders (III) and triiron tetraoxide powders.

Examples of the material of the ferrite type magnetic powders include Mn type ferrites, Mn-Mg type ferrites, Mn-Mg-Sr type ferrites, Mg-Zn type ferrites, Mg-Sr type ferrites, Zn-Mn type ferrites, Cu-Zn type ferrites, Ni-Zn type ferrites, Ni-Zn-Cu type ferrites, Ba-Zn type ferrites, Ba-Mg type ferrites, Ba-Ni type ferrites, Ba-Co type ferrites, Ba-Ni-Co type ferrites, and Y type ferrites.

Examples of the material of the magnetic metallic powders include pure iron; and crystalline or non-crystalline alloy magnetic materials such as Fe-Si type alloys, Fe-Si-Al type alloys, Fe-Cr type alloys, Fe-Cr-Si type alloys, Fe-Ni-Cr type alloys, Fe-Cr-Al type alloys, Fe-Ni type alloys, Fe-Ni-B type alloys, Fe-Ni-Mo type alloys, Fe-Ni-Mo-Cu type alloys, Fe-Co type alloys, Fe-Ni-Co type alloys, and Co-based amorphous alloys.

When the resin composition of the present invention contains (e) the other magnetic powder, the amount of the component (e) is preferably adjusted such that the magnetic powders consisting of the components (a) to (c) meet the content ranges described above.

When the resin composition of the present invention contains (e) the other magnetic powder, the content of the component (e) may be 0% by volume or more than 0% by volume, is preferably 0.1% by volume or more, more preferably 1% by volume or more, and even more preferably 3% by volume or more, and is preferably 25% by volume or less, more preferably 15% by volume or less, and even more preferably 10% by volume or less relative to 100% by volume of the nonvolatile components of the resin composition.

When the resin composition of the present invention contains (e) the other magnetic powder, the content of the component (e) may be 0% by mass or more than 0% by mass, is preferably 0.1% by mass or more, more preferably 1% by mass or more, and even more preferably 3% by mass or more, and is preferably 25% by mass or less, more preferably 15% by mass or less, and even more preferably 10% by mass or less when the nonvolatile component of the resin composition is 100% by mass.

### (F) Thermoplastic Resin according to First Embodiment

The resin composition according to the first embodiment of the present invention may further contain a thermoplastic resin (also referred to as "(F) the thermoplastic resin" or the "component (F)") as an optional component in combination with the magnetic powders including the components (a) to (c) and in combination with the component (D) and the component (E) described above. (F) The thermoplastic resin does not include those corresponding to the component (D) described above. (F) The thermoplastic resin can effectively improve the mechanical characteristics of the cured product of the resin composition.

Examples of (F) the thermoplastic resin include phenoxy resins, polyimide resins, polyvinyl acetal resins, polyolefin resins, polybutadiene resins, polyamideimide resins, polyetherimide resins, polysulfone resins, polyethersulfone resins, polyphenylene ether resins, polycarbonate resins, polyetheretherketone resins, and polyester resins. As to (F) the thermoplastic resin, one may be used alone or two or more may be used in combination.

Examples of the phenoxy resins include phenoxy resins having one or more skeletons selected from the group consisting of a bisphenol A skeleton, a bisphenol F skeleton, a bisphenol S skeleton, a bisphenol acetophenone skeleton, a novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton. The end of the phenoxy resins may be any functional group such as a phenolic hydroxy group or an epoxy group. Specific examples of the phenoxy resins include "1256" and "4250" manufactured by Mitsubishi Chemical Corporation (both are phenoxy resins containing a bisphenol A skeleton); "YX8100" manufactured by Mitsubishi Chemical Corporation (a phenoxy resin containing a bisphenol S skeleton); "YX6954" manufactured by Mitsubishi Chemical Corporation (a phenoxy resin containing a bisphenol acetophenone skeleton); "FX280" and "FX293" manufactured by NIPPON STEEL Chemical & Material Co., Ltd.; and "YL7500BH30," "YX6954BH30," "YX7553," "YX7553BH30," "YL7769BH30," "YL6794," "YL7213," "YL7290," "YL7482," and "YL7891BH30" manufactured by Mitsubishi Chemical Corporation.

Specific examples of the polyimide resins include "SLK-6100" manufactured by Shin-Etsu Chemical Co., Ltd. and "Rikacoat SN20" and "Rikacoat PN20" manufactured by New Japan Chemical Co., Ltd. Specific examples of the polyimide resins also include modified polyimides such as a linear polyimide obtained by reacting a bifunctional hydroxy group-terminated polybutadiene, a diisocyanate compound, and a tetrabasic acid anhydride (the polyimide described in Japanese Patent Application Laid-open No. 2006-37083) and polysiloxane skeleton-containing polyimides (the polyimides described in Japanese Patent Application Laid-open No. 2002-12667, Japanese Patent Application Laid-open No. 2000-319386, and the like).

Examples of the polyvinyl acetal resins includes polyvinylformal resins and polyvinyl butyral resins, and polyvinyl butyral resins are preferred. Specific examples of the polyvinyl acetal resins include the S-LEC BH series, BX series (for example, BX-5Z), KS series (for example, KS-1), BL series, and BM series manufactured by Sekisui Chemical Co., Ltd.

Examples of the polyolefin resins include low-density polyethylenes, ultralow-density polyethylenes, high-density polyethylenes, ethylene type copolymer resins such as ethylene-vinyl acetate copolymers, ethylene-ethyl acrylate copolymers, and ethylene-methyl acrylate copolymers; polyolefin type polymers such as polypropylenes and ethylene-propylene block copolymers.

Examples of the polybutadiene resins include hydrogenated polybutadiene skeleton-containing resins, hydroxy group-containing polybutadiene resins, phenolic hydroxy group-containing polybutadiene resins, carboxy group-containing polybutadiene resins, acid anhydride group-containing polybutadiene resins, epoxy group-containing polybutadiene resins, isocyanate group-containing polybutadiene resins, urethane group-containing polybutadiene resins, and polyphenylene ether-polybutadiene resins.

Specific examples of the polyamideimide resins include "Vylomax HR11NN" and "Vylomax HR16NN" manufactured by Toyobo Co., Ltd. Specific examples of the polyamideimide resins also include modified polyamideimides such as "KS9100" and "KS9300" (polyamideimide containing a polysiloxane skeleton) manufactured by Hitachi Chemical Co., Ltd.

Specific examples of the polyethersulfone resins include "PES5003P" manufactured by Sumitomo Chemical Co., Ltd.

Specific examples of the polysulfone resins include Polysulfone "P1700" and "P3500" manufactured by Solvay Advanced Polymers, Inc.

Specific examples of the polyphenylene ether resins include "NORYL SA90" manufactured by SABIC. Specific examples of the polyetherimide resins include "Ultem" manufactured by General Electric Company.

Examples of the polycarbonate resins include hydroxy group-containing carbonate resins, phenolic hydroxy group-containing carbonate resins, carboxy group-containing carbonate resins, acid anhydride group-containing carbonate resins, isocyanate group-containing carbonate resins, and urethane group-containing carbonate resins. Specific examples of the polycarbonate resins include "FPC0220" manufactured by Mitsubishi Gas Chemical Company, Inc.; "T6002" and "T6001" manufactured by Asahi Kasei Corporation (polycarbonate diols); and "C-1090," "C-2090," and "C-3090" manufactured by Kuraray Co., Ltd. (polycarbonate diols). Specific examples of the polyetheretherketone resins include "Sumiploy K" manufactured by Sumitomo Chemical Co., Ltd.

Examples of the polyester resins include polyethylene terephthalate resins, polyethylene naphthalate resins, polybutylene terephthalate resins, polybutylene naphthalate resins, polytrimethylene terephthalate resins, polytrimethylene naphthalate resins, and polycyclohexanedimethyl terephthalate resins.

The weight average molecular weight (Mw) of (F) the thermoplastic resin is preferably greater than 5,000, more preferably 8,000 or more, even more preferably 10,000 or more, and still even more preferably 20,000 or more. There is no particular limitation on the upper limit thereof, which may be, for example, 1,000,000 or less, 500,000 or less, or 100,000 or less.

When the resin composition contains (F) the thermoplastic resin, the content of the component (F) is preferably 0.1% by mass or more, more preferably 0.2% by mass or more, and even more preferably 0.3% by mass or more, and is preferably 1% by mass or less, more preferably 0.7% by mass or less, and even more preferably 0.5% by mass or less when the nonvolatile component of the resin composition is 100% by mass.

When the resin composition contains (F) the thermoplastic resin, the content of the component (F) is preferably 5% by mass or more, more preferably 8% by mass or more, and even more preferably 10% by mass or more, and is preferably 15% by mass or less, more preferably 13% by mass or less, and even more preferably 12% by mass or less when the resin component of the resin composition is 100% by mass.

### (G) Curing Accelerator according to First Embodiment

The resin composition according to the first embodiment of the present invention may further contain a curing accelerator (also referred to as "(G) the curing accelerator" or the "component (G)") as an optional component in combination with the magnetic powders including the components (a) to (c) and in combination with the components (D) to (F) described above. (G) The curing accelerator does not include those corresponding to the magnetic powders including the components (a) to (c) and does not include those corresponding to the components (D) to (F) described above. (G) The curing accelerator has a function as a catalyst of the reaction of (D) the thermosetting resin and can thus accelerate the curing of the resin composition.

Examples of (G) the curing accelerator include imidazole type curing accelerators, phosphorus type curing accelerators, amine type curing accelerators, guanidine type curing accelerators, metallic curing accelerators, and urea type curing accelerators. As to (G) the curing accelerator, one may be used alone or two or more may be used in combination. Among them, as (G) the curing accelerator, one or more curing accelerators selected from the group consisting of the imidazole type curing accelerators and the phosphorus type curing accelerators are preferred, and the imidazole type curing accelerators are more preferred.

Examples of the imidazole type curing accelerators include imidazole compounds and adducts of imidazole compounds and epoxy resins such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanuric acid adduct, 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline, and 2-phenylimidazoline, and 2-ethyl-4-methylimidazole and 1-benzyl-2-phenylimidazole are preferred. As to the imidazole type curing accelerators, commercially available products may be used, and examples thereof include "P200-H50" manufactured by Mitsubishi Chemical Corporation; and "Curezol 2MZ," "2E4MZ," "Cl1Z," "Cl1Z-CN," "Cl1Z-CNS," "Cl1Z-A," "2MZ-OK," "2MA-OK," "2MA-OK-PW," "2MZA-PW," "2PHZ," "2PHZ-PW," "1B2PZ," and "1B2PZ-10M" manufactured by Shikoku Chemicals Corporation.

Examples of the phosphorus type curing accelerators include phosphonium salts and phosphines. Examples of the phosphonium salts include aliphatic phosphonium salts such as tetrabutylphosphonium bromide, tetrabutylphosphonium chloride, tetrabutylphosphonium acetate, tetrabutylphosphonium decanoate, tetrabutylphosphonium laurate, n-butylphosphonium tetraphenylborate, bis(tetrabutylphosphonium)pyromellitate, tetrabutylphosphonium hydrogen hexahydrophthalate, tetrabutylphosphonium 2,6-bis[(2-hydroxy-5-methylphenyl)methyl]-4-methylphenolate, and di-tert-butylmethylphosphonium tetraphenylborate; and aromatic phosphonium salts such as methyltriphenylphosphonium bromide, ethyltriphenylphosphonium bromide, propyltriphenylphosphonium bromide, butyltriphenylphosphonium bromide, benzyltriphenylphosphonium chloride, tetraphenylphosphonium bromide, p-tolyltriphenylphosphonium tetra-p-tolylborate, tetraphenylphosphonium tetraphenylborate, tetraphenylphosphonium tetra-p-tolylborate, triphenylethylphosphonium tetraphenylborate, tris(3-methylphenyl)ethylphosphonium tetraphenylborate, tris(2-methoxyphenyl)ethylphosphonium tetraphenylborate, (4-methylphenyl)triphenylphosphonium thiocyanate, tetraphenylphosphonium thiocyanate, and butyltriphenylphosphonium thiocyanate.

Examples of the phosphines include aliphatic phosphines such as tributylphosphine, tri-tert-butylphosphine, trioctylphosphine, di-tert-butyl(2-butenyl) phosphine, di-tert-butyl(3-methyl-2-butenyl) phosphine, and tricyclohexyl phosphine; aromatic phosphines such as dibutylphenylphosphine, di-tert-butylphenylphosphine, methyldiphenylphosphine, ethyldiphenylphosphine, butyldiphenylphosphine, diphenylcyclohexylphosphine, triphenylphosphine, tri-o-tolylphosphine, tri-m-tolylphosphine, tri-p-tolylphosphine, tris(4-ethylphenyl)phosphine, tris(4-propylphenyl) phosphine, tris(4-isopropylphenyl)phosphine, tris(4-butylphenyl)phosphine, tris(4-tert-butylphenyl)phosphine, tris(2,4-dimethylphenyl)phosphine, tris(2,5-dimethylphenyl)phosphine, tris(2,6-dimethylphenyl)phosphine, tris(3,5-dimethylphenyl) phosphine, tris(2,4,6-trimethylphenyl) phosphine, tris(2,6-dimethyl-4-ethoxyphenyl) phosphine, tris(2-methoxyphenyl)phosphine, tris(4-methoxyphenyl)phosphine, tris(4-ethoxyphenyl) phosphine, tris(4-tert-butoxyphenyl)phosphine, diphenyl-2-pyridylphosphine, 1,2-bis(diphenylphosphino)ethane, 1,3-bis(diphenylphosphino)propane, 1,4-bis(diphenylphosphino)butane, 1,2-bis(diphenylphosphino)acetylene, and 2,2'-bis(diphenylphosphino)diphenyl ether; aromatic phosphine borane complexes such as triphenylphosphine triphenylborane; and aromatic phosphine quinone addition reaction products such as triphenylphosphine p-benzoquinone addition reaction products.

As to the phosphorus type curing accelerators, commercially available products may be used, and examples thereof include "TBP-DA" manufactured by Hokko Chemical Industry Co., Ltd.

Examples of the amine type curing accelerators include trialkylamines such as triethylamine and tributylamine, 4-dimethylaminopyridine, benzyl dimethylamine, 2,4,6-tris(dimethylaminomethyl)phenol, 1,8-diazabicyclo[5,4,0]undecene, 1,8-diazabicyclo[5,4,0]undecene-7,4-dimethylaminopyridine, and 2,4,6-tris(dimethylaminomethyl)phenol, and 4-dimethylaminopyridine is preferred. As to the amine type curing accelerators, commercially available products may be used, and examples thereof include "PN-50," "PN-23," and "MY-25" manufactured by Ajinomoto Fine-Techno Co., Inc.

Examples of the guanidine type curing accelerators include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]dec-5-ene, 7-methyl-1,5,7-triazabicyclo[4.4.0]dec-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide, and dicyandiamide and 1,5,7-triazabicyclo[4.4.0]dec-5-ene are preferred.

Examples of the metallic curing accelerators include organometallic complexes or organometallic salts of metals such as cobalt, copper, zinc, iron, nickel, manganese, and tin. Specific examples of the organometallic complexes include organocobalt complexes such as cobalt(II) acetylacetonate and cobalt(III) acetylacetonate, organocopper complexes such as copper(II) acetylacetonate, organozinc complexes such as zinc(II) acetylacetonate, organoiron complexes such as iron(III) acetylacetonate, organonickel complexes such as nickel(II) acetylacetonate, and organomanganese complexes such as manganese(II) acetylacetonate. Examples of the organometallic salts include zinc octylate, tin octylate, zinc naphthenate, cobalt naphthenate, tin stearate, and zinc stearate.

Examples of the urea type curing accelerators include aliphatic dimethylureas such as 1,1-dimethylurea, 1,1,3-trimethylurea, 3-ethyl-1,1-dimethylurea, 3-cyclohexyl-1,1-dimethylurea, and 3-cyclooctyl-1,1-dimethylurea; aromatic dimethylureas such as 3-phenyl-1,1-dimethylurea, 3-(4-chlorophenyl)-1,1-dimethylurea, 3-(3,4-dichlorophenyl)-1,1-dimethylurea, 3-(3-chloro-4-methylphenyl)-1,1-dimethylurea, 3-(2-methylphenyl)-1,1-dimethylurea, 3-(4-methylphenyl)-1,1-dimethylurea, 3-(3,4-dimethylphenyl)-1,1-dimethylurea, 3-(4-isopropylphenyl)-1,1-dimethylurea, 3-(4-methoxyphenyl)-1,1-dimethylurea, 3-(4-nitrophenyl)-1,1-dimethylurea, 3-[4-(4-methoxyphenoxy)phenyl]-1,1-dimethylurea, 3-[4-(4-chlorophenoxy)phenyl]-1,1-dimethylurea, 3-[3-(trifluoromethyl)phenyl]-1,1-dimethylurea, N,N-(1,4-phenylene)bis(N',N'-dimethylurea), and N,N-(4-methyl-1,3-phenylene)bis(N',N'-dimethylurea) [toluene bis(dimethylurea)].

When the resin composition of the present invention contains (G) the curing accelerator, the content of the component (G) is preferably 0.001% by mass or more, and more preferably 0.01% by mass or more, and is preferably 0.05% by mass or less, and more preferably 0.03% by mass or less when the nonvolatile component of the resin composition is 100% by mass.

When the resin composition of the present invention contains (G) the curing accelerator, the content of the component (G) is preferably 0.1% by mass or more, more preferably 0.3% by mass or more, and even more preferably 0.5% by mass or more, and is preferably 1.5% by mass or less, more preferably 1% by mass or less, and even more preferably 0.7% by mass or less when the resin component of the resin composition is 100% by mass.

### (H) Dispersant according to First Embodiment

The resin composition according to the first embodiment of the present invention may further contain a dispersant (also referred to as "(H) the dispersant" or the "component (H)") as an optional component in combination with the magnetic powders comprising the components (a) to (c) and in combination with the components (D) to (G) described above. (H) The dispersant does not include those corresponding to the components (D) to (G) described above. (H) The dispersant can enhance the dispersibility of the magnetic powders such as the components (a) to (c).

As (H) the dispersant, a compound that can reduce the viscosity of the resin composition may be used. Examples of (H) the dispersant include phosphate type dispersants, polyoxyalkylene type dispersants, acetylene type dispersants, silicone type dispersants, anionic dispersants, and cationic dispersants. As to (H) the dispersant, one may be used alone or two or more may be used in combination. Among them, the phosphate type dispersants are preferred.

Among the phosphate type dispersants, polyether type phosphate type dispersants are preferred. The polyether type phosphate type dispersants are phosphate type dispersants containing a poly(alkyleneoxy) structure in the molecule. Examples of the polyether type phosphate type dispersants include polyoxyalkylene alkyl ether phosphates and polyoxyalkylene alkyl phenyl ether phosphates. Among them, the polyoxyalkylene alkyl ether phosphates are preferred.

The polyoxyalkylene alkyl ether phosphates can have a structure in which one to three alkyl-oxy-poly(alkyleneoxy) groups are bonded to the phosphorus atom of phosphates. The number of alkyleneoxy units (the number of repeating units) of the poly(alkyleneoxy) moiety in the alkyl-oxy-poly(alkyleneoxy) group is preferably 2 to 30, and more preferably 3 to 20. The alkylene group in the poly(alkyleneoxy) moiety is preferably an alkylene group with two to four carbon atoms. Examples of such an alkylene group include an ethylene group, a propylene group, an isopropylene group, a butylene group, and an isobutyl group. Furthermore, the alkyl group in the alkyl-oxy-poly(alkyleneoxy) group is preferably an alkyl group with 6 to 30 carbon atoms, and more preferably an alkyl group with 8 to 20 carbon atoms. Examples of such an alkyl group include a decyl group, an undecyl group, a dodecyl group, a tridecyl group, a tetradecyl group, a pentadecyl group, a hexadecyl group, a heptadecyl group, and an octadecyl group. When a polyoxyalkylene alkyl ether phosphate has a plurality of alkyl-oxy-poly(alkyleneoxy) groups, the plurality of alkyl groups may be the same or different. Furthermore, when a polyoxyalkylene alkyl ether phosphate has a plurality of alkyl-oxy-poly(alkyleneoxy) groups, the plurality of alkylene groups may be the same or different.

The acid value of the polyether type phosphate type dispersants is preferably 10 or more, and more preferably 15 or more, and is preferably 200 or less, and more preferably 150 or less. The acid value of the dispersant can be measured by the neutralization titration method.

Examples of the commercially available product of the phosphate type dispersants include polyether type phosphate type dispersants manufactured by Kusumoto Chemicals, Ltd. (e.g., "ED152," "ED153," "ED154," "ED118," "ED174," "ED251," and the like of the HIPLAAD series); and "RS-410," "RS-610," and "RS-710" of the Phosphanol series manufactured by Toho Chemical Industry Co., Ltd.

Examples of the polyoxyalkylene type dispersants include polyoxyethylene alkyl ethers, polyoxyethylene alkyl esters, polyoxyethylene sorbitan fatty acid esters, polyoxyethylene alkyl phenyl ethers, polyoxyethylene alkyl amines, and polyoxyethylene alkyl amides. Examples of the commercially available product of the polyoxyalkylene type dispersants include "AKM-0531," "AFB-1521," "SC-0505K," "SC-1015F," "SC-0708A," and "HKM-50A" of the "Malialim" series manufactured by NOF Corporation.

Examples of the acetylene type dispersants include acetylene glycol. Examples of the commercially available product of acetylene type dispersants include "82," "104," "440," "465," "485," and "Olefin Y" of the "Surfynol" series manufactured by Air Products and Chemicals Inc.

Examples of the silicone type dispersants include polyether-modified polydimethylsiloxane, polyether-modified siloxane, and polyester-modified polydimethylsiloxane. Examples of the commercially available product of the silicone type dispersants include "BYK347" and "BYK348" manufactured by BYK-Chemie.

Examples of the anionic dispersants include sodium polyacrylate, sodium dodecylbenzene sulfonate, sodium laurate, ammonium polyoxyethylene alkyl ether sulfate, and sodium carboxymethyl cellulose. Examples of the commercially available product of the anionic dispersants include "PN-411" and "PA-111" manufactured by Ajinomoto Fine-Techno Co., Inc.; and "A-550" and "PS-1900" manufactured by Lion Corporation.

Examples of the cationic dispersants include amino group-containing polyacrylate type resins and amino group-containing polystyrene type resins. Examples of the commercially available product of the cationic dispersants include "161," "162," "164," "182," "2000," and "2001" manufactured by BYK-Chemie; "PB-821," "PB-822," "PB-824," and "PB-881" manufactured by Ajinomoto Fine-Techno Co., Inc.; "V-216" and "V-220" manufactured by ISP Japan Ltd.; and "Solspers 13940," "Solspers 24000," and "Solspers 32000" manufactured by Lubrizol Corporation.

As to (H) the dispersant, one may be used alone or two or more may be used in combination.

When the resin composition of the present invention contains (H) the dispersant, the content of the component (H) is preferably 0.01% by mass or more, more preferably 0.05% by mass or more, and even more preferably 0.1% by mass or more, and is preferably 1% by mass or less, more preferably 0.5% by mass or less, and even more preferably 0.3% by mass or less when the nonvolatile component of the resin composition is 100% by mass.

When the resin composition of the present invention contains (H) the dispersant, the content of the component (H) is preferably 1% by mass or more, more preferably 2% by mass or more, and even more preferably 2.5% by mass or more, and is preferably 5% by mass or less, more preferably 4% by mass or less, and even more preferably 3% by mass or less when the resin component of the resin composition is 100% by mass.

In the resin composition of the present invention, the content (% by mass) of (a) the large-diameter magnetic powder is expressed as "M(a)" and the content (% by mass) of (H) the dispersant is expressed as "M(H)" relative to 100% by mass of the nonvolatile component of the resin composition. In this case, the value of the percentage of the mass ratio of (H) the dispersant to (a) the large-diameter magnetic powder contained in the resin composition ((H) the dispersant/(a) the large-diameter magnetic powder) can be expressed as "M(H)/M(a) × 100." The value of M(H)/M(a) × 100 is preferably 0.15 or more, more preferably 0.2 or more, and even more preferably 0.25 or more, and is preferably 0.5 or less, more preferably 0.4 or less, and even more preferably 0.35 or less or 0.33 or less. When the value of M(H)/M(a) × 100 is within the above range, the specific magnetic permeability can be effectively improved in the low-frequency band, and furthermore, the appearance of the resin composition during application can be made good.

In the resin composition of the present invention, the content (% by mass) of (b) the intermediate magnetic powder is expressed as "M(b)" relative to 100% by mass of the nonvolatile component of the resin composition. In this case, the value of the percentage of the mass ratio of (H) the dispersant to (b) the intermediate magnetic powder contained in the resin composition ((H) the dispersant/(b) the intermediate magnetic powder) can be expressed as "M(H)/M(b) × 100." The value of M(H)/M(b) × 100 is preferably 0.15 or more, more preferably 0.2 or more, and even more preferably 0.23 or more, and is preferably 0.31 or less. When the value of M(H)/M(b) × 100 is within the above range, the specific magnetic permeability can be effectively improved in the low-frequency band, and furthermore, the appearance of the resin composition during application can be made good.

In the resin composition of the present invention, the content (% by mass) of (c) the small-diameter magnetic powder is expressed as "M(c)" relative to 100% by mass of the nonvolatile component of the resin composition. In this case, the value of the percentage of the mass ratio of (H) the dispersant to (c) the small-diameter magnetic powder contained in the resin composition ((H) the dispersant/(c) the small-diameter magnetic powder) can be expressed as "M(H)/M(c) × 100." The value of M(H)/M(c) × 100 is preferably 0.5 or more, more preferably 0.6 or more, and even more preferably 0.7 or more, and is preferably 5 or less, more preferably 3 or less, and even more preferably 2 or less or 1.9 or less. When the value of M(H)/M(c) × 100 is within the above range, the specific magnetic permeability can be effectively improved in the low-frequency band, and furthermore, the appearance of the resin composition during application can be made good.

In the resin composition of the present invention, the value of the percentage of the mass ratio of (H) the dispersant to the total amount of (a) the large-diameter magnetic powder, (b) the intermediate magnetic powder, and (c) the small-diameter magnetic powder contained in the resin composition ((H) the dispersant/((a) the large-diameter magnetic powder + (b) the intermediate magnetic powder + (c) the small-diameter magnetic powder)) can be expressed as "M(H)/(M(a) + M(b) + M(c)) × 100." The value of M(H)/(M(a) + M(b) + M(c)) × 100 is preferably 0.05 or more, more preferably 0.1 or more, and even more preferably 0.11 or more, and is preferably 0.2 or less, more preferably 0.15 or less, and even more preferably 0.13 or less. When the value of M(H)/(M(a) + M(b) + M(c)) × 100 is within the above range, the specific magnetic permeability can be effectively improved in the low-frequency band, and furthermore, the appearance of the resin composition during application can be made good.

### (I) Optional Additive according to First Embodiment

The resin composition according to the first embodiment of the present invention may further contain (I) an optional additive in combination with the components described above. Examples of (I) the optional additive include radical polymerization initiators such as peroxide type radical polymerization initiators and azo type radical polymerization initiators; organic fillers such as rubber particles; organometallic compounds such as organocopper compounds and organozinc compounds; polymerization inhibitors such as hydroquinone, catechol, pyrogallol, and phenothiazine; leveling agents such as silicone type leveling agents and acrylic polymer type leveling agents; thickening agents such as Bentone and montmorillonite; defoaming agents such as silicone type defoaming agents, acrylic defoaming agents, fluorine type defoaming agents, and vinyl resin type defoaming agents; UV absorbers such as benzotriazole type UV absorbers; adhesion improvers such as urea silane; adhesion imparting agents such as triazole type adhesion imparting agents, tetrazole type adhesion imparting agents, and triazine type adhesion imparting agents; antioxidants such as hindered phenol type antioxidants and hindered amine type antioxidants; fluorescent brighteners such as stilbene derivatives; surfactants such as fluorine type surfactants and silicone type surfactants; flame retardants such as phosphorus type flame retardants (for example, phosphate compounds, phosphazene compounds, phosphinic acid compounds, and red phosphorus), nitrogen type flame retardants (for example, melamine sulfate), halogen type flame retardants, and inorganic flame retardants (for example, antimony trioxide); and stabilizers such as borate type stabilizers, titanate type stabilizers, aluminate type stabilizers, zirconate type stabilizers, isocyanate type stabilizers, carboxylic acid type stabilizers, and carboxylic acid anhydride type stabilizers. As to (I) the optional additive, one may be used alone or two or more may be used in combination.

### (J) Solvent according to First Embodiment

The resin composition according to the first embodiment of the present invention may further contain an optional (J) solvent as a volatile component in addition to the nonvolatile component such as the magnetic powders comprising the components (a) to (c) and the components (D) to (I) described above.

As (J) the solvent, organic solvents are normally used. The organic solvents are preferably ones that can dissolve the resin component contained in the nonvolatile component. Examples of the organic solvents include ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethylene glycol; ether ester type solvents such as 2-ethoxyethyl acetate, propylene glycol monomethyl ether acetate, diethylene glycol monoethyl ether acetate, ethyl diglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propylene glycol monomethyl ether, and diethylene glycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. As to (J) the solvent, one may be used alone or two or more may be used in combination at any ratio.

In the resin composition of the present invention, the amount of (J) the solvent is preferably small when the resin composition is made as a paste. The content of (J) the solvent may be, for example, 5% by mass or less relative to 100% by mass of the entire component in the resin composition. When the content (% by mass) of (J) the solvent contained in the resin composition is small, the generation of voids due to the volatilization of (J) the solvent can be inhibited, and furthermore, the handleability and workability of the resin composition can be improved.

### Characteristics of Resin Composition according to First Embodiment

The resin composition according to the first embodiment of the present invention can be cured by heat. Thus, the cured product of the resin composition can be obtained by thermally curing the resin composition. Generally, among the components contained in the resin composition, volatile components such as (J) the solvent may be volatilized by heat during thermal curing, but nonvolatile components such as the magnetic powders comprising the components (a) to (c) and the components (D) to (I) are not volatilized by heat during thermal curing. Thus, the cured product of the resin composition may contain the nonvolatile components of the resin composition or reaction products thereof.

The resin composition according to the first embodiment of the present invention can produce a cured product with improved specific magnetic permeability. Specifically, the cured product of this resin composition can have a high specific magnetic permeability in the low-frequency band (e.g., 10 MHz).

In an example, when the specific magnetic permeability of the cured product of the resin composition of the present invention is measured at a measurement frequency of 10 MHz and a room temperature of 23°C, the range of the specific magnetic permeability is preferably 39 or more, more preferably 39.5 or more, and even more preferably 40 or more, 41 or more, 42 or more, 43 or more, 44 or more, 45 or more, or 46 or more. There is no particular restriction on the upper limit thereof, which may be, for example, 80 or less, 75 or less, or 70 or less. The specific magnetic permeability of the cured product of the resin composition can be measured by the method described in "Test Example 2: Measurement and Evaluation of Specific Magnetic Permeability" in Examples below.

The resin composition according to the first embodiment of the present invention can have an excellent appearance during application. In an example, when the resin composition is applied uniformly with a doctor blade, the generation of streaks during application can be inhibited.

Although there is no particular restriction on the properties of the resin composition of the present invention, it is preferably in the form of a paste having fluidity. For example, the resin composition may be made as a pasty resin composition using a solvent. For example, the resin composition may be a pasty resin composition using a liquid thermosetting resin such as a liquid epoxy resin. When the amount of (J) the solvent in the resin composition is small, the generation of voids due to the volatilization of (J) the solvent can be inhibited, and furthermore, excellent handleability and workability can be achieved.

Taking advantage of the excellent characteristics described above, the resin composition of the present invention is preferably used as a resin composition for inductor production. For example, the resin composition described above is preferably used as a hole-filling resin composition for being filled in holes in a substrate included in a circuit board. For example, the resin composition described above is also preferably used to form a cured product layer in the circuit board. To facilitate application to these uses, the resin composition may be used in a pasty form or used in the form of a resin sheet containing a layer of the resin composition.

### Production Method of Resin Composition according to First Embodiment

The production method of the resin composition according to the first embodiment of the present invention is not limited to a particular method so long as the above configuration can be achieved. As described above, the resin composition of the present invention contains (a) the large-diameter magnetic powder, (b) the intermediate magnetic powder, and (c) the small-diameter magnetic powder, each in specific contents. The production method of the resin composition according to the first embodiment of the present invention may include mixing together a magnetic powder raw material containing (a) the large-diameter magnetic powder, a magnetic powder raw material containing (b) the intermediate magnetic powder, and a magnetic powder raw material containing (c) the small-diameter magnetic powder in order for the contents of (a) the large-diameter magnetic powder, (b) the intermediate magnetic powder, and (c) the small-diameter magnetic powder in the resin composition to be in the above specified ranges. Furthermore, the production method of the resin composition according to the first embodiment of the present invention may include mixing togther a magnetic powder raw material containing (a) the large-diameter magnetic powder and (b) the intermediate magnetic powder and a magnetic powder raw material containing (c) the small-diameter magnetic powder. Furthermore, the production method of the resin composition according to the first embodiment of the present invention may include mixing together a magnetic powder raw material containing (a) the large-diameter magnetic powder and a magnetic powder raw material containing (b) the intermediate magnetic powder and (c) the small-diameter magnetic powder. Furthermore, in the production method of the resin composition according to the first embodiment of the present invention, one magnetic powder raw material containing (a) the large-diameter magnetic powder, (b) the intermediate magnetic powder, and (c) the small-diameter magnetic powder may be used alone or a plurality of magnetic powder raw materials containing them may be used in combination. The production method of the resin composition according to the first embodiment of the present invention may include mixing part or all of the magnetic powders such as the components (a) to (c) and the components (D) to (J) described above together simultaneously or mixing those together sequentially. In the production method of the resin composition according to the first embodiment of the present invention, the temperature in the process of mixing together the components may be adjusted as appropriate. Thus, the production method of the resin composition according to the first embodiment of the present invention may include heating and/or cooling temporarily or throughout the process. In addition, the production method of the resin composition according to the first embodiment of the present invention may include stirring or shaking in the process of mixing together the components. Furthermore, the production method of the resin composition according to the first embodiment of the present invention may include defoaming under low-pressure conditions such as under a vacuum. The resin composition according to the first embodiment of the present invention may be produced by a production method of a resin composition according to a second embodiment, which will be described below.

### Outline of Production Method of Resin Composition according to Second Embodiment

The following shows an example of a production method of a resin composition that is particularly suitable for producing a resin composition containing (a) the large-diameter magnetic powder, (b) the intermediate magnetic powder, and (c) the small-diameter magnetic powder, each in specific contents.

The production method of the resin composition according to the second embodiment of the present invention (hereinafter also referred to as the "production method of the present invention") includes mixing together
(A) an iron alloy type magnetic powder having an average particle size of more than 20 µm 50 µm or less,
(B) an iron alloy type magnetic powder having an average particle size of more than 2 µm or more and 20 µm or less,
(C) an iron alloy type magnetic powder having an average particle size of 2 µm or less, and
(D) a thermosetting resin. In the following description, "(A) the iron alloy type magnetic powder having an average particle size of more than 20 µm and 50 µm or less" may be referred to as "(A) the large magnetic raw material powder." "(B) The iron alloy type magnetic powder having an average particle size of more than 2 µm and 20 µm or less" may be referred to as "(B) the intermediate magnetic raw material powder." "(C) The iron alloy type magnetic powder having an average particle size of 2 µm or less" may be referred to as "(C) the small magnetic raw material powder."

The resin composition obtained by the production method of the present invention can be cured by the thermosetting of (D) the thermosetting resin to provide a cured product. The thus obtained cured product can have a high specific magnetic permeability in the low-frequency band (e.g., 10 MHz). In addition, the resin composition obtained by the production method of the present invention can have an excellent appearance during application.

As can be seen from the range of the average particle size, (A) the large-diameter magnetic raw material powder can include (a) the large-diameter magnetic powder described in the first embodiment. (B) The intermediate magnetic raw material powder can include (b) the intermediate magnetic powder described in the first embodiment. (C) The small-diameter magnetic raw material powder can include (c) the small-diameter magnetic powder described in the first embodiment. Therefore, the inventor of the present invention infers that the mechanism by which the effect according to the present embodiment is obtained includes the action of the combination of (a) the large-diameter magnetic powder, (b) the intermediate magnetic powder, and (c) the small-diameter magnetic powder described in the first embodiment. However, the technical scope of the present invention is not limited to the mechanism described here.

### (A) Iron Alloy type Magnetic Powder having Average Particle Size of more than 20 µm and 50 µm or less according to Second Embodiment

The production method according to the second embodiment of the present invention includes mixing (A) the large-diameter magnetic raw material powder as the component (A) with (B) the intermediate magnetic raw material powder, (C) the small-diameter magnetic raw material powder, and (D) the thermosetting resin. (A) The large-diameter magnetic raw material powder is an iron alloy type magnetic powder having a specific range of average particle size.

(A) The large-diameter magnetic raw material powder is provided for mixing, for example, in the form of particles. (A) The large-diameter magnetic raw material powder may contain crystal grains in at least part of its particles, preferably contains crystal grains on the surface layer of the particles, more preferably contains crystal grains throughout the particles, and even more preferably consists only of crystal grains.

(A) The large-diameter magnetic raw material powder has an average particle size D₅₀ in the range of more than 20 µm and 50 µm or less. More specifically, the average particle size D₅₀ of (A) the large-diameter magnetic raw material powder is preferably 21 µm or more, more preferably 23 µm or more, and even more preferably 25 µm or more, and is preferably 40 µm or less. By the production method including mixing (A) the large-diameter magnetic raw material powder having such a range of average particle size D₅₀ with (B) the intermediate magnetic raw material powder, (C) the small-diameter magnetic raw material powder, and (D) the thermosetting resin, the specific magnetic permeability can be improved in the low-frequency band, and furthermore, a resin composition with an excellent appearance during application can be produced.

The average particle size D₅₀ of (A) the large-diameter magnetic raw material powder represents a volume-based median diameter. The average particle size D₅₀ of (A) the large-diameter magnetic raw material powder can be measured by laser diffraction and scattering based on Mie scattering theory. Specifically, it can be measured by creating the particle size distribution of (A) the large-diameter magnetic raw material powder on a volume basis with a laser diffraction scattering type particle size distribution analyzer and setting its median diameter as the average particle size D₅₀. As to a sample to be measured, the magnetic powder ultrasonically dispersed in water can suitably be used. As the laser diffraction scattering type particle size distribution analyzer, "MT3000II" manufactured by MicrotracBEL Corporation, "LA-960" manufactured by Horiba, Ltd., "SALD-2200" manufactured by Shimadzu Corporation, or the like can be used.

From the viewpoint of being able to better enjoy the effect of the present invention, (A) the large-diameter magnetic raw material powder preferably contains a nanocrystalline magnetic powder containing an iron alloy. The range of the nanocrystalline magnetic powder containing an iron alloy is as described in the first embodiment.

As to (A) the large-diameter magnetic raw material powder, one may be used alone or two or more may be used in combination.

(A) The large-diameter magnetic raw material powder can be produced, for example, by atomization. Specific examples of the production method of (A) the large-diameter magnetic raw material powder include the methods described in Japanese Patent Application Laid-open No. 2021-141267 and Japanese Patent Application Laid-open No. 2021-158343. For (A) the large-diameter magnetic raw material powder, commercially available products may be used. Examples of the commercially available magnetic powder containing (A) the large-diameter magnetic raw material powder include "KUAMET NC1-53um," "KUAMET NC1-75um," "KUAMET NC1 053C03," "KUAMET NC1 075C03," and "KUAMET NC2-53um" manufactured by Epson Atmix Corporation. When (A) the large-diameter magnetic raw material powder is obtained from the market, a commercially available magnetic powder may be classified and used if necessary. For example, a commercially available magnetic powder that does not have its average particle size D₅₀ in the range described above may be classified and used after appropriately adjusting the value of the average particle size D₅₀.

(A) The large-diameter magnetic raw material powder is preferably spherical. The aspect ratio of the particles of (A) the large-diameter magnetic raw material powder may be the same as the range of the aspect ratio of (a) the large-diameter magnetic powder.

The amount of (A) the large-diameter magnetic raw material powder used in the production method of the present invention is preferably 60% by volume or more, more preferably 62% by volume or more, and even more preferably 64% by volume or more or 65% by volume or more, and is preferably 75% by volume or less, more preferably 73% by volume or less, and even more preferably 71% by volume or less or 70% by volume or less when the nonvolatile component of the resin composition to be produced is 100% by volume. When the blended amount (% by volume) of (A) the large-diameter magnetic raw material powder is within the above range, the specific magnetic permeability can be effectively improved in the low-frequency band.

The amount of (A) the large-diameter magnetic raw material powder used in the production method of the present invention is preferably 60% by mass or more, more preferably 70% by mass or more, and even more preferably 75% by mass or more, and is preferably 90% by mass or less, more preferably 85% by mass or less, and even more preferably 82% by mass or less when the nonvolatile component of the resin composition to be produced is 100% by mass. When the blended amount (% by mass) of (A) the large-diameter magnetic raw material powder is within the above range, the specific magnetic permeability can be effectively improved in the low-frequency band.

The amount of (A) the large-diameter magnetic raw material powder used in the production method of the present invention is preferably 70% by volume or more, more preferably 75% by volume or more, and even more preferably 78% by volume or more, and is preferably 90% by volume or less, more preferably 87% by volume or less, and even more preferably 85% by volume or less when the entire magnetic powder to be mixed for the production of the resin composition is 100% by volume. When the amount (% by volume) of (A) the large-diameter magnetic raw material powder in the entire magnetic powder is within the above range, the specific magnetic permeability can be effectively improved in the low-frequency band.

The amount of (A) the large-diameter magnetic raw material powder used in the production method of the present invention is preferably 70% by mass or more, more preferably 75% by mass or more, and even more preferably 78% by mass or more, and is preferably 90% by mass or less, more preferably 87% by mass or less, and even more preferably 85% by mass or less when the entire magnetic powder to be mixed for the production of the resin composition is 100% by mass. When the amount (% by mass) of (A) the large-diameter magnetic raw material powder in the entire magnetic powder is within the above range, the specific magnetic permeability can be effectively improved in the low-frequency band.

### (B) Iron Alloy type Magnetic Powder having Average Particle Size of more than 2 µm and 20 µm or less according to Second Embodiment

The production method according to the second embodiment of the present invention includes mixing (B) the intermediate magnetic raw material powder as the component (B) with (A) the large-diameter magnetic raw material powder, (C) the small-diameter magnetic raw material powder, and (D) the thermosetting resin. (B) The intermediate magnetic raw material powder is an iron alloy type magnetic powder having a specific range of average particle size. (B) The intermediate magnetic raw material powder is provided for mixing, for example, in the form of particles.

(B) The intermediate magnetic raw material powder has an average particle size D₅₀ in the range of more than 2 µm and 20 µm or less. More specifically, the average particle size D₅₀ of (B) the intermediate magnetic raw material powder is preferably 2.1 µm or more, more preferably 2.2 µm or more, and even more preferably 2.3 µm or more, and is preferably 19 µm or less, more preferably 18 µm or less, and even more preferably 17 µm or less. By the production method including mixing (B) the intermediate magnetic raw material powder having such a range of average particle size D₅₀ with (A) the large-diameter magnetic raw material powder, (C) the small-diameter magnetic raw material powder, and (D) the thermosetting resin, the specific magnetic permeability can be improved in the low-frequency band, and furthermore, a resin composition with an excellent appearance during application can be produced. The average particle size D₅₀ of (B) the intermediate magnetic raw material powder represents a volume-based median diameter, and can be measured by the same method as for the average particle size D₅₀ of (A) the large-diameter magnetic raw material powder.

(B) The intermediate magnetic raw material powder is preferably at least one iron alloy type magnetic powder selected from a nanocrystalline magnetic powder containing an iron alloy, a Ni-containing iron alloy type magnetic powder, a polycrystalline magnetic powder, and an amorphous magnetic powder. The ranges of the nanocrystalline magnetic powder containing an iron alloy, the Ni-containing iron alloy type magnetic powder, the polycrystalline magnetic powder, and the amorphous magnetic powder are as described each in the first embodiment.

As to (B) the intermediate magnetic raw material powder, one may be used alone or two or more may be used in combination.

For (B) the intermediate magnetic raw material powder, commercially available products may be used. Examples of the commercially available magnetic powder containing (B) the intermediate magnetic raw material powder include "KUAMET NC1-V1-38um," "ATFINE-NC1 PF3FA," "ATFINE-NC1 PF5FA," "ATFINE-NC1 PF10FA," "ATFINE-NC1 PF3FC124A," "ATFINE-NC1 PF5FC124A," and "ATFINE-NC1 PF10FC124A" manufactured by Epson Atmix Corporation (nanocrystalline magnetic powders); AKT-PB-3Si(3) and AKT-PB(5) manufactured by Mitsubishi Steel Mfg. Co., Ltd. and "50%FE-50%NI PF-5F", "50%FE-50%NI PF-10F", and "50%FE-50%NI PF-20F" manufactured by Epson Atmix Corporation (Ni-containing iron alloy type magnetic powders); "EA-SMP-10 PF3K," "EA-SMP-10 PF5F", and "EA-SMP-10 PF10F" manufactured by Epson Atmix Corporation (polycrystalline magnetic powders); and "AW02-08 PF3F," "AW02-08 PF5F," "AW02-08 PF8F," and "AW02-08 PF10F" manufactured by Epson Atmix Corporation (amorphous magnetic powders). When (B) the intermediate magnetic raw material powder is obtained from the market, a commercially available magnetic powder may be classified and used if necessary. For example, a commercially available magnetic powder that does not have its average particle size D₅₀ in the range described above may be classified and used after appropriately adjusting the value of the average particle size D₅₀.

(B) The intermediate magnetic raw material powder is preferably spherical. The range of the aspect ratio of the particles of (B) the intermediate magnetic raw material powder may be the same as the range of the aspect ratio of (b) the intermediate magnetic powder.

The amount of (B) the intermediate magnetic raw material powder used in the production method of the present invention is preferably 1% by volume or more, more preferably 2% by volume or more, and even more preferably 3% by volume or more, and is preferably 20% by volume or less, more preferably 16% by volume or less, and even more preferably 13% by volume or less when the nonvolatile component of the resin composition to be produced is 100% by volume. When the blended amount (% by volume) of (B) the intermediate magnetic raw material powder is within the above range, the specific magnetic permeability can be effectively improved in the low-frequency band, and furthermore, a resin composition with an excellent appearance during application can be produced.

The amount of (B) the intermediate magnetic raw material powder used in the production method of the present invention is preferably 1% by mass or more, more preferably 3% by mass or more, and even more preferably 4% by mass or more, and is preferably 20% by mass or less, more preferably 17% by mass or less, and even more preferably 15% by mass or less when the nonvolatile component of the resin composition to be produced is 100% by mass. When the blended amount (% by mass) of (B) the intermediate magnetic raw material powder is within the above range, the specific magnetic permeability can be effectively improved in the low-frequency band, and furthermore, a resin composition with an excellent appearance during application can be produced.

The amount of (B) the intermediate magnetic raw material powder used in the production method of the present invention is preferably 1% by volume or more, more preferably 3% by volume or more, and even more preferably 4% by volume or more, and is preferably 20% by volume or less, more preferably 17% by volume percent or less, and even more preferably 15% by volume or less when the entire magnetic powder to be mixed for the production of the resin composition is 100% by volume. When the amount (% by volume) of (B) the intermediate magnetic raw material powder in the entire magnetic powder is within the above range, the specific magnetic permeability can be effectively improved in the low-frequency band, and furthermore, a resin composition with an excellent appearance during application can be produced.

The amount of (B) the intermediate magnetic raw material powder used in the production method of the present invention is preferably 1% by mass or more, more preferably 3% by mass or more, and even more preferably 4% by mass or more, and is preferably 20% by mass or less, more preferably 17% by mass or less, and even more preferably 15% by mass or less relative to 100% by mass of the entire amount of the magnetic powder to be mixed for the production of the resin composition. When the amount (% by mass) of (B) the intermediate magnetic raw material powder in the entire magnetic powder is within the above range, the specific magnetic permeability can be effectively improved in the low-frequency band, and furthermore, a resin composition with an excellent appearance during application can be produced.

The amount (% by volume) of (A) the large-diameter magnetic raw material powder is expressed as "V(A)" and the amount (% by volume) of (B) the intermediate magnetic raw material powder is expressed as "V(B)" relative to 100% by volume of the nonvolatile component of the resin composition. In this case, the volume ratio between (A) the large-diameter magnetic raw material powder and (B) the intermediate magnetic raw material powder ((A) the large-diameter magnetic raw material powder/(B) the intermediate magnetic raw material powder) can be expressed as "V(A)/V(B)." This volume ratio V(A)/V(B) is preferably 1 or more, more preferably 3 or more, and even more preferably 5 or more, and is preferably 25 or less, more preferably 20 or less, and even more preferably 17 or less. When the volume ratio V(A)/V(B) is within the above range, the specific magnetic permeability can be effectively improved in the low-frequency band, and furthermore, a resin composition with an excellent appearance during application can be produced.

The total amount (% by volume) of (A) the large-diameter magnetic raw material powder and (B) the intermediate magnetic raw material powder relative to 100% by volume of the nonvolatile components contained in the resin composition can be expressed as "V(A) + **V(B)."** This total amount (% by volume) V(A) + V(B) is preferably 70% by volume or more, more preferably 80% by volume or more, and even more preferably 84% by volume or more, and is preferably 97% by volume or less, and more preferably 95% by volume or less. When the total amount (% by volume) V(A) + V(B) is within the above range, the specific magnetic permeability can be effectively improved in the low-frequency band, and furthermore, a resin composition with an excellent appearance during application can be produced.

### (C) Iron Alloy type Magnetic Powder having Average Particle Size of 2 µm or less according to Second Embodiment

The production method according to the second embodiment of the present invention includes mixing (C) the small-diameter magnetic raw material powder as the component (C) with (A) the large-diameter magnetic raw material powder, (B) the intermediate magnetic raw material powder, and (D) the thermosetting resin. (C) The small-diameter magnetic raw material powder is an iron alloy type magnetic powder having a specific average particle size. (C) The small-diameter magnetic raw material powder is provided for mixing, for example, in the form of particles.

(C) The small-diameter magnetic raw material powder has an average particle size D₅₀ of 2 µm or less. More specifically, the average particle size D₅₀ of (C) the small-diameter magnetic raw material powder is preferably 1.9 µm or less, and more preferably 1.8 µm or less. There is not particular restriction on the lower limit of the average particle size D₅₀ of (C) the small-diameter magnetic raw material powder, which may be, for example, 0.01 µm or more or 0.1 µm or more. By the production method including mixing (C) the small-diameter magnetic raw material powder having such an average particle size D₅₀ with (A) the large-diameter magnetic raw material powder, (B) the intermediate magnetic raw material powder, and (D) the thermosetting resin, the specific magnetic permeability can be improved in the low-frequency band, and furthermore, a resin composition with an excellent appearance during application can be produced. The average particle size D₅₀ of (C) the small-diameter magnetic raw material powder represents a volume-based median diameter, and can be measured by the same method as for the average particle size D₅₀ of (A) the large-diameter magnetic raw material powder.

The range of the iron alloy forming the component (C) is the same as the range of the iron alloy forming (c) the small-diameter magnetic powder according to the first embodiment, including its suitable range.

As to (C) the small-diameter magnetic raw material powder, one may be used alone or two or more may be used in combination.

For (C) the small-diameter magnetic raw material powder, commercially available products may be used. Examples of the commercially available magnetic powder containing (C) the small-diameter magnetic raw material powder include "G00129R" and "CVD iron powder (0.7 µm)" manufactured by JFE Mineral & Alloy Company, Ltd. When (C) the small-diameter magnetic raw material powder is obtained from the market, a commercially available magnetic powder may be classified and used, if necessary. For example, a commercially available magnetic powder that does not have its average particle size D₅₀ in the range described above may be classified and used after appropriately adjusting the value of the average particle size D₅₀.

(C) The small-diameter magnetic raw material powder is preferably spherical. The range of the aspect ratio of the particles of (C) the small-diameter magnetic raw material powder may be the same as the range of the aspect ratio of (c) the small-diameter magnetic powder.

The amount of (C) the small-diameter magnetic raw material powder used in the production method of the present invention is preferably 1% by volume or more, more preferably 2% by volume or more, and even more preferably 3% by volume or more, and is preferably 20% by volume or less, more preferably 16% by volume or less, and even more preferably 13% by volume or less when the nonvolatile component of the resin composition to be produced is 100% by volume. When the blended amount (% by volume) of (C) the small-diameter magnetic raw material powder is within the above range, the specific magnetic permeability can be effectively improved in the low-frequency band, and furthermore, a resin composition with an excellent appearance during application can be produced.

The amount of (C) the small-diameter magnetic raw material powder used in the production method of the present invention is preferably 1% by mass or more, more preferably 3% by mass or more, and even more preferably 4% by mass or more, and is preferably 20% by mass or less, more preferably 17% by mass or less, and even more preferably 15% by mass or less when the nonvolatile component of the resin composition to be produced is 100% by mass. When the blended amount (% by mass) of (C) the small-diameter magnetic raw material powder is within the above range, the specific magnetic permeability can be effectively improved in the low-frequency band, and furthermore, a resin composition with an excellent appearance during application can be produced.

The amount of (C) the small-diameter magnetic raw material powder used in the production method is preferably 1% by volume or more, more preferably 3% by volume or more, and even more preferably 4% by volume or more, and is preferably 20% by volume or less, more preferably 18% by volume or less, and even more preferably 16% by volume or less when the entire magnetic powder to be mixed for the production of the resin composition is 100% by volume. When the amount (% by volume) of (C) the small-diameter magnetic raw material powder in the entire magnetic powder is within the above range, the specific magnetic permeability can be effectively improved in the low-frequency band, and furthermore, a resin composition with an excellent appearance during application can be produced.

The amount of (C) the small-diameter magnetic raw material powder used in the production method of the present invention is preferably 1% by mass or more, more preferably 3% by mass or more, and even more preferably 4% by mass or more, and is preferably 20% by mass or less, more preferably 18% by mass or less, and even more preferably 16% by mass or less relative to 100% by mass of the entire amount of the magnetic powder to be mixed for the production of the resin composition. When the amount (% by mass) of (C) the small-diameter magnetic raw material powder in the entire magnetic powder is within the above range, the specific magnetic permeability can be effectively improved in the low-frequency band, and furthermore, a resin composition with an excellent appearance during application can be produced.

The amount (% by volume) of (C) the small-diameter magnetic raw material powder is expressed as "V(C)" relative to 100% by volume of the nonvolatile component of the resin composition. In this case, the volume ratio between (A) the large-diameter magnetic raw material powder and (C) the small-diameter magnetic raw material powder ((A) the large-diameter magnetic raw material powder/(C) the small-diameter magnetic raw material powder) can be expressed as "V(A)/V(C)." This volume ratio V(A)/V(C) is preferably 1 or more, more preferably 3 or more, and even more preferably 4 or more, and is preferably 25 or less, more preferably 20 or less, and even more preferably 17 or less. When the volume ratio V(A)/V(C) is within the above range, the specific magnetic permeability can be effectively improved in the low-frequency band, and furthermore, a resin composition with an excellent appearance during application can be produced.

The total amount (% by volume) of (A) the large-diameter magnetic raw material powder and (C) the small-diameter magnetic raw material powder relative to 100% by volume of the nonvolatile components contained in the resin composition can be expressed as "V(A) + V(C)." This total amount (% by volume) V(A) + V(C) is preferably 70% by volume or more, more preferably 80% by volume or more, and even more preferably 84% by volume or more, and is preferably 97% by volume or less, and more preferably 96% by volume or less. When the total amount (% by volume) V(A) + V(C) is within the above range, the specific magnetic permeability can be effectively improved in the low-frequency band, and furthermore, a resin composition with an excellent appearance during application can be produced.

### (D) Thermosetting Resin according to Second Embodiment

The production method according to the second embodiment of the present invention includes mixing (D) the thermosetting resin as the component (D) with (A) the large-diameter magnetic raw material powder, (B) the intermediate magnetic raw material powder, and (C) the small-diameter magnetic raw material powder. As (D) the thermosetting resin according to the second embodiment, the same one as (D) the thermosetting resin according to the first embodiment may be used. The range of the amount of (D) the thermosetting resin used in the production method according to the second embodiment may be the same range as that described in the first embodiment. Therefore, in the production method according to the second embodiment, the ranges of the amount of (D-1) the epoxy resin, the amount of (D-2) the curing agent, and the amount of (D) the thermosetting resin may be the same as the ranges described each in the first embodiment. (D) The thermosetting resin according to the second embodiment can produce the same effect as that by (D) the thermosetting resin described in the first embodiment.

### (E) The Other Magnetic Raw Material Powder according to Second Embodiment

The production method according to the second embodiment of the present invention may further mix a magnetic raw material powder other than the components (A) to (C) (hereinafter also referred to as "(E) the other magnetic raw material powder" or the "component **(E)")** as an optional component in combination with the components (A) to (D) described above.

As (E) the other magnetic raw material powder, particles of a material having a specific magnetic permeability of greater than 1 may be used. The material of (E) the other magnetic raw material powder is, for example, an inorganic material and may be a soft magnetic material or a hard magnetic material. As to the material of (E) the other magnetic raw material powder, one may be used alone or two or more may be used in combination. Thus, (E) the other magnetic raw material powder may be a soft magnetic powder, a hard magnetic powder, or a combination of the soft magnetic powder and the hard magnetic powder. As to (E) the other magnetic raw material powder, one may be used alone or two or more may be used in combination. In particular, (E) the other magnetic raw material powder preferably contains the soft magnetic powder and more preferably contains only the soft magnetic powder.

Examples of (E) the other magnetic raw material powder include magnetic metal oxide powders and magnetic metallic powders. The ranges of the magnetic metal oxide powders and the magnetic metallic powders are as described above.

When (E) the other magnetic raw material powder is mixed in the production method of the present invention, the amount of the component (E) is preferably adjusted such that the components (A) to (C) meet the amount ranges described above.

The amount of the component (E) used in the production method of the present invention may be 0% by volume or more than 0% by volume, is preferably 0.1% by volume or more, more preferably 1% by volume or more, even more preferably 3% by volume or more, and is preferably 25% by volume or less, more preferably 15% by volume or less, and even more preferably 10% by volume or less relative to 100% by volume of the nonvolatile component of the resin composition to be produced.

The amount of the component (E) used in the production method of the present invention may be 0% by mass or more than 0% by mass, is preferably 0.1% by mass or more, more preferably 1% by mass or more, and even more preferably 3% by mass or more, and is preferably 25% by mass or less, more preferably 15% by mass or less, and even more preferably 10% by mass or less when the nonvolatile component of the resin composition to be produced is 100% by mass.

### (F) Thermoplastic Resin According to Second Embodiment

The production method according to the second embodiment of the present invention may further mix (F) a thermoplastic resin as an optional component in combination with the components (A) to (E) described above. As (F) the thermoplastic resin according to the second embodiment, the same one as (F) the thermoplastic resin according to the first embodiment may be used. The range of the amount of (F) the thermoplastic resin used in the production method according to the second embodiment may be the same range as that described in the first embodiment. (F) The thermoplastic resin according to the second embodiment can produce the same effect as that by (F) the thermoplastic resin described in the first embodiment.

### (G) Curing Accelerator according to Second Embodiment

The production method according to the second embodiment of the present invention may further mix (G) a curing accelerator as an optional component in combination with the components (A) to (F) described above. As (G) the curing accelerator according to the second embodiment, the same one as (G) the curing accelerator according to the first embodiment may be used. The range of the amount of (G) the curing accelerator used in the production method according to the second embodiment may be the same range as that described in the first embodiment. (G) The curing accelerator according to the second embodiment can produce the same effect as that by (G) the curing accelerator described in the first embodiment.

### (H) Dispersant according to Second Embodiment

The production method according to the second embodiment of the present invention may further mix (H) a dispersant as an optional component in combination with the components (A) to (G) described above. As (H) the dispersant according to the second embodiment, the same one as (H) the dispersant according to the first embodiment may be used. The range of the amount of (H) the dispersant used in the production method according to the second embodiment may be the same range as that described in the first embodiment. (H) The dispersant according to the second embodiment can produce the same effect as that by (H) the dispersant described in the first embodiment.

In the production method of the present invention, the blended amount (% by mass) of (A) the large-diameter magnetic raw material powder is expressed as "M(A)" and the blended amount (% by mass) of (H) the dispersant is expressed as **"M(H)"** relative to 100% by mass of the nonvolatile component of the resin composition to be produced. In this case, the value of the percentage of the mass ratio of (H) the dispersant to (A) the large-diameter magnetic raw material powder ((H) the dispersant/(A) the large-diameter magnetic raw material powder) can be expressed as "M(H)/M(A) × 100." The value of M(H)/M(A) × 100 is preferably 0.1 or more, more preferably 0.11 or more, and even more preferably 0.12 or more, and is preferably 0.17 or less, more preferably 0.15 or less, and even more preferably 0.14 or less. When the value of M(H)/M(A) × 100 is within the above range, the specific magnetic permeability can be effectively improved in the low-frequency band.

In the production method of the present invention, the blended amount (% by mass) of (B) the intermediate magnetic raw material powder is expressed as "M(B)" relative to 100% by mass of the nonvolatile component of the resin composition to be produced. In this case, the value of the percentage of the mass ratio of (H) the dispersant to (B) the intermediate magnetic raw material powder ((H) the dispersant/(B) the intermediate magnetic raw material powder) can be expressed as "M(H)/M(B) × 100." The value of M(H)/M(B) × 100 is preferably 0.5 or more, more preferably 0.6 or more, and even more preferably 0.7 or more, and is preferably 5 or less, more preferably 3.5 or less, and even more preferably 2.5 or less or 2.3 or less. When the value of M(H)/M(B) × 100 is within the above range, the specific magnetic permeability can be effectively improved in the low-frequency band, and furthermore, a resin composition with an excellent appearance during application can be produced.

In the production method of the present invention, the blended amount (% by mass) of (C) the small-diameter magnetic raw material powder is expressed as "M(C)" relative to 100% by mass of the nonvolatile component of the resin composition to be produced. In this case, the value of the percentage of the mass ratio of (H) the dispersant to (C) the small-diameter magnetic raw material powder ((H) the dispersant/(C) the small-diameter magnetic raw material powder) can be expressed as "M(H)/M(C) × 100." The value of M(H)/M(C) × 100 is preferably 0.5 or more, more preferably 0.6 or more, and even more preferably 0.7 or more, and is preferably 5 or less, more preferably 3.5 or less, and even more preferably 2.5 or less or 2.3 or less. When the value of M(H)/M(C) × 100 is within the above range, the specific magnetic permeability can be effectively improved in the low-frequency band, and furthermore, a resin composition with an excellent appearance during application can be produced.

In the production method of the present invention, the value of the percentage of the mass ratio of (H) the dispersant to the total amount of (A) the large-diameter magnetic raw material powder, (B) the intermediate magnetic raw material powder, and (C) the small-diameter magnetic raw material powder ((H) the dispersant/((A) the large-diameter magnetic raw material powder + (B) the intermediate magnetic raw material powder + (C) the small-diameter magnetic raw material powder)) can be expressed as "M(H)/(M(A) + M(B) + M(C)) × 100." The value of M(H)/(M(A) + M(B) + M(C)) × 100 is preferably 0.05 or more, more preferably 0.08 or more, and even more preferably 0.1 or more, and is preferably 0.13 or less, more preferably 0.12 or less, and even more preferably 0.11 or less. When the value of M(H)/(M(A) + M(B) + M(C)) × 100 is within the above range, the specific magnetic permeability can be effectively improved in the low-frequency band, and furthermore, a resin composition with an excellent appearance during application can be produced.

### (I) Optional Additive according to Second Embodiment

The production method according to the second embodiment of the present invention may further mix (I) an optional additive as an optional component in combination with the components (A) to (H) described above. As (I) the optional additive according to the second embodiment, the same one as (I) the optional additive according to the first embodiment may be used.

### (J) Solvent according to Second Embodiment

The production method according to the second embodiment of the present invention may further mix (J) a solvent as an optional component in combination with the components (A) to (I) described above. As (J) the solvent according to the second embodiment, the same one as (J) the solvent according to the first embodiment may be used. The range of the amount of (J) the solvent used in the production method according to the second embodiment may be the same range as that described in the first embodiment.

### Operation of Production Method according to

### Second Embodiment

The production method according to the second embodiment of the present invention includes mixing together (A) the large-diameter magnetic raw material powder, (B) the intermediate magnetic raw material powder, (C) the small-diameter magnetic raw material powder, and (D) the thermosetting resin described above. If necessary, the production method according to the second embodiment of the present invention may include mixing part or all of the optional components such as (E) the other raw material magnetic powder, (F) the thermoplastic resin, (G) the curing accelerator, (H) the dispersant, (I) the optional additive, and (J) the solvent in combination with (A) the large-diameter magnetic raw material powder, (B) the intermediate magnetic raw material powder, (C) the small-diameter magnetic raw material powder, and (D) the thermosetting resin.

The production method according to the second embodiment of the present invention may include mixing part or all of the components together simultaneously or mixing those together sequentially. In the production method according to the second embodiment of the present invention, the temperature in the process of mixing together the components may be set as appropriate. Thus, the production method according to the second embodiment of the present invention may include heating and/or cooling temporarily or throughout the process. In addition, the production method according to the second embodiment of the present invention may include stirring or shaking in the process of mixing together the components. Furthermore, the production method according to the second embodiment of the present invention may include defoaming under low-pressure conditions such as under a vacuum.

Resin Composition Produced by Production Method according to Second Embodiment

A resin composition produced by the production method according to the second embodiment of the present invention may contain the above components mixed together. Therefore, the produced resin composition contains (A) the large-diameter magnetic raw material powder, (B) the intermediate magnetic raw material powder, (C) the small-diameter magnetic raw material powder, and (D) the thermosetting resin, and may further, if necessary, contain (E) the other raw material magnetic powder, (F) the thermoplastic resin, (G) the curing accelerator, (H) the dispersant, (I) the optional additive, and (J) the solvent. Therefore, the ranges of the amounts of (A) the large-diameter magnetic raw material powder, (B) the intermediate magnetic raw material powder, (C) the small-diameter magnetic raw material powder, (D) the thermosetting resin, (E) the other raw material magnetic powder, (F) the thermoplastic resin, (G) the curing accelerator, (H) the dispersant, (I) the optional additive, and (J) the solvent contained in the resin composition may be as described above. The resin composition according to the first embodiment may be produced by the production method according to the second embodiment of the present invention.

The resin composition obtained by the production method according to the second embodiment of the present invention is curable by heat. Thus, the cured product of the resin composition can be obtained by thermally curing the resin composition. In general, among the components contained in the resin composition, volatile components such as (J) the solvent may be volatilized by heat during thermal curing, but nonvolatile components such as the components (A) to (I) are not volatilized by heat during thermal curing. Thus, the produced cured product of the resin composition may contain the nonvolatile components of the resin composition or reaction products thereof.

The resin composition obtained by the production method according to the second embodiment of the present invention can produce a cured product with improved specific magnetic permeability. Specifically, the cured product of this resin composition can have a high specific magnetic permeability in the low-frequency band (e.g., 10 MHz).

In an example, when the specific magnetic permeability of the produced cured product of the resin composition is measured at a measurement frequency of 10 MHz and a room temperature of 23°C, the range of the specific magnetic permeability is preferably 39 or more, more preferably 39.5 or more, and even more preferably 40 or more, 41 or more, 42 or more, 43 or more, 44 or more, 45 or more, or 46 or more. There is no particular restriction on the upper limit of the specific magnetic permeability, which may be, for example, 80 or less, 75 or less, or 70 or less.

The resin composition produced by the production method according to the second embodiment of the present invention can have an excellent appearance during application as with the resin composition according to the first embodiment.

Although there is no particular restriction on the properties of the resin composition produced by the production method according to the second embodiment of the present invention, the resin composition is preferably in the form of a paste having fluidity as with the resin composition according to the first embodiment.

The resin composition obtained by the production method according to the second embodiment of the present invention can achieve the same advantages as those of the resin composition according to the first embodiment. The resin composition produced by the production method according to the second embodiment of the present invention may be used for the same applications as those of the resin composition according to the first embodiment, for example.

### Magnetic Paste according to Third Embodiment

The magnetic paste according to a third embodiment of the present invention includes at least one of the resin composition according to the first embodiment and the resin composition produced by the production method according to the second embodiment. The magnetic paste is generally a fluid paste containing the resin composition and may preferably be used for filling holes by printing. This magnetic paste may contain only the resin composition described above or contain any components in combination with the resin composition. Preferably, the pasty resin composition itself can be used as the magnetic paste.

The magnetic paste is preferably pasty at 23°C. The viscosity of this magnetic paste is preferably 20 Pa·s or more, more preferably 25 Pa·s or more, even more preferably 30 Pa·s or more, and particularly preferably 50 Pa·s or more, and is preferably 200 Pa·s or less, more preferably 180 Pa·s or less, and even more preferably 160 Pa·s or less at 23°C. The viscosity can be measured, for example, using an E type viscometer ("RE-80U" manufactured by Toki Sangyo Co., Ltd., 3° × R9.7 rotor) under the measurement conditions with a measurement sample amount of 0.22 ml and a number of revolutions of 5 rpm.

### Resin Sheet according to Fourth Embodiment

The resin sheet according to a fourth embodiment of the present invention includes a support and a resin composition layer provided on the support. The resin composition layer contains the resin composition and preferably contains only the resin composition. As the resin composition, at least one of the resin composition according to the first embodiment and the resin composition obtained by the production method according to the second embodiment may be used.

The thickness of the resin composition layer is preferably 250 µm or less, and more preferably 200 µm or less from the viewpoint of thinning. The lower limit of the thickness of the resin composition layer may be, for example, 5 µm or more or 10 µm or more.

Examples of the support include films of plastic materials, metallic foils, and release papers, and one or more supports selected from the group consisting of films formed of plastic materials and metallic foils are preferred.

When a film of a plastic material is used as the support, examples of the plastic material include polyesters such as polyethylene terephthalate (hereinafter may be abbreviated as "PET"), polyethylene naphthalate (PEN), polycarbonate (PC), acrylic polymers such as polymethyl methacrylate (PMMA), cyclic polyolefins, triacetyl cellulose (TAC), polyether sulfide (PES), polyether ketone, and polyimides. Among them, one or more plastic materials selected from the group consisting of polyethylene terephthalate and polyethylene naphthalate are preferred, and polyethylene terephthalate, which is less expensive, is more preferred.

When a metal foil is used as the support, examples of the metal foil include copper foils and aluminum foils, and copper foils are preferred. As the copper foils, foils formed of copper single metal may be used or foils formed of alloys of copper and other metals (for example, tin, chromium, silver, magnesium, nickel, zirconium, silicon, and titanium) may be used.

The support may be matte treated or corona treated on its surface to be bonded to the resin composition layer.

As the support, a releasing layer-attached support having a releasing layer on the surface to be bonded to the resin composition layer may be used. Examples of the releasing agent for use in the releasing layer of the support with a releasing layer include one or more releasing agents selected from the group consisting of alkyd type releasing agents, polyolefin type releasing agents, urethane type releasing agents, and silicone type releasing agents. Examples of the commercially available product of the releasing agent include "SK-1," "AL-5," and "AL-7" manufactured by Lintec Corporation, which are alkyd resin type releasing agents. Examples of the commercially available product of the support with a releasing layer include "PET501010," "SK-1," "AL-5," and "AL-7" manufactured by Lintec Corporation; "Lumirror T60" manufactured by Toray Industries, Inc.; "Peulex" manufactured by Teijin Ltd.; and "Unipeel" manufactured by Unitika, Ltd., which are PET films having a releasing layer with an alkyd resin type releasing agent as a main component.

The thickness of the support, which is not limited to a particular thickness, is preferably in a range of 5 µm to 75 µm and more preferably in a range of 10 µm to 60 µm. When the support with a releasing layer is used, the thickness of the entire support with a releasing layer is preferably in the above range.

In the resin sheet, the surface of the resin composition layer not bonded to the support (that is, the surface opposite the support) may be provided with a protective film equivalent to the support. The thickness of the protective film, which is not limited to a particular thickness, is 1 µm to 40 µm, for example. By providing the protective film, adhesion of dust and the like to the surface of the resin composition layer and scratches thereon can be inhibited.

The resin sheet can be produced by, for example, applying the resin composition onto the support using a die coater or the like to form the resin composition layer. If necessary, an organic solvent may be mixed into the resin composition before being applied onto the support. When the organic solvent is used, drying may be performed after the application if necessary.

The drying may be performed by, for example, a method such as heating or hot air blowing. The drying conditions are not limited to particular conditions, and the drying is performed such that the content of the organic solvent in the resin composition layer becomes 10% by mass or less, and preferably 5% by mass or less. The resin composition layer can be formed by drying at 50°C to 150°C for 3 minutes to 10 minutes, which vary depending on the components contained in the resin composition.

The resin sheet can be wound in roll form and stored. When having the protective film, the resin sheet can normally be used by peeling off the protective film.

### Circuit Board according to Fifth Embodiment

The circuit board according to a fifth embodiment of the present invention includes the cured product of the resin composition. As the resin composition, at least one of the resin composition according to the first embodiment and the resin composition obtained by the production method according to the second embodiment may be used.

There is no restriction on the specific structure of the circuit board so far as the cured product of the resin composition is included therein. The circuit board according to the first example includes a substrate formed with a hole and the cured product of the resin composition filled in this hole. The circuit board according to the second example includes a cured product layer formed of the cured product of the resin composition. Hereinafter, the circuit boards according to the first example and the second example will be described.

### Circuit Board according to First Example

The circuit board according to the first example includes a substrate formed with a hole and a cured product of the resin composition filled in the hole. This circuit board can be produced by a production method including, for example,
(1) a step of filling the hole of the substrate with the resin composition, and
(2) a step of thermally curing the resin composition to obtain the cured product. The production method of the circuit board according to the first example may further include
(3) a step of polishing the surface of the cured product or the resin composition,
(4) a step of applying a roughening treatment to the cured product, and
(5) a step of forming a conductor layer on the cured product. Usually, the steps (1) through (5) may be carried out sequentially in the order of the step (1), the step (2), the step (3), the step (4), and the step (5). The step (2) may be carried out after the step (3). In the production method of the circuit board according to the first example, it is preferable to form the cured product by using the resin composition in the form of a paste. In the explanation below, the example will be described in which a substrate formed with a through hole as the hole that goes through the substrate in the thickness direction is used.

### Step (1)

The step (1) usually includes a step of preparing a substrate formed with a through hole. The substrate may be prepared by purchasing from the market. Alternatively, the substrate may be prepared by producing it using a suitable material. Hereinafter, the production method of the substrate according to one example will be described.

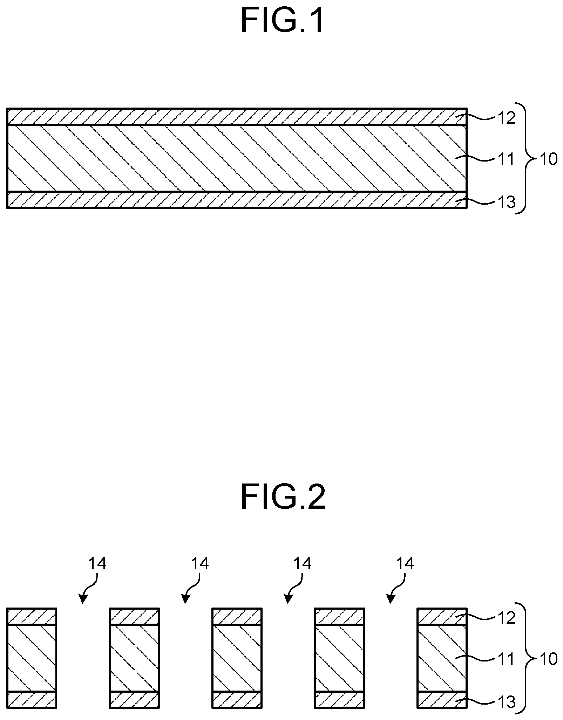

Fig. 1 is a schematic cross sectional view illustrating a core substrate 10 that is prepared in the production method of the circuit board according to the first example of one embodiment of the present invention. The step of preparing the substrate may include a step of preparing the core substrate 10, as illustrated in Fig. 1. The core substrate 10 usually includes a supporting substrate 11. Illustrative examples of the supporting substrate 11 may include insulating substrates such as a glass epoxy substrate, a metal substrate, a polyester substrate, a polyimide substrate, a BT resin substrate, and a thermosetting type polyphenylene ether substrate. On the supporting substrate 11, a metal layer may be formed. The metal layer may be formed on one surface of the supporting substrate 11, or on both surfaces of the substrate. Here, the example is illustrated in which a metal layer 12 and a metal layer 13 are formed on both the surfaces of the supporting substrate 11. The metal layers 12 and 13 each may be, for example, a layer formed of a metal such as copper. The metal layers 12 and 13 may be, for example, copper foil such as carrier-attached copper foil, or a metal layer formed of a material of the conductor layer to be described later.

Fig. 2 is a schematic cross sectional view illustrating the core substrate 10 formed with a through hole 14 in the production method of the circuit board according to the first example of one embodiment of the present invention. The step of preparing the substrate may include a step of forming the through hole 14 in the core substrate 10, as an example illustrated in Fig. 2. The through hole 14 can be formed, for example, by drilling, laser irradiation, or plasma irradiation. Usually, the through hole 14 can be formed by forming a penetrating hole that goes through the core substrate 10. In a specific example, formation of the through hole 14 can be performed by using a drilling machine that is commercially available. Illustrative examples of the commercially available drilling machine may include "ND-1S211" manufactured by Hitachi Via Mechanics, Ltd.

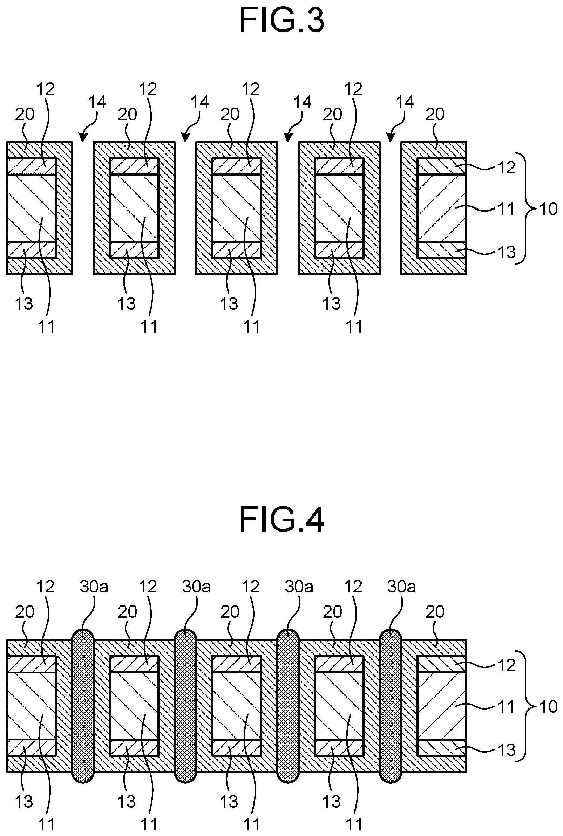

Fig. 3 is a schematic cross sectional view illustrating the core substrate 10 formed with a plated layer 20 in the through hole 14 in the production method of the circuit board according to the first example of one embodiment of the present invention. The step of preparing the substrate may include, after the core substrate 10 is subjected to the roughening treatment as needed, a step of forming the plated layer 20 as illustrated in Fig. 3. The roughening treatment may be performed with any of a dry roughening treatment and a wet roughening treatment. Illustrative examples of the dry roughening treatment may include a plasma treatment. Illustrative examples of the wet roughening treatment may include a method in which a swelling treatment by a swelling liquid, a roughening treatment by an oxidant, and a neutralizing treatment by a neutralizing solution are performed in this order. The plated layer 20 may be formed by a plating method. The procedure to form the plated layer 20 by the plating method may be the same as the procedure in formation of the conductor layer at the step (5) to be described later. Here, the explanation will be made as to the example in which the plated layer 20 is formed inside the through hole 14, on the surface of the metal layer 12, and on the surface of the metal layer 13.

Fig. 4 is a schematic cross sectional view illustrating the state of filling the through hole of the core substrate 10 with a resin composition 30a in the production method of the circuit board according to the first example of one embodiment of the present invention. The step (1) includes, after the core substrate 10 formed with the through hole 14 is prepared, filling the through hole 14 in the core substrate 10 with the resin composition 30a, as illustrated in Fig. **4****.** The filling may be performed, for example, by a printing method. Illustrative examples of the printing method may include a method in which the resin composition 30a is printed to the through hole 14 via a squeegee, a method in which the resin composition 30a is printed via a cartridge, a method in which the resin composition 30a is printed by a mask printing, a roll coating method, and an inkjet method.

### Step (2)

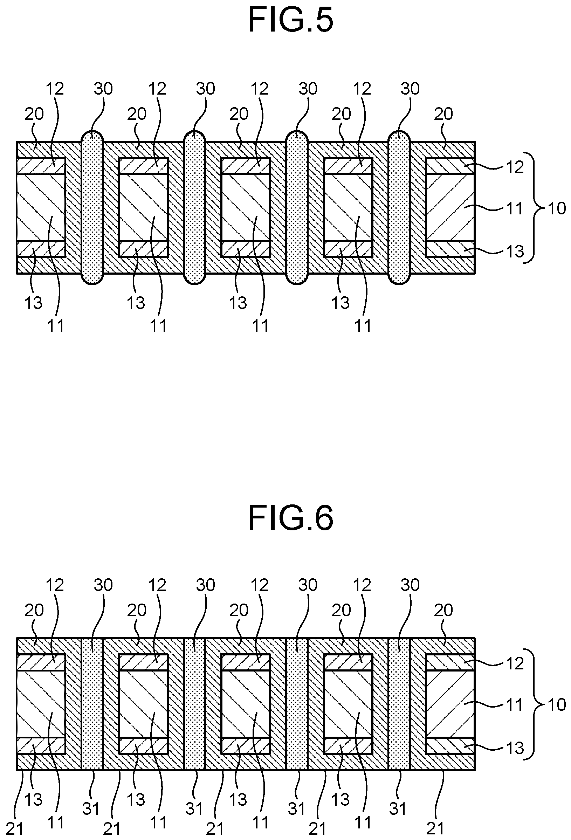

Fig. 5 is a schematic cross sectional view to explain the step (2) in the production method of the circuit board according to the first example of one embodiment of the present invention. The step (2) includes, after filling the through hole 14 with the resin composition 30a, curing the resin composition 30a to form a cured product 30, as illustrated in Fig. 5.

Curing of the resin composition 30a is usually performed by a thermal curing. The condition of the thermal curing of the resin composition 30a may be set as appropriate so far as curing of the resin composition 30a proceeds. The curing temperature is preferably 120°C or higher, more preferably 130°C or higher, and even more preferably 150°C or higher, and is preferably 245°C or lower, more preferably 220°C or lower, and even more preferably 200°C or lower. The curing time is preferably 5 minutes or longer, more preferably 10 minutes or longer, and even more preferably 15 minutes or longer, and is preferably 120 minutes or shorter, more preferably 110 minutes or shorter, and even more preferably 100 minutes or shorter.

The curing degree of the cured product 30 that is obtained at the step (2) is preferably 80% or more, more preferably 85% or more, and even more preferably 90% or more. The curing degree can be measured by using, for example, a differential scanning calorimeter.

The production method of the circuit board according to the first example may include, after filling the through hole 14 with the resin composition 30a and before curing the resin composition 30a, a step of heating the resin composition 30a at a temperature lower than the curing temperature (preliminary heating step). For example, prior to curing the resin composition 30a, the resin composition 30a may be preliminarily heated at a temperature of usually 50°C or higher and lower than 120°C (preferably 60°C or higher and 110°C or lower, more preferably 70°C or higher and 100°C or lower), usually for 5 minutes or longer (preferably for 5 minutes to 150 minutes, more preferably for 15 minutes to 120 minutes).

### Step (3)

Fig. 6 is a schematic cross sectional view to explain the step (3) in the production method of the circuit board according to the first example of one embodiment of the present invention. When the through-hole 14 is filled with the resin composition 30a in the step (1), an excess of the resin composition 30a may protrude to or adhere with the outside the through-hole 14. Therefore, the resin composition 30a may be present not only inside the through hole 14 but also outside the through hole 14. The step (3) includes polishing the excess of the cured product 30 protruding from or adhering to the core substrate 10, as illustrated in Fig. **6****.** The excess of the cured product 30 is removed by polishing, so that the surface of the cured product 30 can be flattened. A surface (polished surface) 31 of the cured product 30 that has been flattened by polishing may usually form a plane that is flush with a surrounding surface 21 of the polished surface 31 **(e.g.,** the surface of the core substrate 10 and the surface of the plated layer 20).

As for the polishing method of the cured product 30, the method with which the excess of the cured product 30 protruding from or adhering to the core substrate 10 can be removed may be used. Illustrative examples of the polishing method as described above may include a buff polishing method, a belt polishing method, and a ceramic polishing method. Illustrative examples of the buff polishing equipment that is commercially available may include "NT-700IM" manufactured by Ishiihyoki **Co.,** Ltd.

From the viewpoint of enhancing the adhesion with the conductor layer, the arithmetic average roughness (Ra) of the polished surface (surface after curing) 31 of the cured product 30 is preferably 300 nm or more, more preferably 350 nm or more, and even more preferably 400 nm or more. The upper limit of the arithmetic average roughness (Ra) of the polished surface (surface after curing) 31 of the cured product 30 is preferably 1,000 nm or less, more preferably 900 nm or less, and even more preferably 800 nm or less. The arithmetic average roughness (Ra) can be measured, for example, by using a non-contact type surface roughness meter.

The production method of the circuit board according to the first example may include, after the step (3), a step of subjecting the cured product 30 to a heat-treatment in order to further increase the curing degree of the cured product **30.** As for the temperature at this heat treatment, the aforementioned curing temperature may be applied. Specific heat treatment temperature is preferably 120°C or higher, more preferably 130°C or higher, and even more preferably 150°C or higher, and is preferably 245°C or lower, more preferably 220°C or lower, and even more preferably 200°C or lower. The heat treatment period is preferably 5 minutes or longer, more preferably 10 minutes or longer, and even more preferably 15 minutes or longer, and is preferably 90 minutes or shorter, more preferably 70 minutes or shorter, and even more preferably 60 minutes or shorter.

In the case where the step (3) is carried out before the step (2), a preliminary heating treatment may be carried out to heat the resin composition at a temperature lower than the curing temperature of the resin composition before the step (3). The temperature at the preliminary heating treatment is preferably 100°C or higher, more preferably 110°C or higher, and even more preferably 120°C or higher, and is preferably 245°C or lower, more preferably 220°C or lower, and even more preferably 200°C or lower. The heat treatment period is preferably 5 minutes or longer, more preferably 10 minutes or longer, and even more preferably 15 minutes or longer, and is preferably 90 minutes or shorter, more preferably 70 minutes or shorter, and even more preferably 60 minutes or shorter.

### Step (4)

The step (4) includes subjecting the cured product 30 to the roughening treatment (desmear treatment). With the roughening treatment, the surface of the cured product 30 is roughened. When the surface of the cured product 30 has been polished, this step usually includes subjecting the polished surface 31 to the roughening treatment (desmear treatment). There is no particular restriction on the procedure and condition of the roughening treatment; for example, the procedure and condition that are used in the production method of a multilayer printed wiring board may be used. In a specific example, the roughening treatment to the cured product 30 may be performed by conducting the method including a swelling treatment with a swelling liquid, a roughening treatment with an oxidant, and a neutralizing treatment with a neutralizing solution in this order.

Illustrative examples of the swelling liquid that may be used in the swelling treatment may include an alkaline solution and a surfactant solution; here, the alkaline solution is preferable. As for the alkaline solution as the swelling liquid, a sodium hydroxide solution and a potassium hydroxide solution are more preferable. Illustrative examples of the swelling liquid that is commercially available may include "Swelling Dip Securiganth P" and "Swelling Dip Securiganth SBU", which are both manufactured by Atotech Japan Co., Ltd.

The swelling treatment with the swelling liquid can be carried out, for example, by immersing the cured product 30 into the swelling liquid at the temperature of 30°C to 90°C for the period of 1 minute to 20 minutes. From the viewpoint of suppressing the swelling of the resin included in the cured product 30 to a suitable level, it is preferable that the cured product 30 is immersed into the swelling liquid at the temperature of 40°C to 80°C for the period of 5 minutes to 15 minutes.

Illustrative examples of the oxidant that may be used in the roughening treatment with the oxidant may include an alkaline permanganate solution having potassium permanganate or sodium permanganate dissolved into a sodium hydroxide aqueous solution. The roughening treatment using the oxidant such as the alkaline permanganate solution is preferably carried out by immersing the cured product 30 into the oxidant solution heated at 60°C to 80°C for the period of 10 minutes to 30 minutes. The concentration of the permanganate salt in the alkaline permanganate solution is preferably in the range of 5% by mass to 10% by mass. Illustrative examples of the oxidant that is commercially available may include alkaline permanganate solutions such as "Concentrate Compact **P"** and "Dosing Solution Securiganth P", both of which are manufactured by Atotech Japan, **Co.,** Ltd.

The neutralizing solution that may be used in the neutralizing treatment is preferably an acidic aqueous solution. A commercially available neutralizing solution is, for example, "Reduction Solution Securiganth **P"** manufactured by Atotech Japan **Co.,** Ltd. The neutralizing treatment with the neutralizing solution can be carried out by immersing the treated surface, which has been subjected to the roughening treatment using the oxidant solution, into the neutralizing solution in the temperature range of 30°C to 80°C for the period of 5 minutes to 30 minutes. From the viewpoint of workability, it is preferable to immerse the cured product 30, which has been subjected to the roughening treatment using the oxidant solution, into the neutralizing solution in the temperature range of 40°C to 70°C for the period of 5 minutes to 20 minutes.

From the viewpoint of improving the adhesion with a conductor layer, the arithmetic average roughness (Ra) of the surface of the cured product 30 after the roughening treatment is preferably 300 nm or more, more preferably 350 nm or more, and even more preferably 400 nm or more. The upper limit of the arithmetic average roughness (Ra) of the surface of the cured product 30 after the roughening treatment is preferably 1,500 nm or less, more preferably 1,200 nm or less, and even more preferably 1,000 nm or less. The arithmetic average roughness (Ra) can be measured, for example, by using a non-contact type surface roughness meter.

### Step (5)

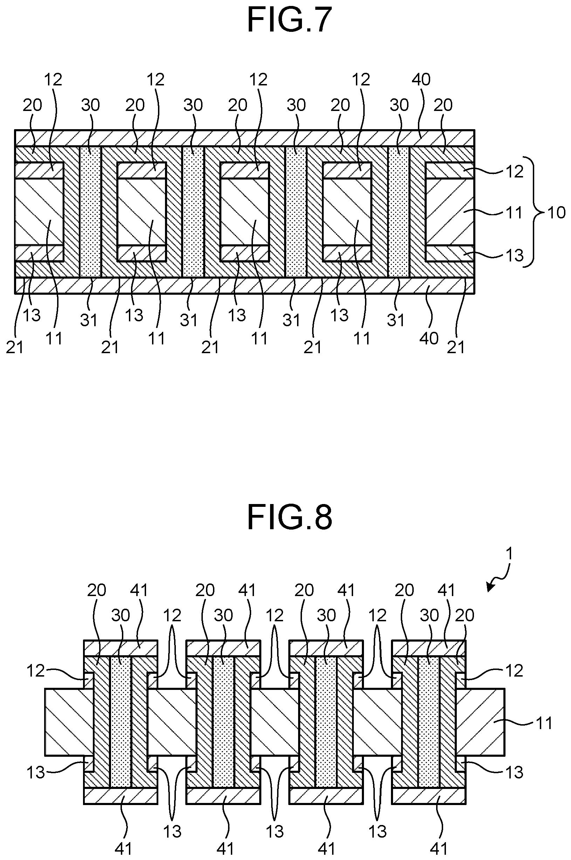

Fig. 7 is a schematic cross sectional view to explain the step (5) in the production method of the circuit board according to the first example of one embodiment of the present invention. The step (5) includes forming a conductor layer 40 on the polished surface 31 of the cured product 30, as illustrated in Fig. 7. Here, the example is illustrated in which the conductor layer 40 is formed not only on the polished surface 31 of the cured product 30 but also on the surrounding surface 21 (for example, the surface of the core substrate 10 and the surface of the plated layer 20). In Fig. 7, the example that the conductor layer 40 is formed on both sides of the core substrate 10 is illustrated; but the conductor layer 40 may be formed on only one side of the core substrate 10.

Fig. 8 is a schematic cross sectional view to explain the step (5) in the production method of the circuit board according to the first example of one embodiment of the present invention. As illustrated in Fig. 8, after the conductor layer 40 is formed, the step (5) may include removing part of the conductor layer 40, the metal layer 12, the metal layer 13, and the plated layer 20 to form a patterned conductor layer 41 by a treatment such as etching.

Illustrative examples of the method for forming the conductor layer 40 may include a plating method, a sputtering method, and a vapor deposition method. Among these, a plating method is preferable. In a preferable embodiment, the surface of the cured product 30 (and the plated layer 20) is plated with a suitable method such as a semi-additive method or a full additive method, so that the patterned conductor layer 41 having an intended wiring pattern may be formed. Illustrative examples of the material of the conductor layer 40 may include: single metals such as gold, platinum, palladium, silver, copper, aluminum, cobalt, chromium, zinc, nickel, titanium, tungsten, iron, tin, and indium; and alloys of two or more metals selected from the group consisting of gold, platinum, palladium, silver, copper, aluminum, cobalt, chromium, zinc, nickel, titanium, tungsten, iron, tin, and indium. Among these, from the viewpoints of general applicability, cost, easiness in patterning, and the like, preferably usable are chromium, nickel, titanium, aluminum, zinc, gold, palladium, silver, and copper, as well as a nickel-chromium alloy, a copper-nickel alloy, and a copper-titanium alloy. More preferable are chromium, nickel, titanium, aluminum, zinc, gold, palladium, silver, and copper, as well as a nickel-chromium alloy. Copper is even more preferably used.

Here, the example of the method for forming the patterned conductor layer 41 on the polished surface 31 of the cured product 30 will be explained in detail. A plating seed layer is formed on the polished surface 31 of the cured product 30 by an electroless plating. Next, on the resulting plating seed layer, an electroplated layer is formed by an electroplating. Then, as needed, an unnecessary plating seed layer is removed by a treatment such as etching, so that the patterned conductor layer 41 having an intended wiring pattern can be formed. After the patterned conductor layer 41 is formed, in order to improve the adhesion strength of the patterned conductor layer 41, an annealing treatment may be performed as needed. The annealing treatment can be performed, for example, by heating in the temperature range of 150°C to 200°C for the period of 20 minutes to 90 minutes.

From the viewpoint of thinning, the thickness of the patterned conductor layer 41 is preferably 70 µm or less, more preferably 60 µm or less, even more preferably 50 µm or less, still even more preferably 40 µm or less, and especially preferably 30 µm or less, 20 µm or less, 15 µm or less, or 10 µm or less. The lower limit thereof is preferably 1 µm or more, more preferably 3 µm or more, and even more preferably 5 µm or more.

By the method described above, a circuit board 1 including the cured product 30 of the resin composition 30a can be produced.

### Circuit Board according to Second Example

The circuit board according to a second example includes a cured product layer including the cured product of the resin composition. Preferably, the cured product layer includes only the cured product of the resin composition. It is preferable that the cured product layer is formed by using a resin sheet. This circuit board can be produced by a production method including, for example,
(i) a step of forming a cured product layer on an inner layer substrate,
(ii) a step of forming a hole in the cured product layer,
(iii) a step of subjecting the surface of the cured product layer to a roughening treatment, and
(iv) a step of forming a conductor layer on the surface of the cured product layer.

### Step (i)

The step (i) includes forming a cured product layer on the inner layer substrate. Preferably, the step (i) includes laminating the resin sheet onto the inner layer substrate in such a way that the resin composition layer is joined to the inner layer substrate and forming the cured product layer. For example, the resin sheet is laminated to the inner layer substrate in such a way that the resin composition layer is joined to the inner layer substrate, and then, the resin composition layer is thermally cured to form the cured product layer.

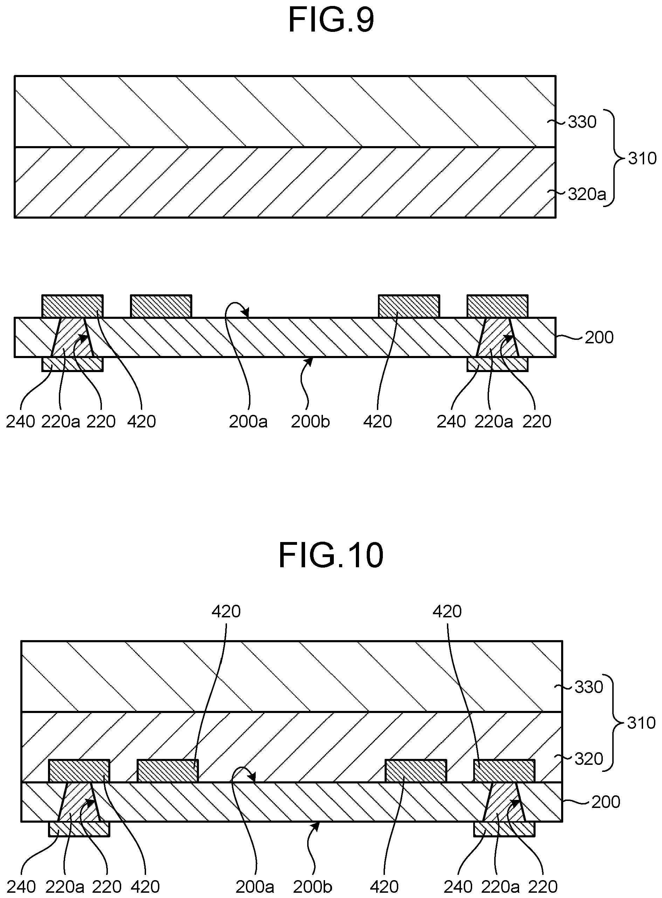

Fig. 9 is a schematic cross sectional view to explain the step (i) in the production method of the circuit board according to the second example of one embodiment of the present invention. As illustrated in Fig. **9****,** a resin sheet 310 including a support 330 and a resin composition layer 320a formed on the support 330 is prepared. Then, the resin sheet 310 and an inner layer substrate 200 are laminated such that the resin composition layer 320a is joined to the inner layer substrate 200.

An insulating substrate may be used as the inner layer substrate 200. Illustrative examples of the inner layer substrate 200 may include insulating substrates such as a glass epoxy substrate, a metal substrate, a polyester substrate, a polyimide substrate, a BT resin substrate, and a thermosetting type polyphenylene ether substrate. The inner layer substrate 200 may be an inner layer circuit board having wiring or the like incorporated in the thickness thereof.

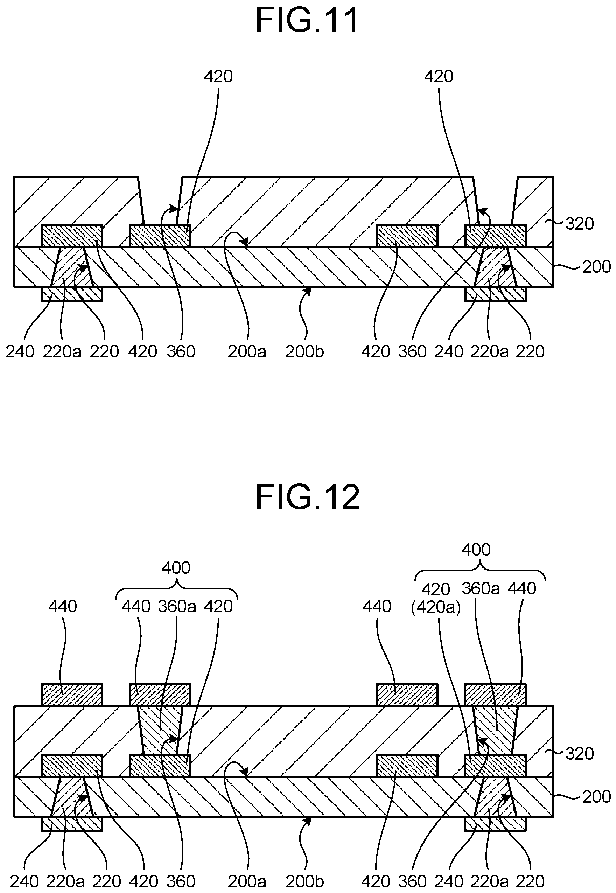

The inner layer substrate 200 illustrated in this example includes a first conductor layer 420 formed on a first main surface 200a and an external terminal 240 formed on a second main surface 200b. The first conductor layer 420 may include a plurality of wires. Note that, in the example illustrated in Fig. 9, only the wiring that constitutes a coil-shaped conductive structural body 400 (see Fig. 12) of an inductor element is illustrated. The external terminal 240 may be a terminal for electrical connection to an external device or the like that is not illustrated in the drawing. The external terminal 240 can be configured as part of a conductor layer formed on the second main surface 200b.

The conductor material that can constitute the first conductor layer 420 and the external terminal 240 may be, for example, the same as the material of the conductor layer described in the first example.

The first conductor layer 420 and the external terminal 240 may have any of a monolayer structure and a multi-layer structure in which two or more layers formed of single-metal layers or alloy layers formed of different metals or alloys are laminated. The thicknesses of the first conductor layer 420 and of the external terminal 240 may be the same as that of a second conductor layer 440 to be described later.

The line and space (L/S) of the first conductor layer 420 and of the external terminal 240 is not particularly restricted. From the viewpoint of reducing a surface irregularity thereby obtaining the cured product layer having an excellent smoothness, the ratio is usually 900 µm/900 µm or less, preferably 700 µm/700 µm or less, more preferably 500 µm/500 µm or less, even more preferably 300 µm/300 µm or less, and further even more preferably 200 µm/200 µm or less. There is no particular restriction on the lower limit of the line and space (L/S); but from the viewpoint of enhancing an embedding property of the resin composition layer into the space, the lower limit thereof is preferably 1 µm/1 µm or more.

The inner layer substrate 200 may have a plurality of through holes 220 that go through the inner layer substrate 200 from the first main surface 200a to the second main surface 200b. In the through hole 220, an inside-the-through-hole wiring 220a is formed. The inside-the-through-hole wiring 220a electrically connects the first conductor layer 420 and the external terminal 240 to each other.

Bonding of the resin composition layer 320a to the inner layer substrate 200 can be performed, for example, by hot-pressing of the resin sheet 310 to the inner layer substrate 200 by pressing from the side of the support 330. Illustrative examples of the member (hereinafter, this member may be referred to as "hot-pressing member") used for the hot-pressing of the resin sheet 310 to the inner layer substrate 200 may include a heated metal plate (e.g., stainless steel (SUS) mirror plate) and a metal roll (SUS roll). Here, it is preferable that the hot-pressing member is not pressed in direct contact with the resin sheet 310 but is pressed via an sheet or the like formed of an elastic material such as a heat-resistant rubber in such a way that the resin sheet 310 can well follow the irregularity on the surface of the inner layer substrate 200.

The temperature at the time of the hot-pressing is preferably 80°C to 160°C, more preferably 90°C to 140°C, and even more preferably 100°C and 120°C. The pressure at the time of the hot-pressing is preferably 0.098 MPa to 1.77 MPa, and more preferably 0.29 MPa to 1.47 MPa. The period at the time of the hot-pressing is preferably 20 seconds to 400 seconds, and more preferably 30 seconds to 300 seconds. It is preferable that the bonding of the resin sheet to the inner layer substrate is performed under the condition of a reduced pressure of 26.7 hPa or less.

Bonding of the resin composition layer 320a of the resin sheet 310 to the inner layer substrate 200 can be performed by using a commercially available vacuum laminator. Illustrative examples of the commercially available vacuum laminator may include a vacuum pressing laminator manufactured by Meiki Co., Ltd. and a vacuum applicator manufactured by Nikko-Materials Co., Ltd.

After the bonding of the resin sheet 310 to the inner layer substrate 200, the resin sheet 310 thereby laminated may be subjected to, for example, a flattening treatment by pressing the hot-pressing member from the side of the support 330 under a normal pressure (under an atmospheric pressure). The pressing conditions in the flattening treatment may be the same as the hot-pressing conditions in the aforementioned lamination. The flattening treatment can be performed by a commercially available laminator. The lamination and the flattening treatments may be carried out continuously by using the commercially available vacuum laminator described above.

Fig. 10 is a schematic cross sectional view to explain the step (i) in the production method of the circuit board according to the second example of one embodiment of the present invention. After the resin sheet 310 is laminated onto the inner layer substrate 200, the resin composition layer 320a is cured to form the cured product layer. In this example, as illustrated in Fig. 10, the resin composition layer 320a that has been joined to the inner layer substrate 200 is thermally cured to form a first cured product layer 320.

Conditions of the thermal curing of the resin composition layer 320a may be set as appropriate so far as curing of the resin composition proceeds. The curing temperature is preferably 120°C or higher, more preferably 130°C or higher, and even more preferably 150°C or higher, and is preferably 245°C or lower, more preferably 220°C or lower, and even more preferably 200°C or lower. The curing time is preferably 5 minutes or longer, more preferably 10 minutes or longer, and even more preferably 15 minutes or longer, and is preferably 120 minutes or shorter, more preferably 110 minutes or shorter, and even more preferably 100 minutes or shorter.

The support 330 may be removed between after the thermal curing at the step (i) and the step (ii), or it may be removed after the step (ii).

From the viewpoint of enhancing the adhesion with the plating, the arithmetic average roughness (Ra) of the cured product layer before the roughening treatment is preferably 300 nm or more, more preferably 350 nm or more, and even more preferably 400 nm or more. The upper limit of the arithmetic average roughness (Ra) of the cured product layer before the roughening treatment is preferably 1,000 nm or less, more preferably 900 nm or less, and even more preferably 800 nm or less. The arithmetic average roughness (Ra) can be measured, for example, by using a non-contact type surface roughness meter.

At the step (i), instead of the resin sheet, the resin composition may be applied onto the inner layer substrate 200 using a die coater or the like followed by the thermal cure to form the cured product layer.

### Step (ii)

Fig. 11 is a schematic cross sectional view to explain the step (ii) in the production method of the circuit board according to the second example of one embodiment of the present invention. The step (ii) includes forming a hole in the first cured product layer 320 to form a via hole 360, as illustrated in Fig. 11. The via hole 360 forms a channel for electrically connecting the first conductor layer 420 and the second conductor layer 440 to be described later. Formation of the via hole 360 may be performed using, for example, drilling, a laser, or a plasma. The size and shape of the hole may be determined as appropriate in accordance with the design of the circuit board.

### Step (iii)

At the step (iii), the surface of the cured product layer in which the via hole is formed is subjected to a roughening treatment. The roughening treatment at the step (iii) may be performed in the same way as described at the step (4) of the first example.

From the viewpoint of improving the adhesion with the plating, the arithmetic average roughness (Ra) of the cured product layer after the roughening treatment is preferably 300 nm or more, more preferably 350 nm or more, and even more preferably 400 nm or more. The upper limit of the arithmetic average roughness (Ra) of the cured product layer after the roughening treatment is preferably 1,500 nm or less, more preferably 1,200 nm or less, and even more preferably 1,000 nm or less. The arithmetic average roughness (Ra) can be measured, for example, by using a non-contact type surface roughness meter.

### Step (iv)

Fig. 12 is a schematic cross sectional view to explain the step (iv) in the production method of the circuit board according to the second example of one embodiment of the present invention. As illustrated in Fig. 12, at the step (iv), the second conductor layer 440 is formed on the first cured product layer 320.

The conductor material that can constitute the second conductor layer 440 may be, for example, the same as the material of the conductor layer described in the first example.

From the viewpoint of thinning, the thickness of the second conductor layer 440 is preferably 70 µm or less, more preferably 60 µm or less, even more preferably 50 um or less, still even more preferably 40 µm or less, and particularly preferably 30 µm or less, 20 µm or less, 15 µm or less, or 10 µm or less. The lower limit of the thickness of the second conductor layer 440 is preferably 1 µm or more, more preferably 3 µm or more, and even more preferably 5 µm or more.

The second conductor layer 440 can be formed by plating. For example, the second conductor layer 440 is preferably formed by wet plating methods such as a semi-additive method that includes an electroless plating step, a mask patterning step, an electrolytic plating step, and a flash etching step, and a full-additive method. By forming the second conductor layer 440 by the wet plating method, the second conductor layer 440 having an intended wiring pattern can be formed. At this step, an inside-the-via-hole wiring 360a is also formed in the via hole 360.

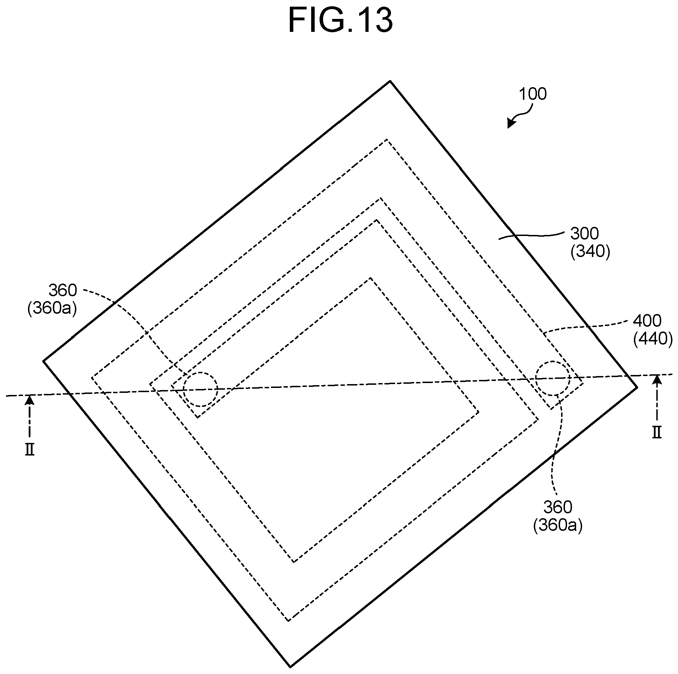

The first conductor layer 420 and the second conductor layer 440 may be formed in a spiral form, for example, as illustrated in Figs. 13 to 15 to be described later as one example. In one example, one end of the central side of the spiral wiring portion of the second conductor layer 440 is electrically connected thorough the inside-the-via-hole wiring 360a to one end of the central side of the spiral wiring portion of the first conductor layer 420. The other end of the outer circumferential side of the spiral wiring portion of the second conductor layer 440 is electrically connected through the inside-the-via-hole wiring 360a to a land 420a of the first conductor layer 420. Therefore, the other end of the outer circumferential side of the spiral wiring portion of the second conductor layer 440 is electrically connected to the external terminal 240 via the inside-the-via-hole wiring 360a, the land 420a, and the inside-the-through-hole wiring 220a.

The coil-shaped conductive structural body 400 is composed of a spiral wiring portion that is a portion of the first conductor layer 420, a spiral wiring portion that is a portion of the second conductor layer 440, and the inside-the-via-hole wiring 360a that electrically connects the spiral wiring portion of the first conductor layer 420 with the spiral wiring portion of the second conductor layer 440.

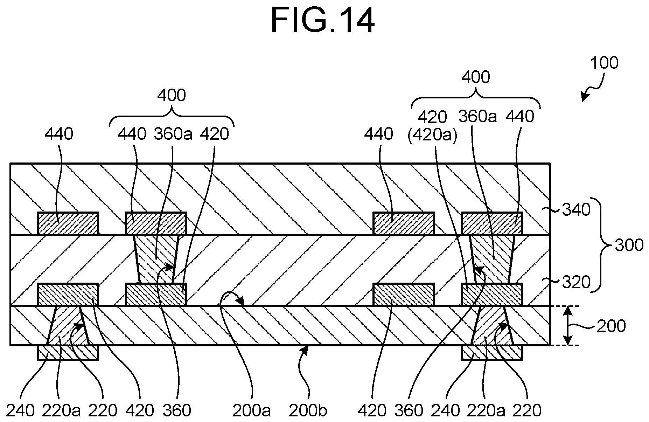

After the step (iv), a step of further forming the cured product layer on the conductor layer may be carried out. As illustrated in detail in Fig. 14 as one example, the second cured product layer 340 is formed on the second conductor layer 440 and the first cured product layer 320 in which the inside-the-via-hole wiring 360a is formed. The second cured product layer may be formed with the same step as the step that has already been described. By the method described above, a circuit board 100 including the first cured product layer 320 and the second cured product layer 340 formed of the cured product of the resin composition may can produced.

### Inductor Substrate according to Sixth Embodiment

The inductor substrate according to a sixth embodiment of the present invention includes the circuit board according to the fifth embodiment described above. When the inductor substrate includes the circuit board according to the first example described above, the inductor substrate may have an inductor pattern formed by a conductor at least partially around the cured product of the resin composition. In this case, the inductor substrate may include an inductor element that is composed of an inductor pattern which is formed, for example, by at least part of a first metal layer 12, a second metal layer 13, the plated layer 20, and the patterned conductor layer 41, and a core portion formed of the cured product 30 surrounded by the inductor pattern. As for the inductor substrate, the one that is described in Japanese Patent Application Laid-open No. 2016-197624 may be used, for example.

When the inductor substrate includes the circuit board obtained by the production method of the circuit board according to the second example, the inductor substrate may have the cured product layer and the conductive structural body having at least part thereof embedded in the cured product layer. The inductor substrate may include the inductor element composed of the conductive structural body and part of the cured product layer that extends in the thickness direction of the cured product layer and is surrounded by the conductive structural body.

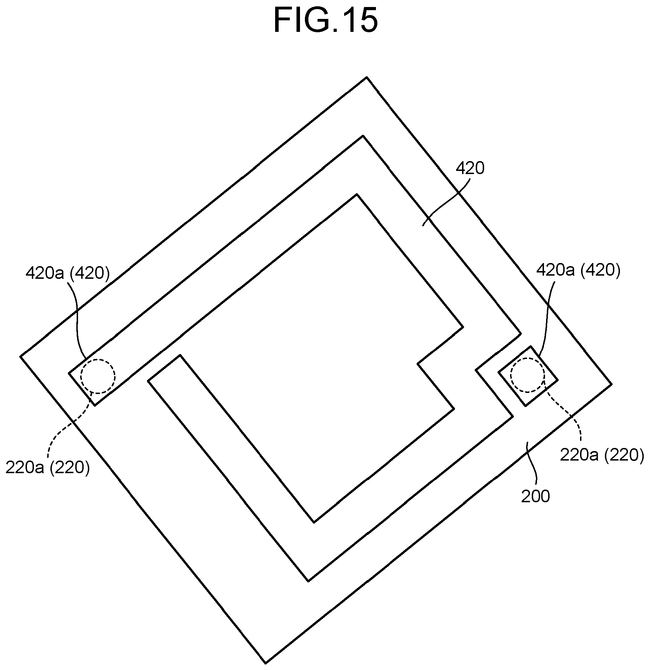

Fig. 13 is a schematic plan view of the circuit board 100 possessed by the inductor substrate, observed from one side in the thickness directions thereof. Fig. 14 is a schematic view illustrating the cut end face of the circuit board 100 cut at the position indicated by the II-II single-dotted line in Fig. 13. Fig. 15 is a schematic plan view to explain the composition of the first conductor layer 420 of the circuit board 100 included in the inductor substrate.

The circuit board 100 may be a substrate having a plurality of the cured product layers (the first cured product layer 320 and the second cured product layer 340) and a plurality of the conductor layers (the first conductor layer 420 and the second conductor layer 440), as illustrated in Fig. 13 and Fig. 14 as one example. Thus, in the example illustrated here, the circuit board 100 may be a build-up wiring board having a build-up cured product layer and a build-up conductor layer. The circuit board 100 has the inner layer substrate 200.

As illustrated in Fig. 14, the first cured product layer 320 and the second cured product layer 340 constitute the magnetic portion 300, which may be considered as an integral cured product layer. Therefore, the coil-shaped conductive structural body 400 is formed such that at least part thereof is embedded in the magnetic portion 300. In other words, in the circuit board 100 illustrated in this example, the inductor element is composed of the coil-shaped conductive structural body 400 and the core portion, which is part of the magnetic portion 300 that extends to the thickness direction of the magnetic portion 300 and is surrounded by the coil-shaped conductive structural body 400.

As illustrated in Fig. 15 as one example, the first conductor layer 420 includes a spiral wiring portion to constitute the coil-shaped conductive structural body 400 and the rectangular land 420a that is electrically connected to the inside-the-through-hole wiring 220a. In the example illustrated here, the spiral wiring portion includes straight portions, bending portions that bend at right angles, and a detour portion that detours the land 420a. The spiral wiring portion of the first conductor layer 420 has an overall outline of a substantially rectangular shape and has the shape that the wiring portion is whirled in a counterclockwise direction from the center side to the outer side thereof.

Similarly, the second conductor layer 440 is formed on the first cured product layer 320. The second conductor layer 440 includes the spiral wiring portion to form the coil-shaped conductive structural body 400. In Fig. 13 or Fig. 14, the spiral wiring portion includes the straight portions and the bending portions that bend at right angles. In Fig. 13 or Fig. 14, the spiral wiring portion of the second conductor layer 440 has an overall outline of a substantially rectangular shape and has the shape that the wiring portion is whirled in a clockwise direction from the center side to the outer side thereof.

The inductor substrate described above may be used as the wiring board to mount an electronic part such as a semiconductor chip, and may also be used as a (multilayered) printed wiring board that uses this wiring board as the inner layer substrate. In addition, the inductor substrate may be used as a chip inductor component obtained by dicing the wiring board, and may also be used as a printed wiring board that is surface-mounted with the chip inductor component.

By using this wiring board, semiconductor devices with various embodiments can be produced. The semiconductor device including the wiring board can be suitably used in electric products (for example, a computer, a mobile phone, a digital camera, and a television), vehicles (for example, a motor bike, an automobile, a train, a marine ship, and an airplane), and so forth.

### Examples

The present invention will be specifically described below with reference to examples. However, the present invention is not limited to these examples. In the following description, "%" and "parts" representing amounts mean "% by mass" and "parts by mass," respectively, unless otherwise indicated. The temperature condition and the pressure condition when there was no special specification were room temperature (23°C) and atmospheric pressure (1 atm).

### (A) Iron Alloy type Magnetic Powder having Average Particle Size of more than 20 µm

· "KUAMET NC1-53um" manufactured by Epson Atmix Corporation, a nanocrystalline magnetic powder containing an Fe-Si-Nb-B type alloy, average particle size (D₅₀): 27 µm, true density: 7.2 g/cm³, the volume ratio of particles with a particle size of 2 µm or less in the present magnetic powder: 0 vol%, the volume ratio of particles with a particle size of more than 2 µm and 20 µm or less in this magnetic powder: 37.9 vol%, and the volume ratio of particles with a particle size of more than 20 µm in the present magnetic powder: 62.1 vol%.
· "KUAMET NC1-75um" manufactured by Epson Atmix Corporation, a nanocrystalline magnetic powder containing an Fe-Si-Nb-B type alloy, average particle size (D₅₀): 35 µm, true density: 7.2 g/cm³, the volume ratio of particles with a particle size of 2 µm or less in the present magnetic powder: 0 vol%, the volume ratio of particles with a particle size of more than 2 µm and 20 µm or less in the present magnetic powder: 5.8 vol%, and the volume ratio of particles with a particle size of more than 20 µm in the present magnetic powder: 94.2 vol%.

### (B) Iron Alloy type Magnetic Powder having Average Particle Size of more than 2 µm and 20 µm or less

· "KUAMET NC1-V1-38um" manufactured by Epson Atmix Corporation, a nanocrystalline magnetic powder containing an Fe-Si-Nb-B type alloy, average particle size (D₅₀): 16 µm, true density: 7.2 g/cm³, the volume ratio of particles with a particle size of 2 µm or less in the present magnetic powder: 0 vol%, the volume ratio of particles with a particle size of more than 2 µm and 20 µm or less in the present magnetic powder: 65 vol%, and the volume ratio of particles with a particle size of more than 20 µm in the present magnetic powder: 35 vol%.
· "AW02-08 PF3F" manufactured by Epson Atmix Corporation, an amorphous magnetic powder containing an Fe-Si-Cr type alloy, average particle size (D₅₀): 3.4 µm, true density: 7.1 g/cm³, the volume ratio of particles with a particle size of 2 µm or less in the present magnetic powder: 5.2 vol%, the volume ratio of particles with a particle size of more than 2 µm and 20 µm or less in the present magnetic powder: 94.8 vol%, and the volume ratio of particles with a particle size of more than 20 µm in the present magnetic powder: 0%.
· "AKT-PB-3Si(3)" manufactured by Mitsubishi Steel Mfg. Co., Ltd., an Fe-Ni-Si type magnetic powder, average particle size (D₅₀): 2.4 µm, true density: 8 g/cm³, the volume ratio of particles with a particle size of 2 µm or less in the present magnetic powder: 39 vol%, the volume ratio of particles with a particle size of more than 2 µm and 20 µm or less in the present magnetic powder: 61 vol%, and the volume ratio of particles with a particle size of more than 20 µm in the present magnetic powder: 0 vol%.
· "AKT-PB-(5)" manufactured by Mitsubishi Steel Mfg. Co., Ltd., an Fe-Ni type magnetic powder, average particle size (D₅₀): 5 µm, true density: 8.2 g/cm³, the volume ratio of particles with a particle size of 2 µm or less in the present magnetic powder: 21 vol%, the volume ratio of particles with a particle size of more than 2 µm and 20 µm or less in the present magnetic powder: 79 vol%, and the volume ratio of particles with a particle size of more than 20 µm in the present magnetic powder: 0 vol%.

· "50%FE-50%NI PF-5F" manufactured by Epson Atmix Corporation, an Fe-Ni type magnetic powder, average particle size (D₅₀): 4 µm, true density: 8.2 g/cm³, the volume ratio of particles with a particle size of 2 µm or less in the present magnetic powder: 4 vol%, the volume ratio of particles with a particle size of more than 2 µm and 20 µm or less in the present magnetic powder: 96 vol%, and the volume ratio of particles with a particle size of more than 20 µm in the present magnetic powder: 0 vol%.
· "EA-SMP-10 PF3K" manufactured by Epson Atmix Corporation, a polycrystalline magnetic powder containing an Fe-Si-Cr type alloy, average particle size (D₅₀): 4 µm, true density: 7.6 g/cm³, the volume ratio of particles with a particle size of 2 µm or less in the present magnetic powder: 5.3 vol%, the volume ratio of particles with a particle size of more than 2 µm and 20 µm or less in the present magnetic powder: 94.7 vol%, and the volume ratio of particles with a particle size of more than 20 µm in the present magnetic powder: 0 vol%.
· "ATFINE-NC1 PF5FA" manufactured by Epson Atmix Corporation, a nanocrystalline magnetic powder containing an Fe-Si-Nb-B type alloy, average particle size (D₅₀): 4 µm, true density: 7.2 g/cm³, the volume ratio of particles with a particle size of 2 µm or less in the present magnetic powder: 3.8 vol%, the volume ratio of particles with a particle size of more than 2 µm and 20 µm or less in the present magnetic powder: 96.2 vol%, and the volume ratio of particles with a particle size of more than 20 µm in the present magnetic powder: 0 vol%.
· "ATFINE-NC1 PF3FA" manufactured by Epson Atmix Corporation, a nanocrystalline magnetic powder containing an Fe-Si-Nb-B type alloy, average particle size (D₅₀): 3 µm, true density: 7.2 g/cm³, the volume ratio of particles with a particle size of 2 µm or less in the present magnetic powder: 4 vol%, the volume ratio of particles with a particle size of more than 2 µm and 20 µm or less in the present magnetic powder: 96 vol%, and the volume ratio of particles with a particle size of more than 20 µm in the present magnetic powder: 0 vol%.

### (C) Iron Alloy type Magnetic Powder having Average Particle Size of 2 µm or less

· "G00129R" manufactured by JFE Mineral & Alloy Company, Ltd., an Fe-Si-Cr type alloy magnetic powder, average particle size (D₅₀): 1.7 µm, true density: 7 g/cm³, the volume ratio of particles with a particle size of 2 µm or less in the present magnetic powder: 85.0 vol%, the volume ratio of particles with a particle size of more than 2 µm and 20 µm or less in the present magnetic powder: 15 vol%, and the volume ratio of particles with a particle ze of more than 20 µm in the present magnetic powder: 0 vol%.
· "CVD iron powder (0.7 µm)" manufactured by JFE Mineral & Alloy Company, Ltd., an Fe-Si-Cr type alloy magnetic powder, average particle size (D₅₀): 0.7 µm, true density: 7 g/cm³, the volume ratio of particles with a particle size of 2 µm or less in the present magnetic powder: 99 vol%, the volume ratio of particles with a particle size of more than 2 µm and 20 µm or less in the present magnetic powder: 1 vol%, and the volume ratio of particles with a particle size of more than 20 µm in the present magnetic powder: 0 vol%.

### (C') Magnetic Powder other than Iron Alloy type Magnetic Powder, having Average Particle Size of 2 µm or less

· "M001" manufactured by Powdertech Co., Ltd., a Mn type ferrite powder, average particle size (D₅₀): 0.12 µm, true density: 5 g/cm³, the volume ratio of particles with a particle size of 2 µm or less in the present magnetic powder: 97 vol%, the volume ratio of particles with a particle size of more than 2 µm and 20 µm or less in the present magnetic powder: 3 vol%, and the volume ratio of particles with a particle size of more than 20 µm in the present magnetic powder: 0 vol%.

### Example 1: Preparation of Resin Composition 1

Mixed together were 83 parts by mass of (A) an iron alloy type magnetic powder having an average particle size of more than 20 µm ("KUAMET NC1-53um" manufactured by Epson Atmix Corporation), 10.3 parts by mass of (B) an iron alloy type magnetic powder having an average particle size of more than 2 µm and 20 µm or less ("AW02-08 PF3F" manufactured by Epson Atmix Corporation), 10.3 parts by mass of (C) an iron alloy type magnetic powder having an average particle size of 2 µm or less ("CVD iron powder (0.7 µm)" manufactured by JFE Mineral & Alloy Company, Ltd.), 1.11 parts by mass of (D) a liquid epoxy resin ("ZX-1059" manufactured by NIPPON STEEL Chemical & Material Co., Ltd., a mixture of a bisphenol A type epoxy resin and a bisphenol F epoxy resin, true density: 1.2 g/cm³), 1.56 parts by mass of (D) a biphenyl skeleton phenolic curing agent ("GPH-65" manufactured by Nippon Kayaku Co., Ltd., true density: 1.2 g/cm³), 0.48 part by mass of (D) a solid epoxy resin ("HP-4700" manufactured by DIC Corporation, a naphthalene type tetrafunctional epoxy resin, true density: 1.2 g/cm³), 1.42 parts by mass of (F) a phenoxy resin ("YX7553BH30" manufactured by Mitsubishi Chemical Corporation, a solution of methyl ethyl ketone:cyclohexanone = 1:1 with a nonvolatile component of 30%, a special skeleton phenoxy resin, the true density of the nonvolatile component: 1.2 g/cm³), 0.02 part by mass of (G) a curing accelerator ("2PHZ-PW" manufactured by Shikoku Chemicals Corporation, an imidazole type curing accelerator, true density 1.2 g/cm³), 0.11 part by mass of (H) a dispersant ("PB-821" manufactured by Ajinomoto Fine-Techno Co., Inc., a cationic dispersant, true density 1.2 g/cm³), 0.11 part by mass of toluene as (J) a solvent, 2.4 parts by mass of methyl ethyl ketone (MEK) as (J) a solvent, and 0.74 part by mass of cyclohexanone (Anone) as (J) a solvent, and the mixture was uniformly dispersed with a high-speed rotary mixer to prepare a resin composition 1.

### Example 2: Preparation of Resin Composition 2

In Example 1, (H) the dispersant was changed to 0.11 part by mass of (H) a dispersant ("SC-1015F" by NOF Corporation, a polyoxyalkylene type dispersant, true density 1.2 g/cm³).

A resin composition 2 was prepared in the same manner as in Example 1 except the above matter.

### Example 3: Preparation of Resin Composition 3 In Example 1,

1) the amount of (A) the iron alloy type magnetic powder having an average particle size of more than 20 µm ("KUAMET NC1-53um" manufactured by Epson Atmix Corporation) was changed from 83 parts by mass to 87 parts by mass,
2) the amount of (B) the iron alloy type magnetic powder having an average particle size of more than 2 µm and 20 µm or less ("AW02-08 PF3F" manufactured by Epson Atmix Corporation) was changed from 10.3 parts by mass to 5.6 parts by mass, and
3) the amount of (C) the iron alloy type magnetic powder having an average particle size of 2 µm or less ("CVD iron powder (0.7 µm)" manufactured by JFE Mineral & Alloy Company, Ltd.) was changed from 10.3 parts by mass to 10.5 parts by mass.

A resin composition 3 was prepared in the same manner as in Example 1 except the above matter.

### Example 4: Preparation of Resin Composition 4

In Example 1,
1) the amount of (B) the iron alloy type magnetic powder having an average particle size of more than 2 µm and 20 µm or less ("AW02-08 PF3F" manufactured by Epson Atmix Corporation) was changed from 10.3 parts by mass to 5 parts by mass, and
2) the amount of (C) the iron alloy type magnetic powder having an average particle size of 2 µm or less ("CVD iron powder (0.7 µm)" manufactured by JFE Mineral & Alloy Company, Ltd.) was changed from 10.3 parts by mass to 15.5 parts by mass.

A resin composition 4 was prepared in the same manner as in Example 1 except the above matter.

### Example 5: Preparation of Resin Composition 5

In Example 1,
1) the amount of (B) the iron alloy type magnetic powder having an average particle size of more than 2 µm and 20 µm or less ("AW02-08 PF3F" manufactured by Epson Atmix Corporation) was changed from 10.3 parts by mass to 15.2 parts by mass, and
2) the amount of (C) the iron alloy type magnetic powder having an average particle size of 2 µm or less ("CVD iron powder (0.7 µm)" manufactured by JFE Mineral & Alloy Company, Ltd.) was changed from 10.3 parts by mass to 5.2 parts by mass.

A resin composition 5 was prepared in the same manner as in Example 1 except the above matter.

### Example 6: Preparation of Resin Composition 6

In Example 1,
1) the amount of (A) the iron alloy type magnetic powder having an average particle size of more than 20 µm ("KUAMET NC1-53um" manufactured by Epson Atmix Corporation) was changed from 83 parts by mass to 86.3 parts by mass, and
2) 10.3 parts by mass of (B) the iron alloy type magnetic powder having an average particle size of more than 2 µm and 20 µm or less ("AW02-08 PF3F" manufactured by Epson Atmix Corporation) were changed to 7.5 parts by mass of (b) another iron alloy type magnetic powder having an average particle size of more than 2 µm and 20 µm or less ("KUAMET NC1-V1-38um" manufactured by Epson Atmix Corporation).

A resin composition 6 was prepared in the same manner as in Example 1 except the above matter.

### Example 7: Preparation of Resin Composition 7

In Example 1, 10.3 parts by mass of (B) the iron alloy type magnetic powder having an average particle size of more than 2 µm and 20 µm or less ("AW02-08 PF3F" manufactured by Epson Atmix Corporation) were changed to 7.5 parts by mass of (B) another iron alloy type magnetic powder having an average particle size of more than 2 µm and 20 µm or less ("AKT-PB-3Si(3)" manufactured by Mitsubishi Steel Mfg. Co., Ltd.).

A resin composition 7 was prepared in the same manner as in Example 1 except the above matter.

### Example 8: Preparation of Resin Composition 8

In Example 1, 10.3 parts by mass of (B) the iron alloy type magnetic powder having an average particle size of more than 2 µm and 20 µm or less ("AW02-08 PF3F" manufactured by Epson Atmix Corporation) were changed to 12.2 parts by mass of (B) another iron alloy type magnetic powder having an average particle size of more than 2 µm and 20 µm or less ("AKT-PB(5)" manufactured by Mitsubishi Steel Mfg. Co., Ltd.).

A resin composition 8 was prepared in the same manner as in Example 1 except the above matter.

### Example 9: Preparation of Resin Composition 9

In Example 1, 10.3 parts by mass of (B) the iron alloy type magnetic powder having an average particle size of more than 2 µm and 20 µm or less ("AW02-08 PF3F" manufactured by Epson Atmix Corporation) were changed to 12 parts by mass (B) another iron alloy type magnetic powder having an average particle size of more than 2 µm and 20 µm or less ("50%FE-50%NI PF-5F" manufactured by Epson Atmix Corporation).

A resin composition 9 was prepared in the same manner as in Example 1 except the above matter.

### Example 10: Preparation of Resin Composition 10

In Example 1, 10.3 parts by mass of (B) the iron alloy type magnetic powder having an average particle size of more than 2 µm and 20 µm or less ("AW02-08 PF3F" manufactured by Epson Atmix Corporation) were changed to 11.4 parts by mass of (B) another iron alloy type magnetic powder having an average particle size of more than 2 µm and 20 µm or less ("EA-SMP-10 PF3K" manufactured by Epson Atmix Corporation).

A resin composition 10 was prepared in the same manner as in Example 1 except the above matter.

### Example 11: Preparation of Resin Composition 11

In Example 1, 10.3 parts by mass of (B) the iron alloy type magnetic powder having an average particle size of more than 2 µm and 20 µm or less ("AW02-08 PF3F" manufactured by Epson Atmix Corporation) were changed to 10.9 parts by mass of (B) another iron alloy type magnetic powder having an average particle size of more than 2 µm and 20 µm or less ("ATFINE-NC1 PF5FA" manufactured by Epson Atmix Corporation, average particle size (D₅₀): 4 µm).

A resin composition 11 was prepared in the same manner as in Example 1 except the above matter.

### Example 12: Preparation of Resin Composition 12

In Example 1, 10.3 parts by mass of (B) the iron alloy type magnetic powder having an average particle size of more than 2 µm and 20 µm or less ("AW02-08 PF3F" manufactured by Epson Atmix Corporation) were changed to 10.9 parts by mass of (B) another iron alloy type magnetic powder having an average particle size of more than 2 µm and 20 µm or less ("ATFINE-NC1 PF3FA" manufactured by Epson Atmix Corporation, average particle size (D₅₀): 3 µm).

A resin composition 12 was prepared in the same manner as in Example 1 except the above matter.

### Example 13: Preparation of Resin Composition 13

In Example 1, 10.3 parts by mass of (C) the iron alloy type magnetic powder having an average particle size of 2 µm or less ("CVD iron powder (0.7 µm)" manufactured by JFE Mineral & Alloy Company, Ltd.) were changed to 10.3 parts by mass of (C) another iron alloy type magnetic powder having an average particle size of 2 µm or less ("G00129R" manufactured by JFE Mineral & Alloy Company, Ltd.).

A resin composition 13 was prepared in the same manner as in Example 1 except the above matter.

### Comparative Example 1: Preparation of Resin Composition 14

In Example 1, 83 parts by mass of (A) the iron alloy type magnetic powder having an average particle size of more than 20 µm ("KUAMET NC1-53um" manufactured by Epson Atmix Corporation) were changed to 83 parts by mass of (B) the iron alloy type magnetic powder having an average particle size of more than 2 µm and 20 µm or less ("KUAMET NC1-V1-38um" manufactured by Epson Atmix Corporation).

A resin composition 14 was prepared in the same manner as in Example 1 except the above matter.

### Comparative Example 2: Preparation of Resin Composition 15

In Example 1, the amount of (A) the iron alloy type magnetic powder having an average particle size of more than 20 µm ("KUAMET NC1-53um" manufactured by Epson Atmix Corporation) was changed from 83 parts by mass to 62 parts by mass.

A resin composition 15 was prepared in the same manner as in Example 1 except the above matter.

### Comparative Example 3: Preparation of Resin Composition 16

In Example 1,
1) 83 parts by mass (A) the iron alloy type magnetic powder having an average particle size of more than 20 µm ("KUAMET NC1-53um" manufactured by Epson Atmix Corporation) were changed to 80 parts by mass of (A) another iron alloy type magnetic powder having an average particle size of more than 20 µm ("KUAMET NC1-75um" manufactured by Epson Atmix Corporation,
2) (B) the iron alloy type magnetic powder having an average particle size of more than 2 µm and 20 µm or less ("AW02-08 PF3F" manufactured by Epson Atmix Corporation) was not used, and
3) (C) the iron alloy type magnetic powder having an average particle size of 2 µm or less ("CVD iron powder (0.7 µm)" manufactured by JFE Mineral & Alloy Company, Ltd.) was not used.

A resin composition 16 was prepared in the same manner as in Example 1 except the above matter.

### Comparative Example 4: Preparation of Resin Composition 17

In Example 1,
1) the amount of (A) the iron alloy type magnetic powder having an average particle size of more than 20 µm ("KUAMET NC1-53um" manufactured by Epson Atmix Corporation) was changed from 83 parts by mass to 92.5 parts by mass,
2) (B) the iron alloy type magnetic powder having an average particle size of more than 2 µm and 20 µm or less ("AW02-08 PF3F" manufactured by Epson Atmix Corporation) was not used, and
3) the amount of (C) the iron alloy type magnetic powder having an average particle size of 2 µm or less ("CVD iron powder (0.7 µm)" manufactured by JFE Mineral & Alloy Company, Ltd.) was changed from 10.3 parts by mass to 11.44 parts by mass.

A resin composition 17 was prepared in the same manner as in Example 1 except the above matter.

### Comparative Example 5: Preparation of Resin Composition 18

In Example 1,
1) the amount of (A) the iron alloy type magnetic powder having an average particle size of more than 20 µm ("KUAMET NC1-53um" manufactured by Epson Atmix Corporation) was changed from 83 parts by mass to 89 parts by mass,
2) (B) the iron alloy type magnetic powder having an average particle size of more than 2 µm and 20 µm or less ("AW02-08 PF3F" manufactured by Epson Atmix Corporation) was not used, and
3) the amount of (C) the iron alloy type magnetic powder having an average particle size of 2 µm or less ("CVD iron powder (0.7 µm)" manufactured by JFE Mineral & Alloy Company, Ltd.) was changed from 10.3 parts by mass to 14.88 parts by mass.

A resin composition 18 was prepared in the same manner as in Example 1 except the above matter.

### Comparative Example 6: Preparation of Resin Composition 19

In Example 1,
1) the amount of (A) the iron alloy type magnetic powder having an average particle size of more than 20 µm ("KUAMET NC1-53um" manufactured by Epson Atmix Corporation) was changed from 83 parts by mass to 92.9 parts by mass,
2) the amount of (B) the iron alloy type magnetic powder having an average particle size of more than 2 µm and 20 µm or less ("AW02-08 PF3F" manufactured by Epson Atmix Corporation) was changed from 10.3 parts by mass to 11.5 parts by mass, and
3) (C) the iron alloy type magnetic powder having an average particle size of 2 µm or less ("CVD iron powder (0.7 µm)" manufactured by JFE Mineral & Alloy Company, Ltd.) was not used.

A resin composition 19 was prepared in the same manner as in Example 1 except the above matter.

### Comparative Example 7: Preparation of Resin Composition 20

In Example 1, 10.3 parts by mass of (C) the iron alloy type magnetic powder having an average particle size of 2 µm or less ("CVD iron powder (0.7 µm)" manufactured by JFE Mineral & Alloy Company, Ltd.) were changed to 7.5 parts by mass of (C') a magnetic powder other than the iron alloy type magnetic powder, having an average particle size of 2 µm or less ("M001" manufactured by Powdertech Co., Ltd.).

A resin composition 20 was prepared in the same manner as in Example 1 except the above matter.

### Test Example 1: Evaluation of Appearance of Resin Composition during Application

The resin compositions prepared in the examples and the comparative examples were evaluated for an appearance during application. A polyethylene terephthalate (PET) film treated with a silicone type releasing agent ("PET501010" manufactured by Lintec Corporation, 50 µm thick) was prepared as a support. Each resin composition was uniformly applied to the releasing surface of the PET film with a doctor blade such that the thickness of a resin composition layer after drying was 100 µm to obtain a resin sheet. The appearance of the resin composition during application was evaluated based on the following criteria.

### Criteria for Appearance during Application

"O": No streaks occur during the application of the resin composition.
"X": Streaks occur during the application of the resin composition.

### Test Example 2: Measurement and Evaluation of Specific Magnetic Permeability

The resin sheet obtained in Test Example 1 was heated at 190°C for 90 minutes to thermally cure the resin composition layer, and the support was peeled off to obtain a sheet-shaped cured product. The resulting cured product was cut into a test piece 5 mm wide and 18 mm long to obtain an evaluation sample. This evaluation sample was measured for the specific magnetic permeability (µ') using a measurement device ("HP8362B" manufactured by Agilent Technologies) by a three-turn coil method with a measurement frequency of 10 MHz at room temperature of 23°C. The specific magnetic permeability was evaluated based on the following criteria.

### Criteria for Specific Magnetic Permeability

"O": The specific magnetic permeability is 39 or more.
"X": The specific magnetic permeability is less than 39.

### Results

Tables 1 to 3 below list the compositions and results of the resin compositions of the examples and the comparative examples.

**Table 1**

| **[Table 1. Compositions and results of resin compositions of Exameples 1 to 6]** | | | | | | | | |
|---|---|---|---|---|---|---|---|---|
| | | | Example | | | | | |
| | | | 1 | 2 | 3 | 4 | 5 | 6 |
| (A) | Iron alloy type magnetic powder having average particle size of more than 20 µm and 50 µm or less | KUAMET NC1-53um | 83.00 | 83.00 | 87.00 | 83.00 | 83.00 | 86.30 |
| | | KUAMET NC1-75um | | | | | | |
| (B) | Iron alloy type magnetic powder having average particle size of more than 2 µm and 20 µm or less | KUAMENT NC1-V1-38um | | | | | | 7.50 |
| | | AW02-08 PF3F | 10.30 | 10.30 | 5.60 | 5.00 | 15.20 | |
| | | AKT-PB-3Si(3) | | | | | | |
| | | AKT-PB(5) | | | | | | |
| | | 50%FE-50%NI PF-5F | | | | | | |
| | | EA-SMP-10 PF3K | | | | | | |
| | | ATFINE-NC1 PF5FA | | | | | | |
| | | ATFINE-NC1 PF3FA | | | | | | |
| (C) | Iron alloy type magnetic powder having average particle size of 2 µm or less | G00129R | | | | | | |
| | | CVD iro powder(0.7um) | 10.30 | 10.30 | 10.50 | 15.50 | 5.20 | 10.30 |
| (C' ) | Magnetic powder othe than iron alloy type magnetic powder, having average particle size of 2 µm or less | M001 | | | | | | |
| (D) | Thermosetting resin | ZX-1059 | 1.11 | 1.11 | 1.11 | 1.11 | 1.11 | 1.11 |
| | | GPH-65 | 1.56 | 1.56 | 1.56 | 1.56 | 1.56 | 1.56 |
| | | HP-4700 | 0.48 | 0.48 | 0.48 | 0.48 | 0.48 | 0.48 |
| (F) | Thermoplastic resin | YX7553BH30 | 1.42 | 1.42 | 1.42 | 1.42 | 1.42 | 1.42 |
| (G) | Curing accelerator | 2PHZ-PW | 0.02 | 0.02 | 0.02 | 0.02 | 0.02 | 0.02 |
| (H) | Dispersant | PB-821 | 0.11 | | 0.11 | 0.11 | 0.11 | 0.11 |
| | | SC-1015F | | 0.11 | | | | |
| (J) | Solvent | Toluene | 0.11 | 0.11 | 0.11 | 0.11 | 0.11 | 0.11 |
| | | MEK | 2.40 | 2.40 | 2.40 | 2.40 | 2.40 | 2.40 |
| | | Anone | 0.74 | 0.74 | 0.74 | 0.74 | 0.74 | 0.74 |
| Total of nonvolatile component (parts by mass) | | | 107.31 | 107.31 | 106.81 | 107.21 | 107.11 | 107.81 |
| Content of entire amount of magnetic powder in resin composition (% by mass/100% by mass of nonvolatile component) | | | 96.5 | 96.5 | 96.5 | 96.5 | 96.5 | 96.6 |
| Content of entire amount of magnetic powder in resin composition (% by volume/100% by volume of nonvolatile component | | | 82.4 | 82.4 | 82.3 | 82.4 | 82.4 | 82.4 |
| Blended amount of component (A) in resin composition (% by volume/100% by volume of nonvolatile component) | | | 65.7 | 65.7 | 69.2 | 65.7 | 65.9 | 68.2 |
| Blended amount of component (B) in resin composition (% by volume/100% by volume of nonvolatile component) | | | 8.3 | 8.3 | 4.5 | 4.0 | 12.2 | 5.9 |
| Blended amount of component (C) in resin composition (% by volume/100% by volume of nonvolatile component) | | | 8.4 | 8.4 | 8.6 | 12.6 | 4.2 | 8.4 |
| Ratio of (a) iron alloy type magnetic powder having particle size of more than 20 µm and 50 µm or less ("large-diameter magnetic powder") in resin composition (% by volume/100% by volume of nonvolatile component) | | | 28.1 | 28.1 | 29.6 | 28.1 | 28.1 | 30.9 |
| Ratio of (b) iron alloy type magnetic powder having particle size of more than 2 µm and 20 µm or less ("intermediate magnetic powder") in resin composition (% by volume/100% by volume of nonvolatile component) | | | 32.8 | 32.8 | 30.6 | 28.9 | 36.6 | 29.8 |
| Ratio of (c) iron alloy type magnetic powder having particle size of 2 µm or less ("small-diameter magnetic powder") in resin composition (% by volume/100% by volume of nonvolatile component) | | | 8.7 | 8.7 | 8.7 | 12.7 | 4.8 | 8.3 |
| Content of (a) large-diameter magnetic powder in entire amount of magnetic powder (% by volume) | | | 34.1 | 34.1 | 35.9 | 34.1 | 34.2 | 37.5 |
| Content of (b) intermediate-diameter magnetic powder in entire amount of magnetic powder (% by volume) | | | 39.9 | 39.9 | 37.2 | 35.0 | 44.5 | 36.1 |
| Content of (c) small-diameter magnetic powder in entire amount of magnetic powder (% by volume) | | | 10.6 | 10.6 | 10.6 | 15.4 | 5.9 | 10.0 |
| Volume ratio of (a) large-diameter magnetic powder/(b) intermediate magnetic powder | | | 0.85 | 0.85 | 0.97 | 0.97 | 0.77 | 1.04 |
| Volume ratio of (a) large-diameter magnetic powder/(c) small-diameter magnetic powder | | | 3.21 | 3.21 | 3.38 | 2.21 | 5.81 | 3.73 |
| Value of content of component (H)/content of (a) large-diameter magnetic powder × 100 (mass basis) | | | 0.310 | 0.310 | 0.296 | 0.310 | 0.310 | 0.281 |
| Value of content of component (H)/content of (b) intermediate magnetic power × 100 (mass basis) | | | 0.266 | 0.266 | 0.287 | 0.303 | 0.240 | 0.292 |
| Value of content of component (H)/content of (c) small-large magnetic power × 100 (mass basis) | | | 1.025 | 1.025 | 1.029 | 0.705 | 1.852 | 1.079 |
| Value of content of component (H)/content of ((a) + (b) + (c)) × 100 (mass basis) | | | 0.126 | 0.126 | 0.128 | 0.126 | 0.126 | 0.126 |
| Result | Specific magnetic permeability (10MHz) | Mesured value | 42.8 | 40.4 | 42.6 | 40.0 | 43.2 | 43.4 |
| | | Evaluation | ○ | ○ | ○ | ○ | ○ | ○ |
| | Appearance during application | | ○ | ○ | ○ | ○ | ○ | ○ |

**Table 2**

| **[Table 2. Compositions and results of resin compositions of Exameples 7 to 13]** | | | | | | | | | |
|---|---|---|---|---|---|---|---|---|---|
| | | | Example | | | | | | |
| | | | 7 | 8 | 9 | 10 | 11 | 12 | 13 |
| (A) | Iron alloy type magnetic powder having average particle size of more than 20 µm and 50 µm or less | KUAMET NC1-53um | 83.00 | 83.00 | 83.00 | 83.00 | 83.00 | 83.00 | 83.00 |
| | | KUAMET NC1-75um | | | | | | | |
| (B) | Iron alloy type magnetic powder having average particle size of more than 2 µm and 20 µm or less | KUAMENT NC1-V1-38um | | | | | | | |
| | | AW02-08 PF3F | | | | | | | 10.30 |
| | | AKT-PB-3Si(3) | 12.00 | | | | | | |
| | | AKT-PB(5) | | 12.20 | | | | | |
| | | 50%FE-50%NI PF-5F | | | 12.00 | | | | |
| | | EA-SMP-10 PF3K | | | | 11.40 | | | |
| | | ATFINE-NC1 PF5FA | | | | | 10.90 | | |
| | | ATFINE-NC1 PF3FA | | | | | | 10.90 | |
| (C) | Iron alloy type magnetic powder having average particle size of 2 µm or less | G00129R | | | | | | | 10.30 |
| | | CVD iro powder(0.7um) | 10.30 | 10.30 | 10.30 | 10.30 | 10.30 | 10.30 | |
| (C' ) | Magnetic powder othe than iron alloy type magnetic powder, having average particle size of 2 µm or less | M001 | | | | | | | |
| (D) | Thermosetting resin | ZX-1059 | 1.11 | 1.11 | 1.11 | 1.11 | 1.11 | 1.11 | 1.11 |
| | | GPH-65 | 1.56 | 1.56 | 1.56 | 1.56 | 1.56 | 1.56 | 1.56 |
| | | HP-4700 | 0.48 | 0.48 | 0.48 | 0.48 | 0.48 | 0.48 | 0.48 |
| (F) | Thermoplastic resin | YX7553BH30 | 1.42 | 1.42 | 1.42 | 1.42 | 1.42 | 1.42 | 1.42 |
| (G) | Curing accelerator | 2PHZ-PW | 0.02 | 0.02 | 0.02 | 0.02 | 0.02 | 0.02 | 0.02 |
| (H) | Dispersant | PB-821 | 0.11 | 0.11 | 0.11 | 0.11 | 0.11 | 0.11 | 0.11 |
| | | SC-1015F | | | | | | | |
| (J) | Solvent | Toluene | 0.11 | 0.11 | 0.11 | 0.11 | 0.11 | 0.11 | 0.11 |
| | | MEK | 2.40 | 2.40 | 2.40 | 2.40 | 2.40 | 2.40 | 2.40 |
| | | Anone | 0.74 | 0.74 | 0.74 | 0.74 | 0.74 | 0.74 | 0.74 |
| Total of nonvolatile component (parts by mass) | | | 109.01 | 1109.21 | 109.01 | 108.41 | 107.91 | 107.91 | 107.31 |
| Content of entire amount of magnetic powder in resin composition (% by mass/100% by mass of nonvolatile component) | | | 966 | 96.6 | 966 | 966 | 966 | 966 | 96.5 |
| Content of entire amount of magnetic powder in resin composition (% by volume/100% by volume of nonvolatile component | | | 82.4 | 82.4 | 82.4 | 82.4 | 82.5 | 82.5 | 82.4 |
| Blended amount of component (A) in resin composition (% by volume/100% by volume of nonvolatile component) | | | 65.5 | 65.6 | 65.7 | 65.5 | 65.5 | 65.5 | 65.7 |
| Blended amount of component (B) in resin composition (% by volume/100% by volume of nonvolatile component) | | | 8.5 | 8.5 | 8.3 | 8.5 | 8.6 | 8.6 | 8.3 |
| Blended amount of component (C) in resin composition (% by volume/100% by volume of nonvolatile component) | | | 8.4 | 8.4 | 8.4 | 8.4 | 8.4 | 8.4 | 8.4 |
| Ratio of (a) iron alloy type magnetic powder having particle size of more than 20 µm and 50 µm or less ("large-diameter magnetic powder") in resin composition (% by volume/100% by volume of nonvolatile component) | | | 28.0 | 28.0 | 28.0 | 28.0 | 28.0 | 28.0 | 28.1 |
| Ratio of (b) iron alloy type magnetic powder having particle size of more than 2 µm and 20 µm or less ("intermediate magnetic powder") in resin composition (% by volume/100% by volume of nonvolatile component) | | | 30.1 | 31.6 | 33.0 | 33.0 | 33.2 | 33.2 | 34.0 |
| Ratio of (c) iron alloy type magnetic powder having particle size of 2 µm or less ("small-diameter magnetic powder") in resin composition (% by volume/100% by volume of nonvolatile component) | | | 11.6 | 10.1 | 8.6 | 8.7 | 8.6 | 8.6 | 7.6 |
| Content of (a) large-diameter magnetic powder in entire amount of magnetic powder (% by volume) | | | 33.9 | 34.0 | 34.0 | 33.9 | 33.9 | 33.9 | 34.1 |
| Content of (b) intermediate-diameter magnetic powder in entire amount of magnetic powder (% by volume) | | | 36.5 | 38.4 | 40.0 | 40.0 | 40.2 | 40.2 | 41.3 |
| Content of (c) small-diameter magnetic powder in entire amount of magnetic powder (% by volume) | | | 14.1 | 12.2 | 10.5 | 10.6 | 10.4 | 10.5 | 9.2 |
| Volume ratio of (a) large-diameter magnetic powder/(b) intermediate magnetic powder | | | 0.93 | 0.89 | 0.85 | 0.85 | 0.84 | 0.84 | 0.83 |
| Volume ratio of (a) large-diameter magnetic powder/(c) small-diameter magnetic powder | | | 2.41 | 2.78 | 3.25 | 3.20 | 3.25 | 3.24 | 3.71 |
| Value of content of component (H)/content of (a) large-diameter magnetic powder × 100 (mass basis) | | | 0.310 | 0.310 | 0.310 | 0.310 | 0.310 | 0.310 | 0.310 |
| Value of content of component (H)/content of (b) intermediate magnetic power × 100 (mass basis) | | | 0.283 | 0.267 | 0.255 | 0.260 | 0.262 | 0.262 | 0.257 |
| Value of content of component (H)/content of (c) small-large magnetic power × 100 (mass basis) | | | 0.739 | 0.862 | 1.030 | 1.018 | 1.037 | 1.035 | 1.184 |
| Value of content of component (H)/content of ((a) + (b) + (c)) × 100 (mass basis) | | | 0.123 | 0.123 | 0.123 | 0.124 | 0.125 | 0.125 | 0.126 |
| Result | Specific magnetic permeability (10MHz) | Mesured value | 43.8 | 43.6 | 43.5 | 43.2 | 43.5 | 43.1 | 43.6 |
| | | Evaluation | ○ | ○ | ○ | ○ | ○ | ○ | ○ |
| | Appearance during application | | ○ | ○ | ○ | ○ | ○ | ○ | ○ |

**Table 3**

| **[Table 3. Compositions and results of resin compositions of Comparative Exameples 1 to 7]** | | | | | | | | | |
|---|---|---|---|---|---|---|---|---|---|
| | | | Comparative Example | | | | | | |
| | | | 1 | 2 | 3 | 4 | 5 | 6 | 7 |
| (A) | Iron alloy type magnetic powder having average particle size of more than 20 µm and 50 µm or less | KUAMET NC1-53um | | 62.00 | | 92.50 | 89.00 | 92.90 | 83.00 |
| | | KUAMET NC1-75um | | | 80.00 | | | | |
| (B) | Iron alloy type magnetic powder having average particle size of more than 2 µm and 20 µm or less | KUAMENT NC1-V1-38um | 83.00 | | | | | | |
| | | AW02-08 PF3F | 10.30 | 10.30 | | | | 11.50 | 10.30 |
| | | AKT-PB-3Si(3) | | | | | | | |
| | | AKT-PB(5) | | | | | | | |
| | | 50%FE-50%NI PF-5F | | | | | | | |
| | | EA-SMP-10 PF3K | | | | | | | |
| | | ATFINE-NC1 PF5FA | | | | | | | |
| | | ATFINE-NC1 PF3FA | | | | | | | |
| (C) | Iron alloy type magnetic powder having average particle size of 2 µm or less | G00129R | | | | | | | |
| | | CVD iro powder(0.7um) | 10.30 | 10.30 | | 11.44 | 14.88 | | |
| (C' ) | Magnetic powder othe than iron alloy type magnetic powder, having average particle size of 2 µm or less | M001 | | | | | | | 7.50 |
| (D) | Thermosetting resin | ZX-1059 | 1.11 | 1.11 | 1.11 | 1.11 | 1.11 | 1.11 | 1.11 |
| | | GPH-65 | 1.56 | 1.56 | 1.56 | 1.56 | 1.56 | 1.56 | 1.56 |
| | | HP-4700 | 0.48 | 0.48 | 0.48 | 0.48 | 0.48 | 0.48 | 0.48 |
| (F) | Thermoplastic resin | YX7553BH30 | 1.42 | 1.42 | 1.42 | 1.42 | 1.42 | 1.42 | 1.42 |
| (G) | Curing accelerator | 2PHZ-PW | 0.02 | 0.02 | 0.02 | 0.02 | 0.02 | 0.02 | 0.02 |
| (H) | Dispersant | PB-821 | 0.11 | 0.11 | 0.11 | 0.11 | 0.11 | 0.11 | 0.11 |
| | | SC-1015F | | | | | | | |
| (J) | Solvent | Toluene | 0.11 | 0.11 | 0.11 | 0.11 | 0.11 | 0.11 | 0.11 |
| | | MEK | 2.40 | 2.40 | 2.40 | 2.40 | 2.40 | 2.40 | 2.40 |
| | | Anone | 0.74 | 0.74 | 0.74 | 0.74 | 0.74 | 0.74 | 0.74 |
| Total of nonvolatile component (parts by mass) | | | 107.31 | 86.31 | 83.71 | 107.65 | 107.59 | 108.11 | 104.51 |
| Content of entire amount of magnetic powder in resin composition (% by mass/100% by mass of nonvolatile component) | | | 96.5 | 95.7 | 95.6 | 966 | 966 | 966 | 96.5 |
| Content of entire amount of magnetic powder in resin composition (% by volume/100% by volume of nonvolatile component | | | 82.4 | 78.9 | 78.3 | 82.4 | 82.4 | 82.5 | 82.4 |
| Blended amount of component (A) in resin composition (% by volume/100% by volume of nonvolatile component) | | | 0 | 58.9 | 78.3 | 73.1 | 70.3 | 73.3 | 65.6 |
| Blended amount of component (B) in resin composition (% by volume/100% by volume of nonvolatile component) | | | 74.0 | 9.9 | 0 | 0 | 0 | 9.2 | 8.3 |
| Blended amount of component (C) in resin composition (% by volume/100% by volume of nonvolatile component) | | | 8.4 | 10.1 | 0 | 9.3 | 12.1 | 0 | 0 |
| Ratio of (a) iron alloy type magnetic powder having particle size of more than 20 µm and 50 µm or less ("large-diameter magnetic powder") in resin composition (% by volume/100% by volume of nonvolatile component) | | | 20.2 | 25.1 | 50.5 | 31.2 | 30.0 | 31.3 | 28.0 |
| Ratio of (b) iron alloy type magnetic powder having particle size of more than 2 µm and 20 µm or less ("intermediate magnetic powder") in resin composition (% by volume/100% by volume of nonvolatile component) | | | 50.6 | 31.8 | 4.5 | 27.8 | 26.8 | 36.5 | 32.7 |
| Ratio of (c) iron alloy type magnetic powder having particle size of 2 µm or less ("small-diameter magnetic powder") in resin composition (% by volume/1 00% by volume of nonvolatile component) | | | 8.7 | 10.5 | 0 | 9.2 | 12.0 | 0.5 | 0.4 |
| Content of (a) large-diameter magnetic powder in entire amount of magnetic powder (% by volume) | | | 24.5 | 31.9 | 64.6 | 37.9 | 36.4 | 37.9 | 34.0 |
| Content of (b) intermediate-diameter magnetic powder in entire amount of magnetic powder (% by volume) | | | 61.5 | 40.3 | 5.8 | 33.7 | 32.5 | 44.2 | 39.7 |
| Content of (c) small-diameter magnetic powder in entire amount of magnetic powder (% by volume) | | | 10.6 | 13.3 | 0 | 11.2 | 14.5 | 0.6 | 0.5 |
| Volume ratio of (a) large-diameter magnetic powder/(b) intermediate magnetic powder | | | 0.40 | 0.79 | 11.14 | 1.12 | 1.12 | 0.86 | 0.86 |
| Volume ratio of (a) large-diameter magnetic powder/(c) small-diameter magnetic powder | | | 2.31 | 2.40 | - | 3.39 | 2.51 | 65.41 | 65.25 |
| Value of content of component (H)/content of (a) large-diameter magnetic powder × 100 (mass basis) | | | 0.432 | 0.416 | 0.213 | 0.278 | 0.289 | 0.277 | 0.310 |
| Value of content of component (H)/content of (b) intermediate magnetic power × 100 (mass basis) | | | 0.172 | 0.330 | 2.371 | 0.313 | 0.325 | 0.239 | 0.267 |
| Value of content of component (H)/content of (c) small-large magnetic power × 100 (mass basis) | | | 1.025 | 1.025 | - | 0.971 | 0.747 | 18.395 | 20.538 |
| Value of content of component (H)/content of ((a) + (b) + (c)) × 100 (mass basis) | | | 0.110 | 0.156 | 0.195 | 0.128 | 0.127 | 0.127 | 0.142 |
| Result | Specific magnetic permeability (10MHz) | Mesured value | 36.1 | 35.2 | 40.0 | 34.3 | 26.9 | 43.0 | 44.9 |
| | | Evaluation | × | × | × | × | × | ○ | ○ |
| | Appearance during application | | ○ | ○ | × | ○ | × | × | × |

### Reference Signs List

- 1: Circuit board
- 10: Core substrate
- 11: Supporting substrate
- 12: Metal layer
- 13: Metal layer
- 14: Through hole
- 20: Plated layer
- 21: Surrounding surface of polished surface
- 30: Cured product
- 30a: Resin composition
- 31: Polished surface of cured product (polished surface)
- 40: Conductor layer
- 41: Patterned conductor layer
- 100: Circuit board
- 200: Inner layer substrate
- 200a: First main surface
- 200b: Second main surface
- 220: Through hole
- 220a: Inside-the-through-hole wiring
- 240: External terminal
- 310: Resin Sheet
- 320: First cured product layer
- 320a: Resin composition layer
- 330: Support
- 360: Via hole
- 360a: Inside-the-via-hole wiring
- 400: Coil-shaped conductive structural body
- 420: First conductor layer
- 420a: Land
- 440: Second conductor layer

## Claims

1. A resin composition comprising a thermosetting resin and an iron alloy type magnetic powder,
a content of (a) an iron alloy type magnetic powder having a particle size of more than 20 µm and 50 µm or less being 26% by volume or more and 45% by volume or less,
a content of (b) an iron alloy type magnetic powder having a particle size of more than 2 µm and 20 µm or less being 28% by volume or more and 68% by volume or less, and
a content of (c) an iron alloy type magnetic powder having a particle size of 2 µm or less being 1% by volume or more and 41% by volume or less,
when a nonvolatile component of the resin composition is 100% by volume.

2. The resin composition according to claim **1,** wherein (a) the iron alloy type magnetic powder having a particle size of more than 20 µm and 50 µm or less contains a nanocrystalline magnetic powder containing an iron alloy.

3. The resin composition according to claim 1 or **2,** wherein (b) the iron alloy type magnetic powder having a particle size of more than 2 µm and 20 µm or less contains at least one iron alloy magnetic powder selected from a nanocrystalline magnetic powder containing an iron alloy, a Ni-containing iron alloy type magnetic powder, a polycrystalline magnetic powder containing an iron alloy, and an amorphous magnetic powder.

4. The resin composition according to any one of claims 1 to 3, wherein the volume ratio V(a)/V(c) is 25 or less,
wherein the content (% by volume) of (a) the large-diameter magnetic powder is expressed as V(a) and the content (% by volume) of (c) the small-diameter magnetic powder is expressed as V(c) relative to 100% by volume of the nonvolatile component of the resin composition.

5. The resin composition according to any one of claims 1 to 4, wherein the volume ratio V(a)/V(c) is 15 or less,
wherein the content (% by volume) of (a) the large-diameter magnetic powder is expressed as V(a) and the content (% by volume) of (c) the small-diameter magnetic powder is expressed as V(c) relative to 100% by volume of the nonvolatile component of the resin composition.

6. The resin composition according to any one of claims 1 to 5, wherein the thermosetting resin contains an epoxy resin.

7. The resin composition according to any one of claims 1 to 6, wherein the thermosetting resin contains a curing agent.

8. The resin composition according to any one of claims 1 to 7, further comprising a thermoplastic resin.

9. The resin composition according to any one of claims 1 to 8, further comprising a curing accelerator.

10. The resin composition according to any one of claims 1 to 9, further comprising a dispersant.

11. The resin composition according to any one of claims 1 to 10, wherein the resin composition is for hole filling.

12. A production method of the resin composition according to any one of claims 1 to 11, the production method comprising mixing together:
(A) an iron alloy type magnetic powder having an average particle size of more than 20 µm and 50 µm or less,
(B) an iron alloy type magnetic powder having an average particle size of more than 2 µm and 20 µm or less,
(C) an iron alloy type magnetic powder having an average particle size of 2 µm or less, and
(D) a thermosetting resin.

13. A production method of a resin composition, the production method comprising mixing together:
(A) an iron alloy type magnetic powder having an average particle size of more than 20 µm and 50 µm or less,
(B) an iron alloy type magnetic powder having an average particle size of more than 2 µm and 20 µm or less,
(C) an iron alloy type magnetic powder having an average particle size of 2 µm or less, and
(D) a thermosetting resin.

14. The production method of a resin composition according to claim 12 or 13, wherein (A) the iron alloy type magnetic powder having an average particle size of more than 20 µm and 50 µm or less contains a nanocrystalline magnetic powder containing an iron alloy.

15. The production method of a resin composition according to any one of claims 12 to 14, wherein the component (B) is at least one iron alloy type magnetic powder selected from a nanocrystalline magnetic powder containing an iron alloy, a Ni-containing iron alloy type magnetic powder, a polycrystalline magnetic powder containing an iron alloy, and an amorphous magnetic powder.

16. The production method of a resin composition according to any one of claims 12 to 15, wherein a blended amount of the component (A) is 60% by volume or more and 75% by volume or less when the nonvolatile component of the resin composition to be produced is 100% by volume.

17. A cured product of the resin composition according to any one of claims 1 to 11.

18. A magnetic paste comprising the resin composition according to any one of claims 1 to 11.

19. A resin sheet comprising:
a support; and
a resin composition layer provided on the support,
the resin composition layer containing the resin composition according to any one of claims 1 to 11.

20. A circuit board comprising a cured product layer containing a cured product of the resin composition according to any one of claims 1 to 11.

21. The circuit board according to claim 20, further comprising:
a substrate having holes; and
the cured product of the resin composition filled in the holes.

22. An inductor substrate comprising the circuit board according to claim 20 or 21.
